(19) Europäisches Patentamt
European Patent Office
Office européen des brevets

(11) EP 4 397 501 A1

(12) EUROPEAN PATENT APPLICATION
published in accordance with Art. 153(4) EPC

(43) Date of publication:
10.07.2024 Bulletin 2024/28

(21) Application number: 22864267.4

(22) Date of filing: 17.08.2022

(51) International Patent Classification (IPC):
*B41N 1/14* (2006.01) *B41C 1/10* (2006.01)
*B41M 1/06* (2006.01) *G03F 7/00* (2006.01)
*G03F 7/004* (2006.01) *G03F 7/027* (2006.01)

(52) Cooperative Patent Classification (CPC):
B41C 1/10; B41M 1/06; B41N 1/14; G03F 7/00; G03F 7/004; G03F 7/027

(86) International application number:
PCT/JP2022/031121

(87) International publication number:
WO 2023/032682 (09.03.2023 Gazette 2023/10)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 31.08.2021 JP 2021141516
02.03.2022 JP 2022031973

(71) Applicant: FUJIFILM Corporation
Tokyo 106-8620 (JP)

(72) Inventor: SAKAGUCHI, Akira
Haibara-gun, Shizuoka 421-0396 (JP)

(74) Representative: HGF
HGF Limited
1 City Walk
Leeds LS11 9DX (GB)

# (54) ON-PRESS-DEVELOPING LITHOGRAPHIC PRINTING ORIGINAL PLATE, METHOD FOR PRODUCING LITHOGRAPHIC PRINTING PLATE, AND LITHOGRAPHIC PRINTING METHOD

(57) An on-press development type lithographic printing plate precursor including a support and an image-recording layer on the support, in which the image-recording layer contains a polymerizable compound, a polymerization initiator, and an infrared absorber, and a color forming substance precursor, and a color forming substance generated from the color forming substance precursor has a maximal absorption wavelength in a wavelength range of 380 nm or more and less than 580 nm, at which an absorbance difference with respect to the color forming substance precursor is 0.1 or more, and a maximal absorption wavelength in a wavelength range of 580 nm or more and 750 nm or less, at which an absorbance difference with respect to the color forming substance precursor is 0.07 or more, and a method of preparing lithographic printing plate or a lithographic printing method, using the on-press development type lithographic printing plate precursor.

EP 4 397 501 A1

## Description

The present disclosure relates to an on-press development type lithographic printing plate precursor, a method of preparing a lithographic printing plate, and a lithographic printing method.

In general, a lithographic printing plate is composed of lipophilic image areas that receive ink during a printing process and hydrophilic non-image areas that receive a dampening water. Lithographic printing is a printing method that utilizes the property that water and oil-based ink repel each other to cause differences in ink attachment behavior on a surface of the lithographic printing plate by using lipophilic image areas on the lithographic printing plate as an ink-receiving area and using hydrophilic non-image areas on the lithographic printing plate as dampening water-receiving areas (non-ink-receiving areas), thereby depositing the ink only to the image areas, and then transferring the ink to a printing material, such as paper.

In the related art, in order to prepare this lithographic printing plate, a lithographic printing plate precursor (PS plate) has been widely used which is obtained by providing a lipophilic photosensitive resin layer (image-recording layer) on a hydrophilic support. Usually, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing a surface of the hydrophilic support.

In response to the intensifying interest in the global environment, an environmental issue of waste liquid generated by wet treatments such as a development treatment has gathered more attention.

Regarding the environmental issue described above, an attempt is made to simplify development or plate making or to remove treatments. As one of simple preparation methods, a method called "on-press development" is being carried out. That is, the on-press development is a method of exposing a lithographic printing plate precursor, then immediately mounting the precursor on a printer without performing development of the related art, and removing an unnecessary portion of the image-recording layer at an initial stage of the ordinary printing step.

In the present disclosure, a lithographic printing plate precursor that can be used for such on-press development is called "on-press development type lithographic printing plate precursor".

Examples of the lithographic printing plate precursors in the related art include those described in WO2016/027886A.

WO2016/027886A describes a lithographic printing plate precursor including a layer containing a compound represented by Formula 1 and a binder polymer on a support.

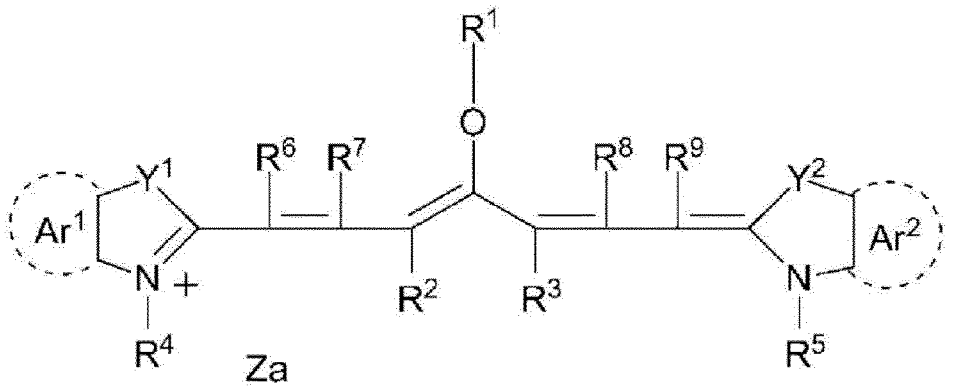

(1)

In Formula 1, $R^1$ represents a group having an R'-O bond that is cleaved by exposure to heat or infrared rays, $R^2$ and $R^3$ each independently represent a hydrogen atom or an alkyl group, $R^2$ and $R^3$ may be linked to each other to form a ring, $Ar^1$ and $Ar^2$ each independently represent a group that forms a benzene ring or a naphthalene ring, $Y^1$ and $Y^2$ each independently represent an oxygen atom, a sulfur atom, $-NR^0-$, or a dialkylmethylene group, $R^4$ and $R^5$ each independently represent an alkyl group, $R^6$ to $R^9$ each independently represent a hydrogen atom or an alkyl group, $R^0$ represents a hydrogen atom, an alkyl group, or an aryl group, and Za represents a counter ion that neutralizes an electric charge.

An object of an embodiment of the present disclosure is to provide an on-press development type lithographic printing plate precursor excellent in visibility and sensor readability.

An object of another embodiment of the present disclosure is to provide a method of preparing a lithographic printing plate and a lithographic printing method in which the on-press development type lithographic printing plate precursor is used.

Means for solving the above issues include the following aspects.

<1> An on-press development type lithographic printing plate precursor, comprising a support, and an image-recording layer on the support, in which the image-recording layer contains a polymerizable compound, a polymerization initiator, an infrared absorber, and a color forming substance precursor, and a color forming substance generated from the color forming substance precursor has a maximal absorption wavelength in a wavelength range of 380 nm or more and less than 580 nm, at which an absorbance difference with respect to the color forming substance precursor is 0.1 or more, and a maximal absorption wavelength in a wavelength range of 580 nm or more and 750 nm or less, at which an absorbance difference with respect to the color forming substance precursor is 0.07 or more.
<2> The on-press development type lithographic printing plate precursor according to <1>, in which a molar absorption coefficient ε at any one of the maximal absorption wavelengths in the color forming substance is 35,000 or more.
<3> The on-press development type lithographic printing plate precursor according to <1> or <2>, in which the color forming substance precursor is a leuco colorant.
<4> The on-press development type lithographic printing plate precursor according to any one of <1> to <3>, in which the color forming substance precursor is an acid color forming agent.
<5> The on-press development lithographic printing plate precursor according to any one of <1> to <4>, in which the color forming substance precursor includes two or more kinds of color forming substance precursors.
<6> The on-press development type lithographic printing plate precursor according to <5>, in which the color forming substance precursor includes two kinds of color forming substance precursors.
<7> The on-press development lithographic printing plate precursor according to any one of <1> to <6>, in which in the color forming substance, the maximal absorption wavelength in the wavelength range of 380 nm or more and less than 580 nm, at which the absorbance difference with respect to the color forming substance precursor is 0.1 or more is a maximal absorption wavelength in a wavelength range of 500 nm or more and less than 580 nm, at which an absorbance difference with respect to the color forming substance precursor is 0.1 or more.
<8> The on-press development lithographic printing plate precursor according to any one of <1> to <7>, in which in the color forming substance, the maximal absorption wavelength in the wavelength range of 580 nm or more and 750 nm or less, at which the absorbance difference with respect to the color forming substance precursor is 0.07 or more is a maximal absorption wavelength in a wavelength range of 580 nm or more and 660 nm or less, at which an absorbance difference with respect to the color forming substance precursor is 0.07 or more.
<9> The on-press development type lithographic printing plate according to any one of <1> to <8>, in which a ring-opening rate of the color forming substance precursor, which is determined by the following expression, is 40 mol% to 99 mol%.
The ring-opening rate = a molar absorption coefficient of the color forming substance precursor to which 1 molar equivalent of acid is added/a molar absorption coefficient ε of the color forming substance generated from the color forming substance precursor $\times$ 100
<10> A method of preparing a lithographic printing plate, comprising a step of exposing the on-press development type lithographic printing plate precursor according to any one of <1> to <9> in a shape of an image, and a step of supplying at least one selected from the group consisting of a printing ink and dampening water on a printer to remove an image-recording layer in a non-image area.
<11> The method of preparing a lithographic printing plate according to <10>, further comprising a step of identifying the exposed lithographic printing plate precursor by a sensor.
<12> A lithographic printing method comprising, a step of exposing the on-press development type lithographic printing plate precursor according to any one of <1> to <9> in a shape of an image, a step of supplying at least one selected from the group consisting of a printing ink and dampening water on a printer to remove an image-recording layer in a non-image area and to prepare a lithographic printing plate, and a step of performing printing by using the obtained lithographic printing plate.
<13> The lithographic printing method according to <12>, further comprising a step of identifying the exposed lithographic printing plate precursor by a sensor.

According to an embodiment of the present disclosure, it is possible to provide an on-press development type lithographic printing plate precursor excellent in visibility and sensor readability.
According to another embodiment of the present disclosure, it is possible to provide a method of preparing a lithographic printing plate and a lithographic printing method in which the on-press development type lithographic printing plate precursor is used.

BRIEF DESCRIPTION OF THE DRAWINGS

Fig. 1 is a schematic cross-sectional view of an embodiment of an aluminum support suitably used in the present disclosure.

Fig. 2 is a schematic cross-sectional view of an embodiment of an aluminum support having an anodic oxide film.

Fig. 3 is a graph showing an example of an alternating waveform current waveform diagram used for an electrochemical roughening treatment in a manufacturing method of an aluminum support having an anodic oxide film.

Fig. 4 is a side view illustrating an example of a radial type cell in the electrochemical roughening treatment carried out using the alternating current according to the manufacturing method of the aluminum support having an anodic oxide film.

Fig. 5 is a side view conceptually showing a brush graining step used in a mechanical roughening treatment in the manufacturing method of an aluminum support having an anodic oxide film.

Fig. 6 is a schematic view of an anodization treatment device used for an anodization treatment in the manufacturing method of an aluminum support having an anodic oxide film.

Hereinafter, the contents of the present disclosure will be described in detail. The description of configuration requirements below is made based on representative embodiments of the present disclosure in some cases, but the present disclosure is not limited to such embodiments.

In the present specification, a numerical range expressed using "to" includes numerical values listed before and after "to" as the lower limit value and the upper limit value.

In addition, in the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present specification, "(meth)acryl" is a term used to explain a concept including both the acryl and methacryl, and "(meth)acryloyl" is a term used to explain a concept including both the acryloyl and methacryloyl.

In addition, the term "step" in the present specification means not only an independent step but also a step that cannot be clearly differentiated from other steps as long as the intended goal of the step is achieved. In the present disclosure, "% by mass" has the same definition as "% by weight", and "part by mass" has the same definition as "part by weight".

In the present disclosure, unless otherwise specified, as each component contained in a composition or each constitutional unit contained in a polymer, one component or one constitutional unit may be used alone, or two or more components or two or more constitutional units may be used in combination.

Furthermore, in the present disclosure, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.

Furthermore, in the present disclosure, a combination of two or more preferred aspects is a more preferred aspect.

In addition, in the present disclosure, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present disclosure, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

In the present disclosure, "*" in a chemical structural formula represents a bonding position with other structures.

Hereinafter, the present disclosure will be described in detail.

(On-press development type lithographic printing plate precursor)

The on-press development type lithographic printing plate precursor according to the present disclosure (also simply referred to as "lithographic printing plate precursor") includes a support, and an image-recording layer on the support, in which the image-recording layer contains a polymerizable compound, a polymerization initiator, an infrared absorber, and a color forming substance precursor, and a color forming substance generated from the color forming substance precursor has a maximal absorption wavelength in a wavelength range of 380 nm or more and less than 580 nm, at which an absorbance difference with respect to the color forming substance precursor is 0.1 or more, and a maximal absorption wavelength in a wavelength range of 580 nm or more and 750 nm or less, at which an absorbance difference with respect to the color forming substance precursor is 0.07 or more.
In addition, the on-press development type lithographic printing plate precursor according to the present disclosure is preferably a negative tone lithographic printing plate precursor.
In the printing step, it is required for the on-press development type lithographic printing plate precursor that plate information can be visually read in order to detect a plate making error and to classify which job the plate is used for (date, printer, color, or the like).
On the other hand, in order to simplify the printing step, the introduction of systems in which a reading code (a bar code, a two-dimensional code, or the like) is exposed on the on-press development type lithographic printing plate precursor, the code is read by a reader, and which printing the plate is to be used for (a date, a printer, a color, or the like) is automatically classified, has been promoted. Therefore, there is an increasing demand for a sensor that can read a reading code in the on-press development type lithographic printing plate precursor.
As a result of diligent studies by the present inventors, the present inventors have found that a color forming substance to be generated from one or a plurality of color developing substance precursors has, as a whole, a maximal absorption wavelength in a wavelength range of 380 nm or more and less than 580 nm, at which an absorbance difference with respect to the color forming substance precursor is 0.1 or more, and a maximal absorption wavelength in a wavelength range of 580 nm or more and 750 nm or less, at which an absorbance difference with respect to the color forming substance precursor is 0.07 or more, thereby both visibility and sensor readability are excellent.
Hereinafter, each of the configuration requirements in the lithographic printing plate precursor according to the present disclosure will be specifically described.

<Image-recording layer>

The lithographic printing plate precursor according to the embodiment of the present disclosure includes an image-recording layer formed on the support.
The image-recording layer contains a polymerizable compound, a polymerization initiator, an infrared absorber, and a color forming substance precursor.
The image-recording layer used in the present disclosure is preferably a negative tone image-recording layer and more preferably a water-soluble or water-dispersible negative tone image-recording layer.
In the lithographic printing plate precursor according to the present disclosure, from the viewpoint of on-press developability, a non-exposed portion of the image-recording layer is preferably removable by at least any of dampening water or printing ink.
Hereinafter, each of the components to be contained in the image-recording layer will be specifically described.

[Color forming substance precursor]

The image-recording layer contains a color forming substance precursor, and a color forming substance generated from the color forming substance precursor has a maximal absorption wavelength in a wavelength range of 380 nm or more and less than 580 nm, at which an absorbance difference with respect to the color forming substance precursor is 0.1 or more, and a maximal absorption wavelength in a wavelength range of 580 nm or more and 750 nm or less, at which an absorbance difference with respect to the color forming substance precursor is 0.07 or more.
As the color forming substance precursor, one kind of a color forming substance precursor where a color forming substance to be generated has the maximal absorption wavelengths in both of a wavelength range of 380 nm or more and less than 580 nm and a wavelength range of 580 nm or more and 750 nm or less may be used, or one or more kinds of color forming substance precursors where a color forming substance to be generated has a maximal absorption wavelength in a wavelength range of 380 nm or more and less than 580 nm and one or more kinds of color forming substance precursors where a color forming substance has a maximal absorption wavelength in a wavelength range of 580 nm or more and 750 nm or less may be used. However, from the viewpoints of visibility, sensor readability, and ink suppressiveness, two or more kinds of color forming substance precursors are preferably included, and two kinds of color forming substance precursors are more preferably included.

The maximal absorption wavelength is in a wavelength range of 380 nm or more and less than 580 nm, and from the viewpoints of visibility and ink turbidity, the absorbance difference with respect to the color forming substance precursor is preferably 0.12 or more and more preferably 0.15 or more and 0.30 or less.

In addition, in the color developing substance generated from the color developing substance precursor, from the viewpoints of visibility and ink turbidity, the maximal absorption wavelength in a wavelength range of 380 nm or more and less than 580 nm, at which an absorbance difference with respect to the color forming substance precursor is 0.1 or more is preferably a maximal absorption wavelength in a wavelength range of 500 nm or more and less than 580 nm, at which an absorbance difference with respect to the color forming substance precursor is 0.1 or more, more preferably a maximal absorption wavelength in a wavelength range of 530 nm or more and less than 580 nm, at which an absorbance difference with respect to the color forming substance precursor is 0.1 or more, and particularly preferably a maximal absorption wavelength in a wavelength range of 550 nm or more and less than 580 nm, at which an absorbance difference with respect to the color forming substance precursor is 0.1 or more.

The maximal absorption wavelength is in a wavelength range of 580 nm or more and 750 nm or less, and from the viewpoints of visibility, sensor readability, and ink turbidity, the absorbance difference with respect to the color forming substance precursor is preferably 0.08 or more and more preferably 0.09 or more and 0.30 or less.

In addition, in the color developing substance generated from the color developing substance precursor, from the viewpoints of visibility, sensor readability, and ink turbidity, the maximal absorption wavelength in a wavelength range of 580 nm or more and 750 nm or less, at which an absorbance difference with respect to the color forming substance precursor is 0.07 or more is preferably a maximal absorption wavelength in a wavelength range of 580 nm or more and 700 nm or less, at which an absorbance difference with respect to the color forming substance precursor is 0.07 or more, more preferably a maximal absorption wavelength in a wavelength range of 580 nm or more and 660 nm or less, at which an absorbance difference with respect to the color forming substance precursor is 0.07 or more, and particularly preferably a maximal absorption wavelength in a wavelength range of 585 nm or more and 630 nm or less, at which an absorbance difference with respect to the color forming substance precursor is 0.07 or more.

From the viewpoints of visibility and ink turbidity, a molar absorption coefficient ε at any one of the maximal absorption wavelengths of the color forming substance generated from the color forming substance precursor is preferably 35,000 or more, more preferably 35,000 or more and 200,000 or less, and particularly preferably 50,000 or more and 150,000 or less.

From the viewpoints of visibility and ink turbidity, a molar absorption coefficient ε at the maximal absorption wavelength in a wavelength range of 380 nm or more and less than 580 nm of the color forming substance generated from the color forming substance precursor is preferably 35,000 or more, more preferably 35,000 or more and 200,000 or less, and particularly preferably 50,000 or more and 150,000 or less.

From the viewpoints of visibility, sensor readability, and ink turbidity, a molar absorption coefficient ε at the maximal absorption wavelength in a wavelength range of 580 nm or more and 750 nm or less of the color forming substance generated from the color forming substance precursor is preferably 10,000 or more, more preferably 12,000 or more and 100,000 or less, and particularly preferably 15,000 or more and 80,000 or less.

In addition, from the viewpoints of visibility, sensor readability, and ink turbidity, the molar absorption coefficient ε at the maximum absorption wavelength in a wavelength range of 380 nm or more and less than 580 nm of a color forming substance generated from the color forming substance precursor is preferably larger than the molar absorption coefficient ε at the maximal absorption wavelength in the wavelength range of 580 nm or more and 750 nm or less of the color forming substance generated from the color forming substance precursor.

In the present disclosure, the maximal absorption wavelength and the change in absorbance of the color forming substance generated from the color forming substance precursor is measured by the following method.

By using Trendsetter Q800 manufactured by Eastman Kodak Company that was equipped with an infrared semiconductor laser, the obtained lithographic printing plate precursor was exposed under the conditions of output of 14 W, an outer drum rotation speed of 360 rpm, and a resolution of 2,400 dpi (dot per inch, 1 inch is equal to 2.54 cm) (irradiation energy equivalent to 110 $mJ/cm^2$). The exposed image includes a solid image. The reflection spectra of the solid image area and the non-image area are measured using a spectrocolorimeter CM-2600d (manufactured by KONICA MINOLTA, INC.), and an absorbance is acquired from the reflectivity of each of the reflection spectra. A wavelength at which a difference in absorbance between the solid image area and the non-image area is a maximal value is defined as a maximal absorption wavelength, and a change in absorbance at the wavelength is acquired.

In the present disclosure, the molar absorption coefficient ε of the color forming substance generated from the color forming substance precursor is measured by the following method.

The color forming substance precursor to be measured is weighed (0.04 mmol) and put in a 100 mL volumetric flask.

About 90 mL of acetic acid is added thereto. After it is visually confirmed that the measurement sample has completely dissolved, acetic acid is added thereto such that the volume increases up to 100 mL, thereby preparing a dye solution A.

Acetic acid (about 80 mL) is added to another 100 mL volumetric flask, 5 mL of deionized water and 5 mL of the dye solution A are then added thereto by using a 5 mL transfer pipette, and the solution is gently shaken.
After it is visually confirmed that the solution has no precipitate of the color forming substance precursor, acetic acid is added thereto so that the volume increases up to 100 mL, thereby preparing a dye solution B. In the dye solution B, the concentration of the color forming substance precursor is 0.02 mmol/L.
A measurement cell (quartz glass, optical path width: 10 mm) is filled with the dye solution B, and the solution is measured using an ultraviolet-visible spectrophotometer (UV-1800, manufactured by Shimadzu Corporation.).
As a blank, a solution of water:acetic acid = 5:95 is used.
From the obtained spectrum, the maximal absorption wavelengths in a wavelength range of 380 nm or more and less than 580 nm and in a wavelength range of 580 nm or more and 750 nm or less are read. From the absorbance at each of the wavelengths, the molar absorption coefficient $\varepsilon$ is calculated.
In addition, the measurement with the ultraviolet-visible spectrophotometer was performed using the dye solution A (color forming substance precursor) and the dye solution B (color forming substance), and from the obtained spectra, the change in absorbance at the maximal absorption wavelength in the wavelength range of 380 nm or more and less than 580 nm and the change in absorbance at the maximal absorption wavelength in the wavelength range of 580 nm or more and 750 nm or less are calculated.
From the viewpoint of visibility, in the color forming substance precursor, a ring-opening rate determined by the following equation is preferably 2% to 100%, more preferably 5% to 60%, and particularly preferably 10% to 40%.
Ring-opening rate = molar absorption coefficient of color forming substance precursor to which 1 molar equivalent of acid is added/molar absorption coefficient $\varepsilon$ of color forming substance generated from color forming substance precursor $\times$ 100
The ring-opening rate in the present disclosure is measured by the following method.

-Preparation of dye solution C-

The color forming substance precursor is weighed (0.1 mmol) and put in a 50 mL volumetric flask.
About 40 mL of acetonitrile is added thereto. After it is visually confirmed that the measurement sample has completely dissolved, acetonitrile is added thereto such that the volume increases up to 50 mL, thereby preparing a dye solution C.

-Preparation of acid solution D-

0.2 mmol of 10-camphorsulfonic acid (CSA) is added to a 100 mL volumetric flask, and about 80 mL of acetonitrile is added thereto. After it is confirmed that CSAhas completely dissolved, acetonitrile is added thereto such that the volume increases up to 100 mL, thereby preparing an acid solution D.

-Preparation of measurement solution E-

5 mL of deionized water is added to a 100 mL volumetric flask by using a transfer pipette, and 80 mL of acetonitrile is added thereto. 1 mL of the dye solution C and 1 mL of the acid solution D are added thereto, and acetonitrile is added thereto such that the volume increases up to 100 mL, thereby preparing a measurement solution E.
In the measurement solution E, the concentration of the color forming substance precursor including the generated color forming substance is 0.02 mmol/L.
A measurement cell (quartz glass, optical path width: 10 mm) is filled with the measurement solution E, and the solution is measured using an ultraviolet-visible spectrophotometer (UV-1800, manufactured by Shimadzu Corporation.).
As a blank, a solution of water:acetonitrile = 5:95 is used.
From the obtained spectrum, the maximal absorption wavelength in the visible light region (380 nm to 750 nm) is read. From the absorbance at the wavelength, the molar absorption coefficient $\varepsilon$ is calculated.
The ring-opening rate is calculated according to the following equation.

Ring-opening rate = molar absorption coefficient of color forming substance precursor to which 1 molar equivalent of acid is added/molar absorption coefficient of color forming substance precursor $\times$ 100

In a case where the image-recording layer contains two or more color forming substance precursors, the ring-opening rate of each of the color forming substance precursors is measured, and the color forming rate of the color forming substance precursor is determined by confirming whether or not the ring-opening rate satisfies the above-described range.

From the viewpoint of visibility and color formability, the color forming substance precursor is preferably an acid color forming agent.

In addition, from the viewpoint of visibility and color formability, the color forming substance precursor is preferably a leuco colorant.

"Color forming substance precursor" used in the present disclosure means a compound that forms color by a stimulus such as light or acid and thus changes the color of the image-recording layer. Furthermore, "acid color forming agent" means a compound that forms color by being heated in a state of accepting an electron accepting compound (for example, a proton of an acid or the like) and thus changes the color of the image-recording layer. The acid color forming agent is particularly preferably a colorless compound which has a partial skeleton such as lactone, lactam, sultone, spiropyran, an ester, or an amide and allows such a partial skeleton to rapidly open the ring or to be cleaved when coming into contact with an electron-accepting compound.

Particularly, from the viewpoints of visibility and color formability, the color forming substance precursor used in the present disclosure is preferably at least one kind of compound selected from the group consisting of a spiropyran compound, a spirooxazine compound, a spirolactone compound, and a spirolactam compound.

From the viewpoint of visibility, the hue of the color forming substance after color forming is preferably green, blue, or black.

From the viewpoints of visibility and color formability, the acid color forming agent is preferably a leuco colorant.

The aforementioned leuco colorant is not particularly limited as long as it has a leuco structure. The leuco colorant preferably has a spiro structure, and more preferably has a spirolactone ring structure.

From the viewpoint of color formability and visibility of exposed portions, the leuco colorant is preferably a leuco colorant having a phthalide structure or a fluoran structure.

From the viewpoint of visibility, UV printing durability, and temporal stability, the color forming substance precursor preferably has 2 or more electron-donating groups directly bonded to an aromatic ring.

As the electron-donating groups, from the viewpoint of color formability and visibility of the exposed portion, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable, a monoalkyl monoarylamino group or a diarylamino group is even more preferable, and a monoalkyl monoarylamino group is particularly preferable.

From the viewpoint of visibility, UV printing durability, and temporal stability, the color forming substance precursor preferably has a xanthene structure.

Furthermore, from the viewpoint of visibility, UV printing durability, and temporal stability, the color forming substance precursor preferably includes a compound represented by Formula (Z-1) or Formula (Z-2), and more preferably includes a compound represented by Formula (Z-1).

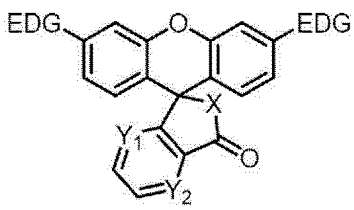

(Z-1)

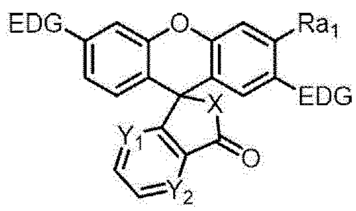

(Z-2)

In Formula (Z-1) and Formula (Z-2), EDG each independently represents an electron-donating group, X represents O or NR, R represents a hydrogen atom, an alkyl group, an aryl group, or a heteroaryl group, $Y_1$ and $Y_2$ each independently represent CH or N, and $Ra_1$ represents a hydrogen atom, an alkyl group, or an alkoxy group.

As the electron-donating groups represented by EDG in Formula (Z-1) and Formula (Z-2), from the viewpoint of color formability and visibility of the exposed portion, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable, a monoalkyl monoarylamino group or a diarylamino group is even more preferable, and a monoalkyl monoarylamino group is particularly preferable.

Furthermore, from the viewpoint of visibility, UV printing durability, and temporal stability, the color forming substance precursor more preferably includes a compound represented by Formula (Z-3) or Formula (Z-4), and particularly preferably includes a compound represented by Formula (Z-3).

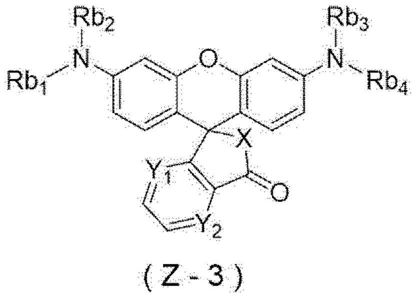

(Z-3)

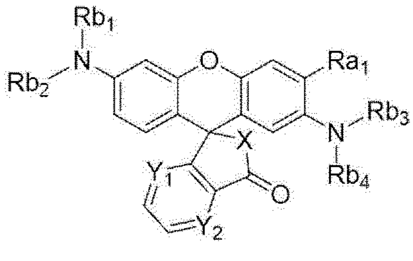

(Z-4)

In Formula (Z-3) and Formula (Z-4), Rai represents a hydrogen atom, an alkyl group, or an alkoxy group, $Rb_1$ to $Rb_4$ each independently represent a hydrogen atom, an alkyl group, or an aryl group, $Rb_1$ and $Rb_2$ or $Rb_3$ and $Rb_4$ may form a ring, and $Y_1$ and $Y_2$ each independently represent CH or N.

From the viewpoint of visibility, UV printing durability, and temporal stability, $Rb_1$ and $Rb_4$ in Formula (Z-3) and Formula (Z-4) preferably each independently represent an alkyl group or an aryl group, and more preferably each independently represent an aryl group.

From the viewpoint of visibility, UV printing durability, and temporal stability, $Rb_2$ and $Rb_3$ in Formula (Z-3) and Formula (Z-4) preferably each independently represent an alkyl group or an aryl group, and more preferably each independently represent an alkyl group.

From the viewpoint of visibility, UV printing durability, and temporal stability, Rai in Formula (Z-4) preferably represent a hydrogen atom or an alkoxy group, and more preferably represent a hydrogen atom.

In Formula (Z-3) and Formula (Z-4), from the viewpoints of color formability and visibility of exposed portions, $Y_1$ and $Y_2$ are preferably C.

The alkyl group in Formula (Z-1) to Formula (Z-4) may be linear or branched or may have a ring structure.

The number of carbon atoms in the alkyl group in Formula (Z-1) to Formula (Z-4) is preferably 1 to 20, more preferably 1 to 8, even more preferably 1 to 4, and particularly preferably 1 or 2.

The number of carbon atoms in the aryl group in Formula (Z-1) to Formula (Z-4) is preferably 6 to 20, more preferably 6 to 10, and particularly preferably 6 to 8.

Furthermore, each of the groups such as the alkyl group and the aryl group in Formula (Z-1) to Formula (Z-4) may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, a cyano group, and the like. In addition, these substituents may be further substituted with these substituents.

From the viewpoints of visibility, sensor readability, and color formability, the color forming substance precursor preferably includes a compound represented by Formula (Z-5).

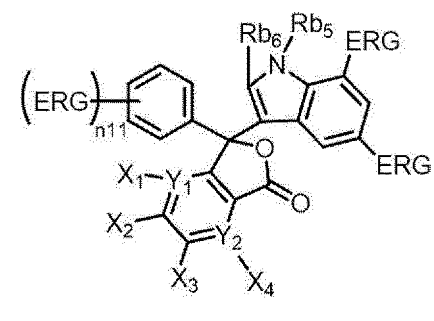

(Z-5)

In Formula (Z-5), ERG's each independently represent an electron-donating group, n11 represents an integer of 1 to 5, $X_1$ to $X_4$ each independently represent a hydrogen atom, a halogen atom, or dialkylanilino group, $Y_1$ and $Y_2$ each independently represent C or N, $X_1$ does not exist in a case where $Y_1$ is N, $X_4$ does not exist in a case where $Y_2$ is N, and $Rb_5$ and $Rb_6$ each independently represent a hydrogen atom, an alkyl group, an aryl group, or a heteroaryl group.

From the viewpoints of visibility and color formability, the electron-donating group represented by ERG in Formula (Z-5) is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy

group, or an alkyl group, more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, or an aryloxy group, even more preferably a monoalkyl monoarylamino group, a diarylamino group, a diheteroarylamino group, or a monoaryl monoheteroarylamino group, and particularly preferably a monoalkyl monoarylamino group.

From the viewpoints of visibility and color formability, the electron-donating group represented by ERG is preferably a disubstituted amino group having an aryl group that has a substituent on at least one ortho position or a heteroaryl group that has a substituent on at least one ortho position, more preferably a disubstituted amino group having a phenyl group having a substituent on at least one ortho position and an electron-donating group at a para position, even more preferably an amino group having a phenyl group having a substituent on at least one ortho position and an electron-donating group at a para position, and an aryl group or a heteroaryl group, and particularly preferably an amino group having a phenyl group having a substituent on at least one ortho position and an electron-donating group at a para position, and an aryl group having an electron-donating group or a heteroaryl group having an electron-donating group.

In the present disclosure, in a case where a bonding position of an aryl group or a heteroaryl group with other structures is defined as position 1, the ortho position in the aryl group or heteroaryl group other than a phenyl group is called a bonding position (for example, position 2 or the like) adjacent to the position 1.

Furthermore, from the viewpoints of visibility and color formability, the electron-donating group that the aryl group or heteroaryl group has is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoints of visibility and color formability, $Rb_5$ in Formula (Z-5) is preferably an alkyl group, an aryl group, or a heteroaryl group and more preferably an alkyl group.

From the viewpoints of visibility and color formability, $Rb_6$ in Formula (Z-5) is preferably an alkyl group, an aryl group, or a heteroaryl group, more preferably an alkyl group, and particularly preferably a methyl group.

From the viewpoints of visibility and color formability, it is preferable that at least one of $Y_1$ or $Y_2$ in Formula (Z-5) is C, and it is more preferable that both of $Y_1$ and $Y_2$ are C.

From the viewpoints of visibility and color formability, $X_1$ to $X_4$ in Formula (Z-5) each independently are preferably a hydrogen atom or a chlorine atom, and more preferably each independently represent a hydrogen atom.

n11 in Formula (Z-5) is preferably an integer of 1 to 3, and more preferably 1 or 2.

Examples of the leuco colorant to be suitably used include the following compounds. Me represents a methyl group, Et represents an ethyl group, Oct represents an octyl group, and Ph represents a phenyl group.

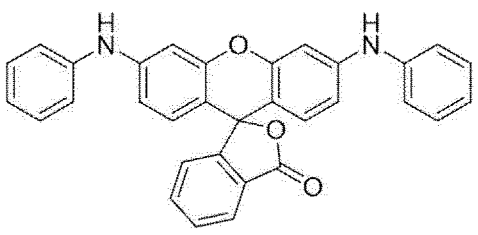

S-1

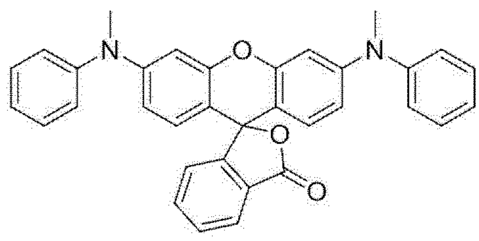

S-2

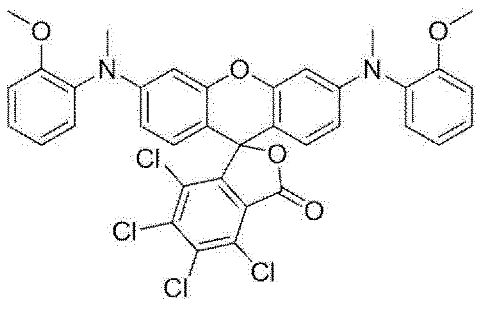

S-3

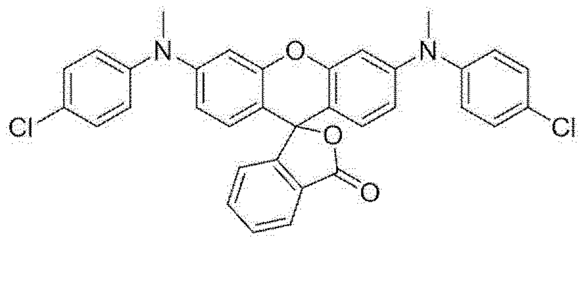

S-4

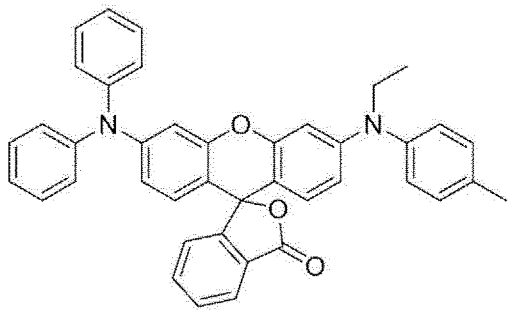

S-5

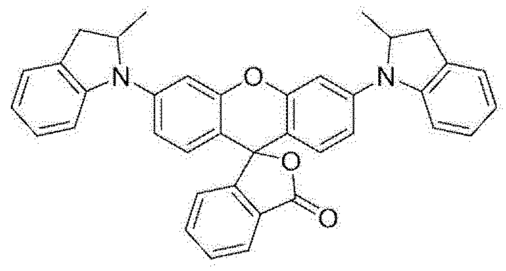

S-6

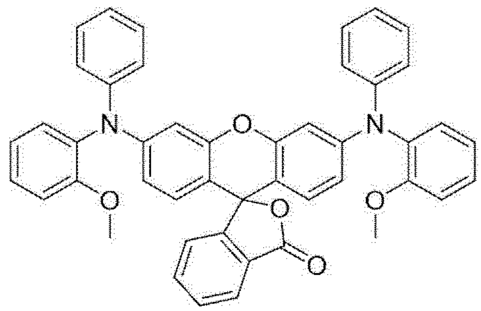

S-7

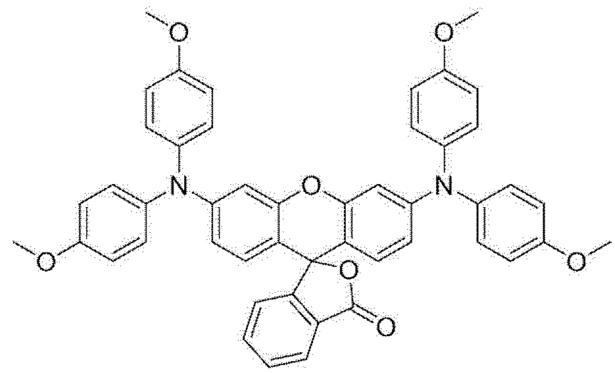

S-8

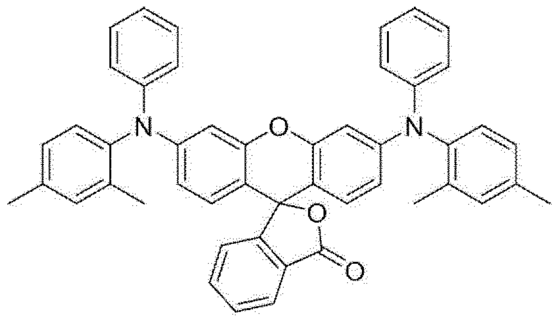

S-9

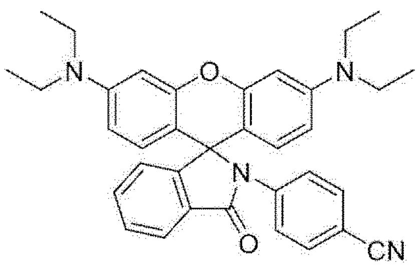

S-10

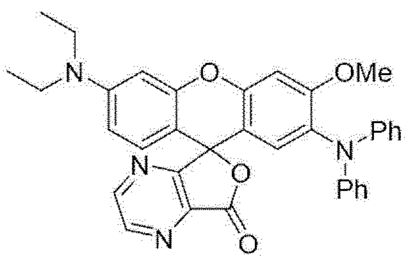

S-11

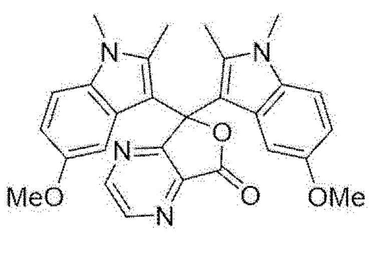

S-12

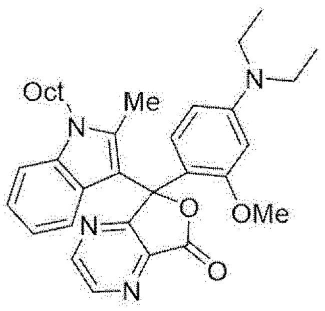

S-13

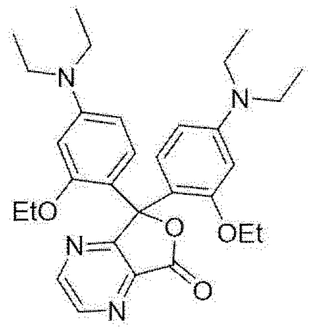

S-14

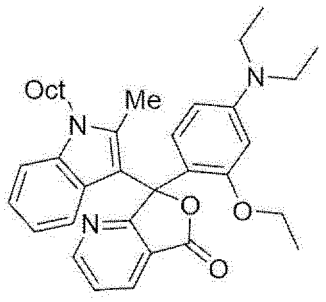

S-15

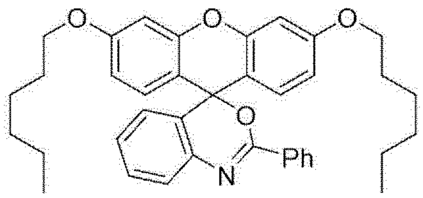

S-16

In addition, from the viewpoints of visibility and ink turbidity, the color forming substance precursor preferably includes a decomposition-type infrared absorber.

The decomposition-type infrared absorber is preferably an infrared absorber that has a function of forming color by absorbing infrared rays and decomposing by exposure to infrared rays.

Hereinafter, a color-forming compound formed as a result of infrared absorption and decomposition of the decomposition-type infrared absorber by exposure to infrared rays will be also called "color forming substance of the decomposition-type infrared absorber".

In addition, it is preferable that the decomposition-type infrared absorber has a function of absorbing infrared rays by exposure to infrared rays and converting the absorbed infrared rays into heat.

The decomposition-type infrared absorber may be an infrared absorber that decomposes by absorbing at least a part of light in the infrared wavelength region (wavelength of 750 nm to 1 mm). The decomposition-type infrared absorber is preferably an infrared absorber having a maximal absorption wavelength in a wavelength region of 750 nm to 1,400 nm, and more preferably an infrared absorber having a maximal absorption wavelength in a wavelength region of 760 nm to 900 nm.

More specifically, the decomposition-type infrared absorber is preferably a compound that decomposes upon the exposure to infrared rays and generates a compound having maximal absorption wavelength in a wavelength range of 380 nm or more and less than 580 nm.

The decomposition-type infrared absorber is preferably an infrared absorber that decomposes by either or both of heat and electron migration resulting from exposure to infrared rays, and more preferably an infrared absorber that decomposes by electron migration resulting from exposure to infrared rays. "Decomposes by electron migration" mentioned herein means that electrons excited to the lowest unoccupied molecular orbital (LUMO) from the highest occupied molecular orbital (HOMO) of the decomposition-type infrared absorber by exposure to infrared rays move to electron accepting groups (groups having potential close to LUMO) in a molecule by means of intramolecular electron migration and thus result in decomposition.

As the infrared absorber that decomposes by exposure to infrared rays, those described in WO2020/262692A can also be suitably used.

As the infrared absorber that decomposes by exposure to infrared rays, those described in JP2008-544322A or WO2016/027886A can also be suitably used.

In addition, as the cyanine colorant which is a decomposition-type infrared absorber, the infrared absorbing compounds described in WO2019/219560A can be suitably used.

Specific examples of infrared absorbers that decompose by exposure to infrared rays will be shown below. However, the present disclosure is not limited thereto.

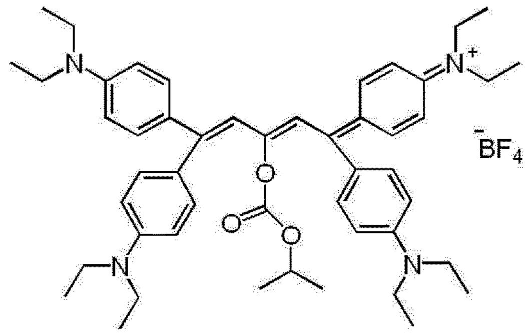

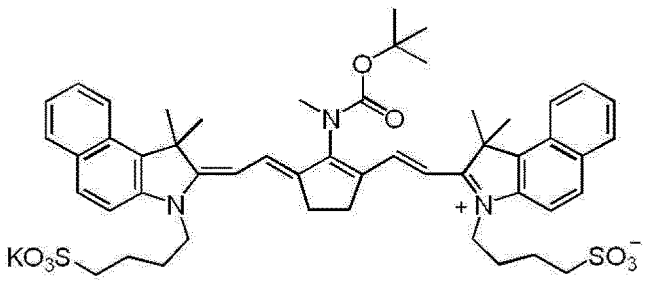

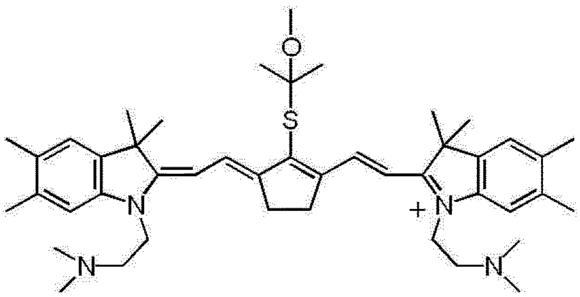

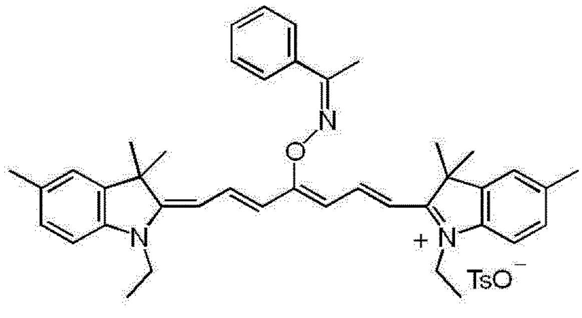

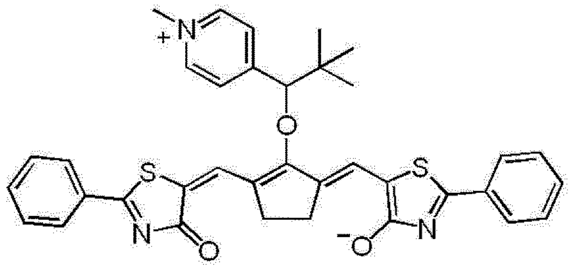

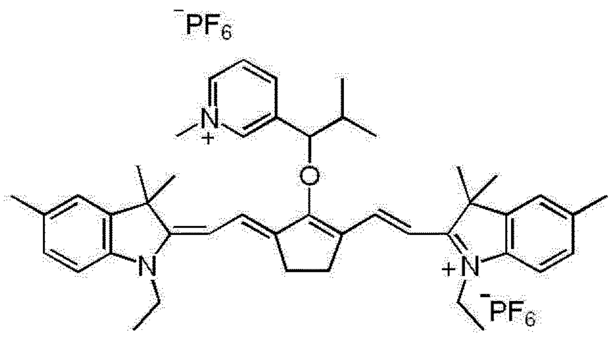

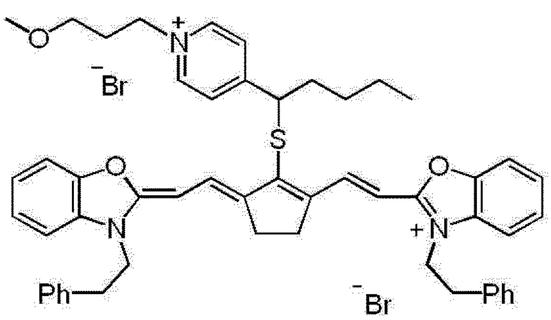

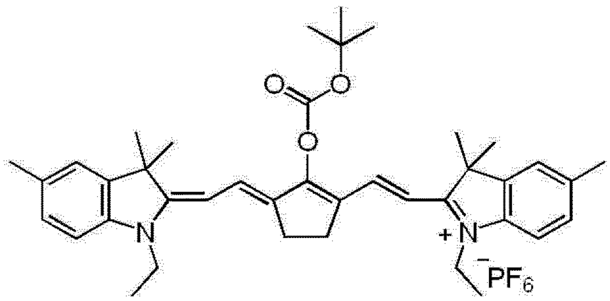

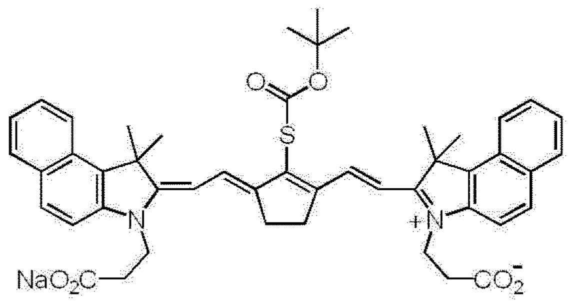

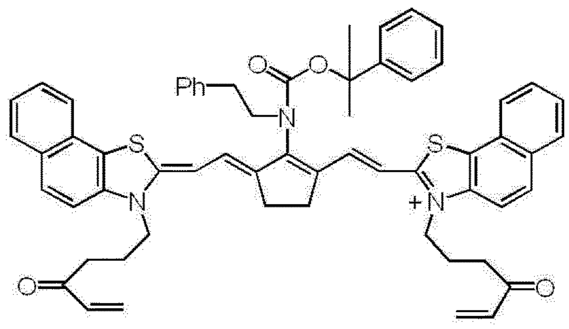

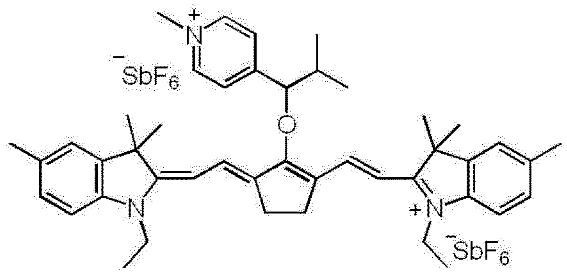

From the viewpoints of visibility, sensor readability, and ink turbidity, it is preferable that the color forming substance precursor includes two or more kinds of leuco colorants or include one or more kinds of decomposition-type infrared absorbers and one or more kinds of leuco colorants, and it is more preferable that the color forming substance precursor includes two kinds of leuco colorants or includes one kind of a decomposition-type infrared absorber and one kind of a leuco colorant.

In addition, from the viewpoints of visibility, sensor readability, and ink turbidity, the color forming substance precursor preferably includes a compound represented by Formula (Z-3) or Formula (Z-4) in which $Rb_1$ and $Rb_3$ are each independently an aryl group and $Rb_2$ and $Rb_4$ are each independently a hydrogen atom or an alkyl group, and a compound represented by Formula (Z-3) or Formula (Z-4) in which $Rb_1$ to $Rb_3$ are each independently an aryl group.

Furthermore, from the viewpoints of visibility, sensor readability, and ink turbidity, the color forming substance precursor preferably includes the decomposition-type infrared absorber and a compound represented by Formula (Z-3) or Formula (Z-4) in which $Rb_1$ to $Rb_3$ are each independently an aryl group.

One of these color forming substance precursors may be used alone, or two or more of these components can be used in combination.

The content of the color forming substance precursor with respect to the total mass of the image-recording layer is preferably 0.5% by mass to 10% by mass, and more preferably 1% by mass to 5% by mass.

[Infrared absorber]

The lithographic printing plate precursor according to the present disclosure contains an infrared absorber in an image-recording layer.

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine colorant, a squarylium colorant, a pyrylium salt, a nickel thiolate complex, and an indolenine cyanine colorant are particularly preferable. Furthermore, for example, a cyanine colorant or an indolenine cyanine colorant is preferable. Among these, a cyanine colorant is particularly preferable.

The infrared absorber is preferably a cationic polymethine colorant having an oxygen or nitrogen atom at the meso-position. Preferred examples of the cationic polymethine colorant include a cyanine colorant, a pyrylium colorant, a thiopyrylium colorant, an azulenium colorant, and the like. From the viewpoint of ease of availability, solubility in a solvent during an introduction reaction, and the like, a cyanine colorant is preferable.

Specific examples of the cyanine colorant include the compounds described in paragraphs "0017" to "0019" of JP2001-133969A and the compounds described in paragraphs "0016" to "0021" of JP2002-023360A and paragraphs

"0012" to "0037" of JP2002-040638A. As the cyanine colorant, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to "0076" of JP2008-195018A are preferable.

In addition, as the infrared absorber, those described in WO2020/262692A can also be suitably used.

As the infrared absorber that decomposes by exposure to infrared rays, those described in JP2008-544322A or WO2016/027886A can also be suitably used.

From the viewpoints of printing durability and halftone dot reproducibility, the highest occupied molecular orbital (HOMO) value of the infrared absorber used in the present disclosure is preferably -5.00 eV or less and more preferably -5.30 eV or less.

From the viewpoints of printing durability and halftone dot reproducibility, the lower limit of HOMO of the infrared absorber is preferably -5.90 eV or more, more preferably -5.75 eV or more, and even more preferably -5.60 eV or more.

In the present disclosure, the highest occupied molecular orbital (HOMO) and the lowest unoccupied molecular orbital (LUMO) are calculated by the following methods.

First, free counter ions in the compound as a calculation object are excluded from the calculation object. For example, for a cationic electron-accepting polymerization initiator and a cationic infrared absorber, counteranions are excluded from the calculation object, and for an anionic electron-donating polymerization initiator, countercations are excluded from the calculation object. "Free" mentioned herein means that the compound as an object and the counter ions thereof are not covalently linked to each other.

The structural optimization is carried out by DFT (B3LYP/6-31G(d)) using quantum chemical calculation software Gaussian 09.

The molecular orbital (MO) energy is calculated by DFT (B3LYP/6-31+G(d,p)/CPCM (solvent = methanol)) using the structure obtained by the structural optimization.

By the following formula, the MO energy Ebare (unit: hartree) obtained by the above-described MO energy calculation is converted into Escaled (unit: eV) used as the HOMO value and the LUMO value in the present disclosure.

$$\text{Escaled} = 0.823168 \times 27.2114 \times \text{Ebare} - 1.07634$$

27.2114 is simply a coefficient for converting hartree into eV, and 0.823168 and - 1.07634 are adjustment coefficients. These are determined such that the calculated HOMO and LUMO of the compound as a calculation object match the measured values.

Only one infrared absorber may be used, or two or more infrared absorbers may be used in combination. In addition, as the infrared absorber, a pigment and a dye may be used in combination.

The total content of the infrared absorber in the image-recording layer with respect to the total mass of the image-recording layer is preferably 0.1% by mass to 10.0% by mass, and more preferably 0.5% by mass to 5.0% by mass.

[Polymerizable compound]

The image-recording layer in the present disclosure contains a polymerizable compound.

In the present disclosure, a polymerizable compound refers to a compound having a polymerizable group.

The polymerizable group is not particularly limited, may be a known polymerizable group, and is preferably an ethylenically unsaturated group. The polymerizable group may be a radically polymerizable group or a cationically polymerizable group, and is preferably a radically polymerizable group.

Examples of the radically polymerizable group include a (meth)acryloyl group, an allyl group, a vinylphenyl group, a vinyl group, and the like. From the viewpoint of reactivity, a (meth)acryloyl group is preferable.

The molecular weight of the polymerizable compound (weight-average molecular weight in a case where the polymerizable compound has molecular weight distribution) is preferably 50 or more and less than 2,500.

The polymerizable compound used in the present disclosure may be, for example, a radically polymerizable compound or a cationically polymerizable compound, and is preferably an addition polymerizable compound having at least one ethylenically unsaturated bond (ethylenically unsaturated compound).

The ethylenically unsaturated compound is preferably a compound having at least one terminal ethylenically unsaturated bond, and more preferably a compound having two or more terminal ethylenically unsaturated bonds. The chemical form of the polymerizable compound is, for example, a monomer, a prepolymer that is a dimer, a trimer, or an oligomer, a mixture of these, or the like.

Particularly, from the viewpoint of printing durability, the polymerizable compound preferably includes a polymerizable compound having functionalities of 3 or more, more preferably includes a polymerizable compound having functionalities of 7 or more, and even more preferably includes a polymerizable compound having functionalities of 10 or more. In addition, from the viewpoint of printing durability of the lithographic printing plate to be obtained, the polymerizable compound preferably includes an ethylenically unsaturated compound having functionalities of 3 or more (preferably having functionalities of 7 or more and more preferably having functionalities of 10 or more), and more preferably includes a (meth)acrylate compound having functionalities of 3 or more (preferably having functionalities of 7 or more and more preferably having functionalities of 10 or more).

From the viewpoints of on-press developability and contamination suppressiveness, the polymerizable compound preferably includes a polymerizable compound having functionalities of 2 or less, more preferably includes a difunctional polymerizable compound, and particularly preferably includes a difunctional (meth)acrylate compound.

From the viewpoints of printing durability, on-press developability, and contamination suppressiveness, the content of the polymerizable compound having functionalities of 2 or less (preferably a difunctional polymerizable compound) with respect to the total mass of polymerizable compounds in the image-recording layer is preferably 5% by mass to 100% by mass, more preferably 10% by mass to 100% by mass, and even more preferably 15% by mass to 100% by mass.

-Oligomer-

As the polymerizable compound contained in the image-recording layer, it is preferable that a polymerizable compound which is an oligomer (hereinafter, also simply called "oligomer") is contained.

In the present disclosure, an oligomer represents a polymerizable compound which has a molecular weight (weight-average molecular weight in a case where the compound has molecular weight distribution) of 600 or more and 10,000 or less and at least one polymerizable group.

From the viewpoints of excellent chemical resistance and excellent printing durability, the molecular weight of the oligomer is preferably 1,000 or more and 5,000 or less.

In addition, from the viewpoint of improving printing durability, the number of polymerizable groups in one molecule of the oligomer is preferably 2 or more, more preferably 3 or more, even more preferably 6 or more, and particularly preferably 10 or more.

The upper limit of the number of polymerizable groups in the oligomer is not particularly limited, but the number of polymerizable groups is preferably 20 or less.

From the viewpoints of printing durability and on-press developability, an oligomer having 7 or more polymerizable groups and a molecular weight of 1,000 or more and 10,000 or less is preferable, and an oligomer having 7 or more and 20 or less polymerizable groups and a molecular weight of 1,000 or more and 5,000 or less is more preferable.

The oligomer may contain a polymer component which is likely to be generated in the process of manufacturing the oligomer.

From the viewpoints of printing durability, visibility, and on-press developability, the oligomer preferably has at least one selected from the group consisting of a compound having a urethane bond, a compound having an ester bond, and a compound having an epoxy residue, and more preferably has a compound having a urethane bond.

In the present disclosure, an epoxy residue refers to a structure formed of an epoxy group and for example, means a structure similar to a structure obtained by the reaction between an acid group (carboxylic acid group or the like) and an epoxy group.

As the compound having a urethane bond, those described in WO2020/262692A can be suitably used.

As the compound having a urethane bond, a compound may also be used which is prepared by obtaining polyurethane by a reaction between a polyisocyanate compound and a polyol compound and introducing a polymerizable group into the obtained polyurethane by a polymer reaction.

For example, the compound having a urethane bond may be obtained by reacting a polyol compound having an acid group with a polyisocyanate compound to obtain a polyurethane oligomer and reacting the obtained polyurethane oligomer with a compound having an epoxy group and a polymerizable group.

The number of polymerizable groups in the compound having an ester bond, which is an example of oligomer, is preferably 3 or more, and more preferably 6 or more.

As the compound having an epoxy residue, which is an example of oligomer, a compound containing a hydroxy group is preferable.

The number of polymerizable groups in the compound having an epoxy residue is preferably 2 to 6, and more preferably 2 or 3.

The compound having an epoxy residue can be obtained, for example, by reacting a compound having an epoxy group with an acrylic acid.

Specific examples of oligomers will be shown as follows, but the oligomer used in the present disclosure is not

limited thereto.

As the oligomer, commercially available products may also be used. Examples thereof include UA-510H, UA-306H, UA-306I, and UA-306T (all manufactured by KYOEISHA CHEMICAL Co., Ltd.), UV-1700B, UV-6300B, and UV7620EA (all manufactured by The Nippon Synthetic Chemical Industry Co., Ltd.), U-15HA (manufactured by SHIN-NAKAMURA CHEMICAL Co., Ltd.), FBECRYL450, EBECRYL657, EBECRYL885, EBECRYL800, EBECRYL3416, and EBECRYL860 (all manufactured by DAICEL-ALLNEX LTD.), and the like. However, the oligomer is not limited to these.

From the viewpoints of improving chemical resistance and printing durability and further suppressing the residues of on-press development, the content of the oligomer with respect to the total mass of polymerizable compounds in the image-recording layer is preferably 30% by mass to 100% by mass, more preferably 50% by mass to 100% by mass, and even more preferably 80% by mass to 100% by mass.

-Low-molecular-weight polymerizable compound-

The polymerizable compound may further include a polymerizable compound other than the oligomer described above.

From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.

From the viewpoint of chemical resistance, the low-molecular-weight polymerizable compound is preferably at least one polymerizable compound selected from the group consisting of a polymerizable compound having three or more ethylenically unsaturated groups and a polymerizable compound having an isocyanuric ring structure.

In the present disclosure, a low-molecular-weight polymerizable compound refers to a polymerizable compound having a molecular weight (weight-average molecular weight in a case where the compound has molecular weight distribution) of 50 or more and less than 600.

From the viewpoints of excellent chemical resistance, excellent printing durability, and excellently suppressing the residues of on-press development, the molecular weight of the low-molecular-weight polymerizable compound is preferably 100 or more and less than 600, more preferably 300 or more and less than 600, and even more preferably 400 or more and less than 600.

In a case where the polymerizable compound includes a low-molecular-weight polymerizable compound as the polymerizable compound other than the oligomer, from the viewpoints of chemical resistance and printing durability and suppressing the residues of on-press development, the ratio (oligomer/low-molecular-weight polymerizable compound) of the oligomer to the low-molecular-weight polymerizable compound (total amount in a case where the polymerizable compound includes two or more low-molecular-weight polymerizable compounds) based on mass is preferably 10/1 to 1/10, more preferably 10/1 to 3/7, and even more preferably 10/1 to 7/3.

As the low-molecular-weight polymerizable compound, the polymerizable compounds described in paragraphs "0082" to "0086" of WO2019/013268A can also be suitably used.

The details of how to use the polymerizable compound, such as the structure of the compound, whether the compound is used alone or used in combination with other compounds, and the additive amount of the compound, can be optionally set.

Particularly, from the viewpoint of printing durability, the image-recording layer preferably contains two or more polymerizable compounds.

The content of the polymerizable compound (total content of polymerizable compounds in a case where the image-recording layer contains two or more polymerizable compounds) with respect to the total mass of the image-recording layer is preferably 5% by mass to 75% by mass, more preferably 10% by mass to 70% by mass, and even more preferably 15% by mass to 60% by mass.

[Polymerization initiator]

The image-recording layer in the present disclosure contains a polymerization initiator.

From the viewpoint of sensitivity, printing durability, on-press developability, and receptivity, the polymerization initiator preferably includes an electron-donating polymerization initiator, and more preferably includes an electron-accepting polymerization initiator and an electron-donating polymerization initiator.

-Electron-accepting polymerization initiator-

It is preferable that the image-recording layer contain an electron-accepting polymerization initiator as a polymerization initiator.

The electron-accepting polymerization initiator is a compound which accepts an electron by intermolecular

electron migration in a case where electrons of an infrared absorber are excited by exposure to infrared rays, and generates a polymerization initiation species such as radicals.

The electron-accepting polymerization initiator used in the present disclosure is a compound that generates a polymerization initiation species such as a radical or a cation by either or both of light energy and heat energy, and can be appropriately selected from known thermal polymerization initiators, compounds having a bond that requires low bond dissociation energy, photopolymerization initiators, and the like.

The electron-accepting polymerization initiator is preferably a radical polymerization initiator and more preferably an onium salt compound.

In addition, as the electron-accepting polymerization initiator, an infrared-ray-sensitive polymerization initiator is preferable.

Examples of the electron-accepting radical polymerization initiator include (a) organic halide, (b) carbonyl compound, (c) azo compound, (d) organic peroxide, (e) metallocene compound, (f) azide compound, (g) hexaarylbiimidazole compound, (i) disulfone compound, (j) oxime ester compound, and (k) onium salt compound.

As (a) organic halide, for example, the compounds described in paragraphs "0022" and "0023" of JP2008-195018A are preferable.

As (b) carbonyl compound, for example, the compounds described in paragraph "0024" of JP2008-195018A are preferable.

As (c) azo compound, for example, the azo compounds described in JP1996-108621A (JP-H8-108621A) and the like can be used.

As (d) organic peroxide, for example, the compounds described in paragraph "0025" of JP2008-195018A are preferable.

As (e) metallocene compound, for example, the compounds described in paragraph "0026" of JP2008-195018A are preferable.

Examples of (f) azide compound include compounds such as 2,6-bis(4-azidobenzylidene)-4-methylcyclohexanone.

As (g) hexaarylbiimidazole compound, for example, the compounds described in paragraph "0027" of JP2008-195018A are preferable.

Examples of (i) disulfone compound include the compounds described in JP1986-166544A (JP-S61-166544A) and JP2002-328465A.

As (j) oxime ester compound, for example, the compounds described in paragraphs "0028" to "0030" of JP2008-195018A are preferable.

Among the above electron-accepting polymerization initiators, from the viewpoint of curing properties, an oxime ester compound and an onium salt compound are preferable. Particularly, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Specific examples of these compounds will be shown below, but the present disclosure is not limited thereto.

As the iodonium salt compound, for example, a diaryliodonium salt compound is preferable. Particularly, an electron-donating group, for example, a diphenyl iodonium salt compound substituted with an electron-donating group such as an alkyl group or an alkoxyl group is more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium--hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As the sulfonium salt compound, for example, a triarylsulfonium salt compound is preferable. Particularly, a triarylsulfonium salt compound is preferable in which at least some of electron-withdrawing groups such as groups on an aromatic ring are substituted with halogen atoms, and a triarylsulfonium salt compound is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

As a counteranion of the iodonium salt compound and the sulfonium salt compound, a sulfonamide anion or a sulfonimide anion is preferable, and a sulfonimide anion is more preferable.

As the sulfonamide anion, an aryl sulfonamide anion is preferable.

In addition, as the sulfonimide anion, a bisaryl sulfonimide anion is preferable.

Specifically, suitable examples of the sulfonamide anion and the sulfonimide anion include those described in

WO2020/262692A.

From the viewpoint of developability and printing durability of the lithographic printing plate to be obtained, the electron-accepting polymerization initiator may include a compound represented by Formula (II).

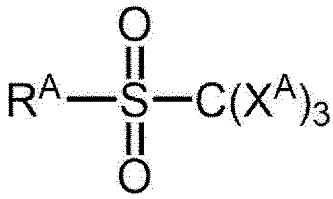

(II)

In Formula (II), $X^A$ represents a halogen atom, and $R^A$ represents an aryl group.

Specifically, examples of $X^A$ in Formula (II) include a fluorine atom, a chlorine atom, a bromine atom, and an iodine atom. Among these, a chlorine atom or a bromine atom is preferable because these have excellent sensitivity, and a bromine atom is particularly preferable.

Furthermore, from the viewpoint of excellent balance between sensitivity and storage stability, $R^A$ in Formula (II) is preferably an aryl group substituted with an amide group.

As a specific example of the electron-accepting polymerization initiator represented by Formula (II), those described in WO2020/262692A can be suitably used.

From the viewpoint of improving sensitivity and making it difficult for plate missing to occur, the lowest unoccupied molecular orbital (LUMO) of the electron-accepting polymerization initiator is preferably -3.00 eV or less, and more preferably -3.02 eV or less.

The lower limit of LUMO is preferably -3.80 eV or more and more preferably -3.60 eV or more.

One electron-accepting polymerization initiator may be used alone, or two or more electron-accepting polymerization initiators may be used in combination.

The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

-Electron-donating polymerization initiator-

The polymerization initiator preferably further includes an electron-donating polymerization initiator, and more preferably includes both the electron-donating polymerization initiator and the electron-accepting polymerization initiator described above, because such a polymerization initiator contributes to the improvement of chemical resistance and printing durability of the lithographic printing plate.

Examples of the electron-donating polymerization initiator include the following five kinds of initiators.

(i) Alkyl- or aryl-ate complex: considered to generate active radicals by oxidative cleavage of carbon-hetero bond. Specific examples thereof include a borate salt compound and the like.

(ii) Amino acetate compound: considered to generate active radicals by oxidation-induced cleavage of C-X bond on carbon adjacent to nitrogen. X is preferably a hydrogen atom, a carboxy group, a trimethylsilyl group, or a benzyl group. Specific examples thereof include N-phenylglycines (which may have a substituent in a phenyl group.), N-phenyl iminodiacetic acids (which may have a substituent in a phenyl group), and the like.

(iii) Sulfur-containing compound: compound obtained by substituting nitrogen atoms of the aforementioned amino acetate compound with sulfur atoms and capable of generating active radicals by the same action as that of the amino acetate compound. Specific examples thereof include phenylthioacetic acids (which may have a substituent on a phenyl group) and the like.

(iv) Tin-containing compound: compound obtained by substituting nitrogen atoms of the aforementioned amino acetate compound with tin atoms and capable of generating active radicals by the same action as that of the amino acetate compound.

(v) Sulfinates: capable of generating active radicals by oxidation. Specific examples thereof include sodium aryl sulfinate and the like.

It is preferable that the image-recording layer contain the borate salt compound among the above electron-donating polymerization initiators. As the borate salt compound, a tetraaryl borate salt compound or a monoalkyltriaryl borate salt compound is preferable. From the viewpoint of compound stability, a tetraaryl borate salt compound is more preferable, and a tetraphenyl borate salt compound is particularly preferable.

A countercation that the borate salt compound has is not particularly limited, but is preferably an alkali metal ion or a tetraalkyl ammonium ion and more preferably a sodium ion, a potassium ion, or a tetrabutylammonium ion.

Specifically, preferred examples of the borate salt compound include sodium tetraphenyl borate.

From the viewpoint of chemical resistance and printing durability, the highest occupied molecular orbital (HOMO) of the electron-donating polymerization initiator used in the present disclosure is preferably -6.00 eV or more, more preferably -5.95 eV or more, even more preferably -5.93 eV or more, and particularly preferably more than -5.90 eV

The upper limit of HOMO is preferably -5.00 eV or less and more preferably -5.40 eV or less.

Specifically, preferred examples of the electron-donating polymerization initiator suitably include the electron-donating polymerization initiator described in WO2020/262692A.

From the viewpoint of visibility, printing durability, and temporal stability, the image-recording layer preferably contains an onium salt compound as the electron-accepting polymerization initiator and contains at least one kind of compound selected from the group consisting of borate salt compounds as the electron-donating polymerization initiator, and more preferably contains an onium salt compound as the electron-accepting polymerization initiator and contains a borate salt compound as the electron-donating polymerization initiator.

Furthermore, the image-recording layer preferably contains a borate salt compound as the electron-donating polymerization initiator. The image-recording layer more preferably contains a borate salt compound as the electron-donating polymerization initiator, and the HOMO value of the infrared absorber - the HOMO value of the borate salt compound is more preferably equal to or less than 0.70 eV

Only one kind of electron-donating polymerization initiator may be added to the image-recording layer, or two or more kinds of electron-donating polymerization initiators may be used in combination.

The content of the electron-donating polymerization initiator with respect to the total mass of the image-recording layer is preferably 0.01% by mass to 30% by mass, more preferably 0.05% by mass to 25% by mass, and even more preferably 0.1% by mass to 20% by mass.

One of the preferred aspects of the present disclosure is an aspect in which the aforementioned electron-accepting polymerization initiator and the aforementioned electron-donating polymerization initiator form a salt.

Specific examples thereof include an aspect in which the aforementioned onium salt compound is a salt formed of an onium ion and an anion of the electron-donating polymerization initiator (for example, a tetraphenyl borate anion). Furthermore, for example, an iodonium borate salt compound is more preferable which is a salt formed of an iodonium cation of the aforementioned iodonium salt compound (for example, a di-p-tolyl iodonium cation) and a borate anion of the aforementioned electron-donating polymerization initiator.

Specific examples of the aspect in which the electron-accepting polymerization initiator and the electron-donating polymerization initiator form a salt suitably include those described in WO2020/262692A.

In the present disclosure, in a case where the image-recording layer contains an onium ion and an anion of the aforementioned electron-donating polymerization initiator, the image-recording layer is regarded as containing an electron-accepting polymerization initiator and the electron-donating polymerization initiator described above.

[Relationship among electron-donating polymerization initiator, electron-accepting polymerization initiator, and infrared absorber]

The image-recording layer of the present disclosure preferably contains the electron-donating polymerization initiator, the electron-accepting polymerization initiator, and the infrared absorber described above. HOMO of the electron-donating polymerization initiator is preferably -6.0 eV or more, and LUMO of the electron-accepting polymerization initiator is preferably -3.0 eV or less.

More preferred aspects of HOMO of the electron-donating polymerization initiator and LUMO of the electron-accepting polymerization initiator are as described above.

Presumably, in the image-recording layer of the present disclosure, the electron-donating polymerization initiator, at least one of the infrared absorbers, and the electron-accepting polymerization initiator may exchange energy, for example, in the manner described in the following chemical formula.

Accordingly, it is considered that in a case where HOMO of the electron-donating polymerization initiator is -6.0 eV or more and LUMO of the electron-accepting polymerization initiator is -3.0 eV or less, radicals may be more efficiently generated, and chemical resistance and printing durability may be therefore further improved easily.

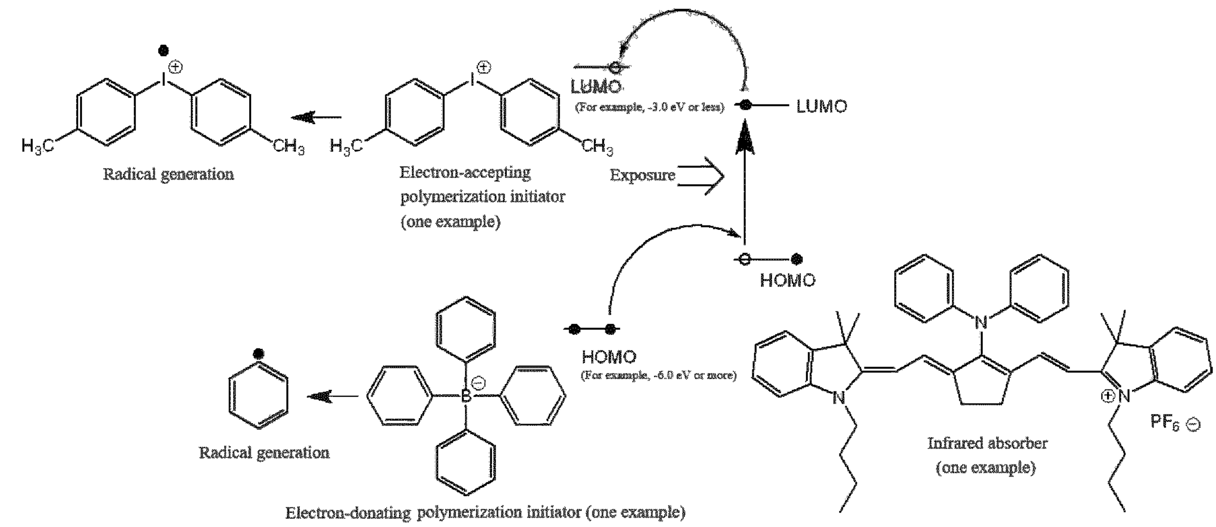


From the viewpoints of printing durability and chemical resistance, the HOMO value of the infrared absorber - the HOMO value of the electron-donating polymerization initiator is preferably 1.0 eV or less, more preferably 0.70 eV or less, and particularly preferably 0.60 eV or less. Furthermore, from the same viewpoint as above, the HOMO value of the infrared absorber - the HOMO value of the electron-donating polymerization initiator is preferably equal to or more than -0.200 eV, and more preferably equal to or more than -0.100 eV The negative sign means that HOMO of the electron-donating polymerization initiator is higher than HOMO of the infrared absorber.

In addition, from the viewpoint of printing durability and chemical resistance, the LUMO value of the electron-accepting polymerization initiator - the LUMO value of the infrared absorber is preferably equal to or less than 1.00 eV, and more preferably equal to or less than 0.700 eV Furthermore, from the same viewpoint as above, the LUMO value of the electron-accepting polymerization initiator - the LUMO value of the infrared absorber is preferably equal to or more than -0.200 eV, and more preferably equal to or more than -0.100 eV

Furthermore, from the same viewpoint as above, the LUMO value of the electron-accepting polymerization initiator - the LUMO value of the infrared absorber is preferably in a range of 1.00 eV to -0.200 eV and more preferably in a range of 0.700 eV to -0.100 eV The negative sign means that LUMO of the infrared absorber is higher than LUMO of the electron-accepting polymerization initiator.

[Particles]

From the viewpoint of printing durability, the image-recording layer preferably contains particles.

The particles may be organic particles or inorganic particles. From the viewpoint of printing durability, the image-recording layer preferably contains organic particles, and more preferably contains polymer particles.

As inorganic particles, known inorganic particles can be used, and metal oxide particles such as silica particles and titania particles can be suitably used.

The polymer particles are preferably selected from the group consisting of thermoplastic resin particles, thermal reactive resin particles, polymer particles having a polymerizable group, microcapsules encapsulating a hydrophobic compound, and a microgel (crosslinked polymer particles). Among these, polymer particles having a polymerizable group or a microgel are preferable. In a particularly preferred embodiment, the polymer particles have at least one ethylenically unsaturated group. The presence of such polymer particles brings about effects of improving the printing durability of an exposed portion and improving the on-press developability of a non-exposed portion.

From the viewpoints of printing durability and on-press developability, the polymer particles are preferably thermoplastic resin particles.

The thermoplastic resin particles are preferably the thermoplastic polymer particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like.

Specific examples of polymers constituting the thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylate or methacrylate having a polyalkylene structure, and the like and mixtures of these. Preferred examples thereof can include polystyrene, copolymers having styrene and acrylonitrile, or polymethyl methacrylate. The average particle diameter of the thermoplastic resin particle is preferably 0.01 μm to 3.0 μm.

Examples of the thermal reactive resin particles include polymer particles having a thermal reactive group. The thermal reactive polymer particles form a hydrophobilized region through crosslinking by a thermal reaction and the accompanying change in functional groups.

The thermal reactive group in the polymer particles having a thermal reactive group may be a functional group that causes any reaction as long as chemical bonds are formed, and is preferably a polymerizable group. Preferred examples thereof include an ethylenically unsaturated group that causes a radical polymerization reaction (for example, an acryloyl group, a methacryloyl group, a vinyl group, an allyl group, and the like), a cationically polymerizable group (for example, a vinyl group, a vinyloxy group, an epoxy group, an oxetanyl group, and the like), an isocyanato group or a blocked isocyanato group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

Examples of the microcapsules include microcapsules encapsulating at least some of the constituent components of the image-recording layer as described in JP2001-277740A and JP2001-277742A. The constituent components of the image-recording layer can also be contained in the exterior of the microcapsules. In a preferred aspect, the image-recording layer containing microcapsules is constituted such that hydrophobic constituent components are encapsulated in the microcapsules and hydrophilic constituent components are contained in the exterior of the microcapsules.

The microgel (crosslinked polymer particles) can contain some of the constituent components of the image-recording layer, in at least one of the surface or the interior of the microgel. From the viewpoints of sensitivity of the lithographic printing plate precursor to be obtained and printing durability of the lithographic printing plate to be obtained, a reactive microgel having a radically polymerizable group on the surface thereof is particularly preferable.

In order to encapsulate the constituent components of the image-recording layer in microcapsules or microgel, known methods can be used.

From the viewpoints of printing durability, antifouling property, and storage stability of the lithographic printing plate to be obtained, the polymer particles are preferably polymer particles which are obtained by a reaction of a polyvalent isocyanate compound that is an adduct of a polyhydric phenol compound having two or more hydroxy groups in a molecule and isophorone diisocyanate with a compound having active hydrogen.

The polyhydric phenol compound is preferably a compound having a plurality of benzene rings having a phenolic hydroxy group.

The compound having active hydrogen is preferably a polyol compound or a polyamine compound, more preferably a polyol compound, and even more preferably at least one compound selected from the group consisting of propylene glycol, glycerin, and trimethylolpropane.

Preferred examples of the resin particles obtained by the reaction of a polyvalent isocyanate compound that is an adduct of a polyhydric phenol compound having two or more hydroxy groups in a molecule and isophorone diisocyanate, with a compound having active hydrogen include the polymer particles described in paragraphs "0032" to "0095" of JP2012-206495A.

Furthermore, from the viewpoint of printing durability and solvent resistance of the lithographic printing plate to be obtained, the polymer particles preferably have a hydrophobic main chain and include both i) constitutional unit having a pendant cyano group directly bonded to the hydrophobic main chain and ii) constitutional unit having a pendant group including a hydrophilic polyalkylene oxide segment.

Preferred examples of the hydrophobic main chain include an acrylic resin chain.

Preferred examples of the pendant cyano group include $-[CH_2CH(C{\equiv}N)]-$ or $-[CH_2C(CH_3)(C{\equiv}N)]-$.

In addition, the constitutional unit having the pendant cyano group can be easily derived from an ethylenically unsaturated monomer, for example, acrylonitrile or methacrylonitrile, or a combination of these.

Furthermore, as an alkylene oxide in the hydrophilic polyalkylene oxide segment, ethylene oxide or a propylene oxide is preferable, and ethylene oxide is more preferable.

The number of repeating alkylene oxide structures in the hydrophilic polyalkylene oxide segment is preferably 10 to 100, more preferably 25 to 75, and even more preferably 40 to 50.

As the resin particles having a hydrophobic main chain and including both i) constitutional unit having the pendant cyano group directly bonded to the hydrophobic main chain and ii) constitutional unit having a pendant group including the hydrophilic polyalkylene oxide segment, for example, the particles described in paragraphs "0039" to "0068" of JP2008-503365A are preferable.

From the viewpoints of printing durability and on-press developability, the polymer particles preferably have a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

Among these, from the viewpoints of on-press developability and printing durability, a polyalkylene oxide structure is preferable, and a polyethylene oxide structure, a polypropylene oxide structure, or a polyethylene/propylene oxide structure is more preferable.

In addition, from the viewpoints of on-press developability and suppressing the residues of development during on-press development, the polyalkylene oxide structure preferably has a polypropylene oxide structure, and more preferably has a polyethylene oxide structure and a polypropylene oxide structure.

From the viewpoints of printing durability, receptivity, and on-press developability, the hydrophilic group preferably has a constitutional unit having a cyano group, or a group represented by Formula Z, more preferably has a constitutional unit represented by Formula (AN) or a group represented by Formula Z, and particularly preferably has a group represented by Formula Z.

$$*\text{-Q-W-Y} \qquad \text{Formula Z}$$

In Formula Z, Q represents a divalent linking group, W represents a divalent group having a hydrophilic structure or a divalent group having a hydrophobic structure, and Y represents a monovalent group having a hydrophilic structure or a monovalent group having a hydrophobic structure, either W or Y has a hydrophilic structure, and * represents a bonding site with another structure.

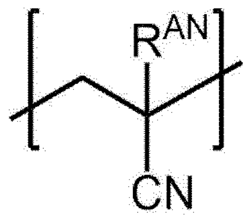

( AN )

In Formula (AN), $R^{AN}$ represents a hydrogen atom or a methyl group.

From the viewpoint of printing durability, the polymer contained in the polymer particles preferably has a constitutional unit formed of a compound having a cyano group.

Generally, it is preferable that a cyano group is introduced as a constitutional unit having a cyano group into a resin by using a compound (monomer) having a cyano group. Examples of the compound having a cyano group include acrylonitrile compounds and suitable examples thereof include (meth)acrylonitrile.

The constitutional unit having a cyano group is preferably a constitutional unit formed of an acrylonitrile compound, and more preferably a constitutional unit formed of (meth)acrylonitrile, that is, a constitutional unit represented by Formula (AN).

In a case where the polymer includes a polymer having a constitutional unit having a cyano group, from the viewpoint of printing durability, the content of the constitutional unit having a cyano group which is preferably a constitutional unit represented by Formula (AN) in the polymer having the constitutional unit having a cyano group with respect to the total mass of the polymer having the constitutional unit having a cyano group is preferably 5% by mass to 90% by mass, more preferably 20% by mass to 80% by mass, and particularly preferably 30% by mass to 60% by mass.

In addition, from the viewpoints of printing durability, receptivity, and on-press developability, the polymer particles preferably include polymer particles having a group represented by Formula Z.

Q in Formula Z is preferably a divalent linking group having 1 to 20 carbon atoms, and more preferably a divalent linking group having 1 to 10 carbon atoms.

In addition, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$'s each independently represent a linear, branched, or cyclic alkylene group having a carbon number of 6 to 120, a haloalkylene group having a carbon number of 6 to 120, an arylene group having a carbon number of 6 to 120, an alkarylene group having a carbon number of 6 to

120 (divalent group formed by removing one hydrogen atom from an alkylaryl group), or an aralkylene group having a carbon number of 6 to 120.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2NR^W-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group (alkylaryl group) having 7 to 120 carbon atoms, an aralkyl group having 7 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoints of printing durability, receptivity, and on-press developability, in the polymer particles having a group represented by formula Z, W is preferably a divalent group having a hydrophilic structure, and it is more preferable that Q is a phenylene group, an ester bond, or an amide bond, W is a polyalkyleneoxy group, and Y is a polyalkyleneoxy group having a hydrogen atom or an alkyl group on a terminal.

From the viewpoints of printing durability and on-press developability, the polymer particles preferably include polymer particles having a polymerizable group, and more preferably include polymer particles having a polymerizable group on the particle surface.

Furthermore, from the viewpoint of printing durability, the polymer particles preferably include polymer particles having a hydrophilic group and a polymerizable group.

The polymerizable group may be a cationically polymerizable group or a radically polymerizable group and, from the viewpoint of reactivity, is preferably a radically polymerizable group.

The polymerizable group is not particularly limited as long as it is a polymerizable group, but from the viewpoint of reactivity, is preferably an ethylenically unsaturated group, more preferably a vinylphenyl group (styryl group), a (meth)acryloxy group, or a (meth)acrylamide group, and particularly preferably a (meth)acryloxy group.

In addition, the polymer in the polymer particles having a polymerizable group preferably has a constitutional unit having a polymerizable group.

The polymerizable group may be introduced into the surface of the polymer particles by a polymer reaction.

In addition, from the viewpoints of printing durability and on-press developability, the image-recording layer preferably contains, as the polymer particles, addition polymerization-type resin particles having a dispersible group which more preferably includes a group represented by Formula Z.

From the viewpoints of printing durability, receptivity, on-press developability, and suppressing the residues of development during on-press development, the polymer particles preferably contain a resin having a urea bond.

Suitable examples of the resin having a urea bond include those described in WO2020/262692A.

From the viewpoints of printing durability and on-press developability, the image-recording layer preferably contains thermoplastic resin particles.

The thermoplastic resin contained in the thermoplastic resin particles is not particularly limited, and examples thereof include polyethylene, polystyrene, polyvinyl chloride, polyvinylidene chloride, polymethyl (meth)acrylate, polyethyl (meth)acrylate, polybutyl (meth)acrylate, polyacrylonitrile, polyvinyl acetate, copolymers of these, and the like. The thermoplastic resin may be in the state of latex.

The thermoplastic resin according to the present disclosure is preferably a thermoplastic resin which melts or softens by heat generated in an exposure step that will be described later and thus forms a part or the entirety of a hydrophobic film forming the recording layer.

From the viewpoints of ink receptivity and printing durability, the thermoplastic resin preferably contains a resin having a constitutional unit formed of an aromatic vinyl compound and a constitutional unit having a cyano group.

Suitable examples of the resin having a constitutional unit formed of an aromatic vinyl compound and a constitutional unit having a cyano group include those described in WO2020/262692A.

From the viewpoints of printing durability and on-press developability, the thermoplastic resin contained in the thermoplastic resin particles preferably has a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

From the viewpoints of printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and even more preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

In addition, from the viewpoint of on-press developability, among the hydrophilic groups, as a polyalkylene oxide structure, groups having a polypropylene oxide structure are preferable, and groups having a polyethylene oxide structure and a polypropylene oxide structure are more preferable.

From the viewpoint of on-press developability, the number of alkylene oxide structures in the polyalkylene oxide structure is preferably 2 or more, more preferably 5 or more, even more preferably 5 to 200, and particularly preferably 8 to 150.

From the viewpoint of on-press developability, the hydrophilic group is preferably a group represented by Formula Z.

From the viewpoints of printing durability and ink receptivity, the glass transition temperature (Tg) of the thermoplastic resin is preferably 60°C to 150°C, more preferably 80°C to 140°C, and even more preferably 90°C to 130°C.

In a case where the thermoplastic resin particles contain two kinds of thermoplastic resins, the value obtained by the FOX equation that will be described later is referred to as the glass transition temperature of the thermoplastic resin.

In the present disclosure, the glass transition temperature of a resin can be measured by differential scanning calorimetry (DSC).

Specifically, the glass transition temperature is measured according to the method described in JIS K 7121 (1987) or JIS K 6240 (2011). As the glass transition temperature in the present specification, an extrapolated glass transition initiation temperature (hereinafter, may be referred to as Tig) is used.

The method of measuring the glass transition temperature will be described in more detail.

In a case of determining the glass transition temperature, the device is kept at a temperature approximately 50°C lower than the expected Tg of the resin until the device stabilizes. Then, the resin is heated at a heating rate of 20 °C/min to a temperature approximately 30°C higher than the temperature at which the glass transition ends, and a differential thermal analysis (DTA) curve or a DSC curve is created.

The extrapolated glass transition initiation temperature (Tig), that is, the glass transition temperature Tg in the present specification is determined as a temperature at an intersection point between a straight line that is obtained by extending the baseline of a low temperature side in the DTA curve or the DSC curve to a high temperature side and a tangent line that is drawn at a point where the slope of the curve of a portion in which the glass transition changes stepwisely is maximum.

In a case where the thermoplastic resin particles contain two kinds of thermoplastic resins, Tg of the thermoplastic resin particles is determined as follows.

In a case where Tg1 (K) represents Tg of a first thermoplastic resin, W1 represents the mass ratio of the first thermoplastic resin to the total mass of thermoplastic resin components in the thermoplastic resin particles, Tg2 (K) represents Tg of a second thermoplastic resin, and W2 represents the mass ratio of the second resin to the total mass of thermoplastic resin components in the thermoplastic resin particles, Tg0 (K) of the thermoplastic resin particles can be estimated according to the following FOX equation.

$$\text{FOX equation: } 1/Tg0 = (W1/Tg1) + (W2/Tg2)$$

In addition, in a case where the thermoplastic resin particles contain three or more kinds of resins or in a case where three or more kinds of thermoplastic resin particles each containing different types of thermoplastic resins are contained in a pretreatment liquid, similarly to the case described above, in a case where Tgn (K) represents Tg of nth resin and Wn represents the mass ratio of the nth resin to the total mass of resin components in the thermoplastic resin particles, Tg0 (K) of the thermoplastic resin particles can be estimated according to the following equation.

$$\text{FOX equation: } 1/Tg0 = (W1/Tg1) + (W2/Tg2) + (W3/Tg3) \cdots + (Wn/Tgn)$$

As the differential scanning calorimeter (DSC), for example, EXSTAR 6220 manufactured by SII NanoTechnology Inc. can be used.

From the viewpoint of printing durability, the arithmetic mean particle diameter of the thermoplastic resin particles is preferably 1 nm or more and 200 nm or less, more preferably 3 nm or more and less than 80 nm, and even more preferably 10 nm or more and 49 nm or less.

Unless otherwise specified, the arithmetic mean particle diameter of the thermoplastic resin particles in the present disclosure refers to a value measured by a dynamic light scattering method (DLS). The measurement of the arithmetic mean particle diameter of the thermoplastic resin particles by DLS is carried out using Brookhaven BI-90 (manufactured by Brookhaven Instruments) according to the manual of the instrument.

The weight-average molecular weight of the thermoplastic resin contained in the thermoplastic resin particles is preferably 3,000 to 300,000, and more preferably 5,000 to 100,000.

The manufacturing method of the thermoplastic resin contained in the thermoplastic resin particles is not particularly limited, and the thermoplastic resin can be manufactured by known methods.

For example, the polymer is obtained by polymerizing a styrene compound, an acrylonitrile compound, and at least one kind of optional compound selected from the group consisting of the aforementioned N-vinyl heterocyclic compound, a compound used for forming the aforementioned ethylenically unsaturated group-containing constitutional unit, a compound used for forming the aforementioned acidic group-containing constitutional unit, a compound used for forming the aforementioned hydrophobic group-containing constitutional unit, and a compound used for forming the aforementioned other constitutional units by known methods.

Specifically, suitable examples of the thermoplastic resin contained in the thermoplastic resin particles include those described in WO2020/262692A.

The average particle diameter of the particles is preferably 0.01 μm to 3.0 μm, more preferably 0.03 μm to 2.0 μm, and even more preferably 0.10 μm to 1.0 μm. In a case where the average particle diameter is in this range, excellent resolution and excellent temporal stability are obtained.

The average primary particle diameter of the particles in the present disclosure is obtained by measuring with a light scattering method or by imaging an electron micrograph of the particles, measuring the particle diameter of a total of 5,000 particles in the photograph, and calculating the average value thereof. For non-spherical particles, the value of particle diameter of spherical particles having the same area as the area of the particles on the photograph is adopted as the particle diameter.

Unless otherwise specified, the average particle diameter in the present disclosure means a volume average particle diameter.

The image-recording layer may contain only one kind of particles, particularly, one kind of polymer particles or two or more kinds of polymer particles.

From the viewpoints of on-press developability and printing durability, the content of particles, particularly, the content of polymer particles in the image-recording layer with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.

In addition, from the viewpoints of on-press developability and printing durability, the content of the polymer particles in the image-recording layer with respect to the total mass of components having a molecular weight of 3,000 or more in the image-recording layer is preferably 20% by mass to 100% by mass, more preferably 35% by mass to 100% by mass, even more preferably 50% by mass to 100% by mass, and particularly preferably 80% by mass to 100% by mass.

[Binder polymer]

The image-recording layer may contain a binder polymer.

The above-described polymer particles do not correspond to the binder polymer. That is, the binder polymer is a polymer that is not in the form of particles.

The binder polymer is preferably a (meth)acrylic resin, a polyvinyl acetal resin, or a polyurethane resin.

Among these, as the binder polymer, known binder polymers that can be used in an image-recording layer in lithographic printing plate precursors can be suitably used. As an example, a binder polymer that is used for an on-press development type lithographic printing plate precursor (hereinafter, also called binder polymer for on-press development) will be specifically described.

As the binder polymer for on-press development, a binder polymer having an alkylene oxide chain is preferable. The binder polymer having an alkylene oxide chain may have a poly(alkylene oxide) moiety in a main chain or side chain. In addition, the binder polymer may be a graft polymer having poly(alkylene oxide) in a side chain or a block copolymer of a block composed of a poly(alkylene oxide)-containing repeating unit and a block composed of an (alkylene oxide)-free repeating unit.

In a case where the binder polymer has a poly(alkylene oxide) moiety in the main chain, a polyurethane resin is preferable. In a case where the binder polymer has a poly(alkylene oxide) moiety in the side chain, examples of polymers as the main chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber, and a (meth)acrylic resin is particularly preferable.

In addition, other preferred examples of the binder polymer include a polymer compound which has a polyfunctional thiol having functionalities of 6 or more and 10 or less as a nucleus and a polymer chain that is bonded to the nucleus by a sulfide bond and has a polymerizable group (hereinafter, this compound will be also called star-shaped polymer compound).

From the viewpoint of curability, preferred examples of the star-shaped polymer compound include a star-shaped polymer compound having a polymerizable group such as an ethylenically unsaturated group on a main chain

or a side chain, and more preferably on a side chain.

Examples of the star-shaped polymer compound include those described in JP2012-148555A or WO2020/262692A.

The molecular weight of the binder polymer that is a polystyrene-equivalent weight-average molecular weight (Mw) determined by GPC is preferably 2,000 or more, more preferably 5,000 or more, and even more preferably 10,000 to 300,000.

As necessary, a hydrophilic polymer such as polyacrylic acid or polyvinyl alcohol described in JP2008-195018A can be used in combination. In addition, a lipophilic (hydrophobic) polymer and a hydrophilic polymer can be used in combination.

From the viewpoints of printing durability and on-press developability, the image-recording layer preferably contains a polymer having a constitutional unit formed of an aromatic vinyl compound, and more preferably contains a polymer having a constitutional unit formed of an aromatic vinyl compound and an infrared absorber which decomposes by exposure to infrared rays.

In addition, for example, from the viewpoint of inhibiting on-press developability from deteriorating with the passage of time, the glass transition temperature (Tg) of the binder polymer used in the present disclosure is preferably 50°C or higher, more preferably 70°C or higher, even more preferably 80°C or higher, and particularly preferably 90°C or higher

Furthermore, from the viewpoint of ease of permeation of water into the image-recording layer, the upper limit of the glass transition temperature of the binder polymer is preferably 200°C, and more preferably 120°C or lower.

From the viewpoint of further inhibiting on-press developability from deteriorating with the passage of time, the binder polymer having the above-described glass transition temperature is preferably polyvinyl acetal.

Polyvinyl acetal is a resin obtained by acetalizing a hydroxy group of polyvinyl alcohol with an aldehyde.

Particularly, polyvinyl butyral is preferable which is obtained by acetalizing (that is, butyralizing) a hydroxy group of polyvinyl alcohol with butyraldehyde.

From the viewpoint of improving printing durability, the polyvinyl acetal preferably has an ethylenically unsaturated group.

Suitable examples of the polyvinyl acetal include those described in WO2020/262692A.

The image-recording layer in the present disclosure preferably contains a resin having a fluorine atom, and more preferably contains a fluoroaliphatic group-containing copolymer.

In a case where the resin having a fluorine atom, particularly, the fluoroaliphatic group-containing copolymer is used, it is possible to inhibit surface abnormalities resulting from foaming during the formation of the image-recording layer and to improve the condition of the coated surface, and further to improve the ink receptivity of the formed image-recording layer.

In addition, the image-recording layer containing the fluoroaliphatic group-containing copolymer has high gradation and is highly sensitive, for example, to laser light. Therefore, the obtained lithographic printing plate exhibits excellent fogging property by scattered light, reflected light, and the like and has excellent printing durability.

As the fluoroaliphatic group-containing copolymer, those described in WO2020/262692A can be suitably used.

In the image-recording layer used in the present disclosure, one binder polymer may be used alone, or two or more binder polymers may be used in combination.

The content of the binder polymer to be contained in the image-recording layer can be optionally set, and the content of the binder polymer with respect to the total mass of the image-recording layer is preferably 1% by mass to 90% by mass and more preferably 5% by mass to 80% by mass.

[Chain transfer agent]

The image-recording layer used in the present disclosure may contain a chain transfer agent. The chain transfer agent contributes to the improvement of printing durability of the lithographic printing plate.

The chain transfer agent is preferably a thiol compound, more preferably a thiol compound having 7 or more carbon atoms from the viewpoint of boiling point (low volatility), and even more preferably a compound having a mercapto group on an aromatic ring (aromatic thiol compound). The thiol compound is preferably a monofunctional thiol compound.

Specifically, suitable examples of the chain transfer agent include those described in WO2020/262692A.

Only one chain transfer agent may be added to the image-recording layer, or two or more chain transfer agents may be used in combination.

The content of the chain transfer agent with respect to the total mass of the image-recording layer is preferably 0.01% by mass to 50% by mass, more preferably 0.05% by mass to 40% by mass, and even more preferably 0.1% by mass to 30% by mass.

[Oil sensitizing agent]

In order to improve ink receptivity, the image-recording layer preferably further contains an oil sensitizing agent.

The SP value of the oil sensitizing agent is preferably less than 18.0, more preferably 14 or more and less than 18, even more preferably 15 to 17, and particularly preferably 16 to 16.9.

In addition, the oil sensitizing agent may be a compound having a molecular weight (weight-average molecular weight in a case where the compound has molecular weight distribution) of 2,000 or more, or a compound having a molecular weight less than 2,000.

In the present disclosure, as the SP value (solubility parameter, (unit: $(MPa)^{1/2}$)), the Hansen solubility parameters are used.

The Hansen solubility parameters are obtained by dividing the solubility parameters introduced by Hildebrand into three components, a dispersion element $\delta d$, a polarity element $\delta p$, and a hydrogen bond element $\delta h$, and expressing the parameters in a three-dimensional space. In the present disclosure, the SP value is expressed as $\delta$ (unit: $(MPa)^{1/2}$), and a value calculated by the following equation is used.

$$\delta\ (MPa)^{1/2} = (\delta d^2 + \delta p^2 + \delta h^2)^{1/2}$$

The dispersion element $\delta d$, the polarity element $\delta p$, and the hydrogen bond element $\delta h$ of various substances have been found by Hansen and his successors, and are described in detail in the Polymer Handbook (fourth edition), VII-698 to 711.

In addition, in the present disclosure, the SP value of a polymer is calculated from the molecular structure of the polymer by the Hoy method described in Polymer Handbook fourth edition.

Examples of the aforementioned oil sensitizing agent include an onium salt compound, a nitrogen-containing low-molecular-weight compound, an ammonium compound such as an ammonium group-containing polymer, and the like.

Particularly, in a case where an inorganic lamellar compound is incorporated into an outermost layer, these compounds function as a surface coating agent for the inorganic lamellar compound and can inhibit the receptivity deterioration caused in the middle of printing by the inorganic lamellar compound.

From the viewpoint of receptivity, the oil sensitizing agent is preferably an onium salt compound.

Examples of the onium salt compound include a phosphonium compound, an ammonium compound, a sulfonium compound, and the like. As the onium salt compound, from the viewpoint described above, at least one kind of compound selected from the group consisting of a phosphonium compound and an ammonium compound is preferable.

The onium salt compound, which will be described later, in a development accelerator or electron-accepting polymerization initiator is a compound having an SP value more than 18, and is not included in the oil sensitizing agent.

Examples of the phosphonium compound include the phosphonium compounds described in JP2006-297907A and JP2007-50660A. Specific examples thereof include 1,4-bis(triphenylphosphonio)butane=di(hexafluorophosphate), 1,7-bis(triphenylphosphonio)heptane=sulfate, and 1,9-bis(triphenylphosphonio)nonane=naphthalene-2,7-disulfonate, and the like.

Preferred examples of the ammonium compound can include a nitrogen-containing low-molecular-weight compound, an ammonium group-containing polymer, and the like.

Examples of the nitrogen-containing low-molecular-weight compound include amine salts and quaternary ammonium salts. In addition, examples thereof also include imidazolinium salts, benzimidazolinium salts, pyridinium salts, and quinolinium salts.

Among these, quaternary ammonium salts and pyridinium salts are preferable.

Specific examples thereof include tetramethylammonium=hexafluorophosphate, tetrabutylammonium=hexafluorophosphate, dodecyltrimethylammonium=p-toluenesulfonate, benzyltriethylammonium--hexafluorophosphate, benzyldimethyloctylammonium=hexafluorophosphate, benzyldimethyldodecylammonium=hexafluorophosphate, the compounds described in paragraphs "0021" to "0037" of JP2008-284858A, the compounds described in paragraphs "0030" to "0057" of JP2009-90645A, and the like.

The ammonium group-containing polymer may have an ammonium group in the structure. As such a polymer, a polymer is preferable in which the content of (meth)acrylate having an ammonium group in a side chain as a copolymerization component is 5 mol% to 80 mol%. Specific examples thereof include the polymers described in paragraphs "0089" to "0105" of JP2009-208458A.

The reduced specific viscosity (unit: ml/g) value of an ammonium salt-containing polymer determined according to the measurement method described in JP2009-208458A is preferably in a range of 5 to 120, more preferably in a range of 10 to 110, and particularly preferably in a range of 15 to 100. In a case where the reduced specific viscosity is converted into a weight-average molecular weight (Mw), the weight-average molecular weight is preferably 10,000 to

150,000, more preferably 17,000 to 140,000, and particularly preferably 20,000 to 130,000.

Specific examples of the ammonium group-containing polymer will be shown below.

(1) 2-(Trimethylammonio)ethylmethacrylate=p-toluenesulfonate/3,6-dioxaheptylmethacrylate copolymer (molar ratio: 10/90, Mw: 45,000)
(2) 2-(Trimethylammonio)ethylmethacrylate=hexafluorophosphate/3,6-dioxaheptylmethacrylate copolymer (molar ratio: 20/80, Mw: 60,000)
(3) 2-(Ethyldimethylammonio)ethylmethacrylate=p-toluenesulfonate/hexylmethacrylate copolymer (molar ratio: 30/70, Mw: 45,000)
(4) 2-(Trimethylammonio)ethylmethacrylate=hexafluorophosphate/2-ethylhexylmethacrylate copolymer (molar ratio: 20/80, Mw: 60,000)
(5) 2-(Trimethylammonio)ethylmethacrylate=methylsulfate/hexylmethacrylate copolymer (molar ratio: 40/60, Mw: 70,000)
(6) 2-(Butyldimethylammonio)ethylmethacrylate=hexafluorophosphate/3,6-dioxaheptylmethacrylate copolymer (molar ratio: 25/75, Mw: 65,000)
(7) 2-(Butyldimethylammonio)ethylacrylate=hexafluorophosphate/3,6-dioxaheptylmethacrylate copolymer (molar ratio: 20/80, Mw: 65,000)
(8) 2-(Butyldimethylammonio)ethylmethacrylate= 13-ethyl-5,8,11-trioxa-1-heptadecanesulfonate/3,6-dioxaheptylmethacrylate copolymer (molar ratio: 20/80, Mw: 75,000)

The content of the oil sensitizing agent with respect to the total mass of the image-recording layer is preferably 1% by mass to 40.0% by mass, more preferably 2% by mass to 25.0% by mass, and even more preferably 3% by mass to 20.0% by mass.

The image-recording layer may contain only one oil sensitizing agent, or two or more oil sensitizing agents may be used in combination.

One of the preferred aspects of the image-recording layer used in the present disclosure is an aspect in which the image-recording layer contains two or more compounds as an oil sensitizing agent.

Specifically, from the viewpoint of satisfying both the on-press developability and receptivity, the image-recording layer used in the present disclosure preferably uses all the phosphonium compound, the nitrogen-containing low-molecular-weight compound, and the ammonium group-containing polymer as an oil sensitizing agent, and more preferably uses all the phosphonium compound, the quaternary ammonium salts, and the ammonium group-containing polymer as an oil sensitizing agent.

[Development accelerator]

The image-recording layer used in the present disclosure preferably further contains a development accelerator.

The value of polarity element as an SP value of the development accelerator is preferably 6.0 to 26.0, more preferably 6.2 to 24.0, even more preferably 6.3 to 23.5, and particularly preferably 6.4 to 22.0.

In the present disclosure, as the value of polarity element as an SP value (solubility parameter, unit: $(cal/cm^3)^{1/2}$), the value of polarity element δp in the Hansen solubility parameters is used. The Hansen solubility parameters are obtained by dividing the solubility parameters introduced by Hildebrand into three components, a dispersion element δd, a polarity element δp, and a hydrogen bond element δh, and expressing the parameters in a three-dimensional space. In the present disclosure, the polarity element δp is used.

δp $[cal/cm^3]$ is a dipole-dipole force element in the Hansen solubility parameters, V $[cal/cm^3]$ is a molar volume, and μ [D] is a dipole moment. As δp, the following equation simplified by Hansen and Beerbower is generally used.

$$\delta_p = \frac{37.4\mu}{V^{1/2}}$$

The development accelerator is preferably a hydrophilic polymer compound or a hydrophilic low-molecular-weight compound.

In the present disclosure, "hydrophilic" means that the value of polarity element as an SP value is 6.0 to 26.0,

the hydrophilic polymer compound refers to a compound having a molecular weight (weight-average molecular weight in a case where the compound has molecular weight distribution) of 3,000 or more, and the hydrophilic low-molecular-weight compound refers to a compound having a molecular weight (weight-average molecular weight in a case where the compound has molecular weight distribution) of less than 3,000.

Examples of the hydrophilic polymer compound include a cellulose compound and the like. Among these, a cellulose compound is preferable.

Examples of the cellulose compound include cellulose or a compound obtained by modifying at least a part of cellulose (modified cellulose compound). Among these, a modified cellulose compound is preferable.

Preferred examples of the modified cellulose compound include a compound which is obtained by substituting at least some of hydroxy groups of cellulose with at least one kind of group selected from the group consisting of an alkyl group and a hydroxyalkyl group.

The degree of substitution of the compound, which is obtained by substituting at least some of hydroxy groups of cellulose with at least one kind of group selected from the group consisting of an alkyl group and a hydroxyalkyl group, is preferably 0.1 to 6.0, and more preferably 1 to 4.

As the modified cellulose compound, an alkyl cellulose compound or a hydroxyalkyl cellulose compound is preferable, and a hydroxyalkyl cellulose compound is more preferable.

Preferred examples of the alkyl cellulose compound include methyl cellulose.

Preferred examples of the hydroxyalkyl cellulose compound include hydroxypropyl cellulose.

The molecular weight of the hydrophilic polymer compound (weight-average molecular weight in a case where the compound has molecular weight distribution) is preferably 3,000 to 5,000,000, and more preferably 5,000 to 200,000.

Examples of the hydrophilic low-molecular-weight compound include a glycol compound, a polyol compound, an organic amine compound, an organic sulfonic acid compound, an organic sulfamine compound, an organic sulfuric acid compound, an organic phosphonic acid compound, an organic carboxylic acid compound, a betaine compound, and the like. Among these, a polyol compound, an organic sulfonic acid compound, or a betaine compound is preferable.

Examples of the glycol compound include glycols such as ethylene glycol, diethylene glycol, triethylene glycol, propylene glycol, dipropylene glycol, and tripropylene glycol, and ether or ester derivatives of these compounds.

Examples of the polyol compound include glycerin, pentaerythritol, tris(2-hydroxyethyl) isocyanurate, and the like.

Examples of the organic amine compound include triethanolamine, diethanolamine, monoethanolamine, salts of these, and the like.

Examples of the organic sulfonic acid compound include alkyl sulfonic acid, toluene sulfonic acid, benzene sulfonic acid, salts of these, and the like. Among these, for example, alkyl sulfonic acid having an alkyl group having 1 to 10 carbon atoms is preferable.

Examples of the organic sulfamine compound include alkylsulfamic acid, salts thereof, and the like.

Examples of the organic sulfuric acid compound include alkyl sulfate, alkyl ether sulfuric acid, salts of these, and the like.

Examples of the organic phosphonic acid compound include phenylphosphonic acid, salts thereof, and the like.

Examples of the organic carboxylic acid compound include tartaric acid, oxalic acid, citric acid, malic acid, lactic acid, gluconic acid, salts of these, and the like.

Examples of the betaine compound include a phosphobetaine compound, a sulfobetaine compound, a carboxybetaine compound, and the like. Among these, for example, trimethylglycine is preferable.

The molecular weight of the hydrophilic low-molecular-weight compound (weight-average molecular weight in a case where the compound has molecular weight distribution) is preferably 100 or more and less than 3,000, and more preferably 300 to 2,500.

The development accelerator is preferably a compound having a cyclic structure.

The cyclic structure is not particularly limited. Examples thereof include a glucose ring in which at least some of hydroxy groups may be substituted, an isocyanuric ring, an aromatic ring which may have a heteroatom, an aliphatic ring which may have a heteroatom, and the like. Among these, for example, a glucose ring or an isocyanuric ring is preferable.

Examples of the compound having a glucose ring include the aforementioned cellulose compound.

Examples of the compound having an isocyanuric ring include the aforementioned tris(2-hydroxyethyl) isocyanurate and the like.

Examples of the compound having an aromatic ring include the toluene sulfonic acid and benzene sulfonic acid described above, and the like.

Examples of the compound having an aliphatic ring include a compound which is the aforementioned alkyl sulfate and has an alkyl group having a ring structure, and the like.

The compound having a cyclic structure preferably has a hydroxy group.

Preferred examples of the compound having a hydroxy group and a cyclic structure include the aforementioned

cellulose compound and the aforementioned tris(2-hydroxyethyl) isocyanurate.

The development accelerator is preferably an onium salt compound.

Examples of the onium salt compound include an ammonium compound, a sulfonium compound, and the like. Among these, an ammonium compound is preferable.

Examples of the development accelerator which is an onium salt compound include trimethylglycine and the like.

The value of polarity element as an SP value of the onium salt compound in the electron-accepting polymerization initiator is not in a range of 6.0 to 26.0. This onium salt compound is not included in the development accelerator.

The image-recording layer may contain only one kind of development accelerator, or two or more kinds of development accelerators may be used in combination.

One of the preferred aspects of the image-recording layer used in the present disclosure is an aspect in which the image-recording layer contains two or more kinds of compounds as a development accelerator.

Specifically, from the viewpoint of on-press developability and receptivity, the image-recording layer used in the present disclosure preferably contains, as a development accelerator, the polyol compound and the betaine compound described above, the betaine compound and the organic sulfonic acid compound described above, or the polyol compound and the organic sulfonic acid compound described above.

The content of the development accelerator with respect to the total mass of the image-recording layer is preferably 0.1% by mass or more and 20% by mass or less, more preferably 0.5% by mass or more and 15% by mass or less, and even more preferably 1% by mass or more and 10% by mass or less.

[Other components]

As other components, a surfactant, a polymerization inhibitor, a higher fatty acid derivative, a plasticizer, an inorganic lamellar compound, and the like can be incorporated into the image-recording layer. Specifically, the description in paragraphs "0114" to "0159" of JP2008-284817A can be referred to.

[Formation of image-recording layer]

The image-recording layer in the lithographic printing plate precursor according to the present disclosure can be formed, for example, by preparing a coating liquid by dispersing or dissolving the necessary components described above in a known solvent, coating a support with the coating liquid by a known method such as bar coating, and drying the coating liquid, as described in paragraphs "0142" and "0143" of JP2008-195018A.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, and the like. Only one solvent may be used, or two or more solvents may be used in combination. The concentration of solid contents in the coating liquid is preferably 1% by mass to 50% by mass.

The coating amount (solid content) of the image-recording layer after coating and drying varies with uses, but from the viewpoint of obtaining excellent sensitivity and excellent film characteristics of the image-recording layer, is preferably 0.3 $g/m^2$ to 3.0 $g/m^2$.

In addition, the layer thickness of the image-recording layer is preferably 0.1 μm to 3.0 μm and more preferably 0.3 μm to 2.0 μm.

In the present disclosure, the layer thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

<Support>

The lithographic printing plate precursor according to the present disclosure has a support.

The support to be used can be appropriately selected from known supports for a lithographic printing plate precursor.

The support is preferably a support having a hydrophilic surface (hereinafter, also called "hydrophilic support").

As the support in the present disclosure, an aluminum plate is preferable which has been roughened using a

known method and has undergone an anodization treatment. That is, the support in the present disclosure preferably has an aluminum plate and an aluminum anodic oxide film disposed on the aluminum plate.

In addition, it is preferable that the support has an aluminum plate and an anodic oxide film of aluminum disposed on the aluminum plate, the anodic oxide film is at a position closer to a side of the image-recording layer than the aluminum plate and has micropores extending in a depth direction from the surface of the anodic oxide film on the side of the image-recording layer, and the average diameter of the micropores within the surface of the anodic oxide film is more than 10 nm and 100 nm or less.

Furthermore, it is preferable that the micropores are each configured with a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position, an average diameter of the large diameter portion within the surface of the anodic oxide film is preferably 15 nm to 100 nm, and an average diameter of the small diameter portion at the communicate position is preferably 13 nm or less.

Fig. 1 is a schematic cross-sectional view of an embodiment of an aluminum support 12a.

The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned such that the anodic oxide film 20a is closer to the image-recording layer side than the aluminum plate 18. That is, it is preferable that the lithographic printing plate precursor according to the present disclosure have at least an anodic oxide film, an image-recording layer, and a water-soluble resin layer in this order on an aluminum plate.

-Anodic oxide film-

Hereinafter, preferred aspects of the anodic oxide film 20a will be described.

The anodic oxide film 20a is a film prepared on a surface of the aluminum plate 18 by an anodization treatment. This film has uniformly distributed ultrafine micropores 22a approximately perpendicular to the surface of the film. The micropores 22a extend from a surface of the anodic oxide film 20a on the image-recording layer side (a surface of the anodic oxide film 20a opposite to the aluminum plate 18 side) along the thickness direction (toward the aluminum plate 18 side).

The average diameter (average opening diameter) of the micropores 22a on the surface of the anodic oxide film 20a is preferably more than 10 nm and 100 nm or less. Particularly, from the viewpoint of balance between printing durability, antifouling properties, and image visibility, the average diameter of the micropores 22a is more preferably 15 nm to 60 nm, even more preferably 20 nm to 50 nm, and particularly preferably 25 nm to 40 nm. The internal diameter of the pores may be larger or smaller than the pore diameter within the surface layer.

In a case where the average diameter is more than 10 nm, printing durability and image visibility are excellent. In addition, in a case where the average diameter is 100 nm or less, printing durability is excellent.

The average diameter of the micropores 22a is a value determined by observing the surface of the anodic oxide film 20a with a field emission scanning electron microscope (FE-SEM) at 150,000X magnification (N = 4), measuring the size (diameter) of 50 micropores existing in a range of 400 nm $\times$ 600 $nm^2$ in the obtained 4 images, and averaging the measured sizes.

In a case where the shape of the micropores 22a is not circular, the equivalent circular diameter is used. "Equivalent circular diameter" is a diameter determined on an assumption that the opening portion is in the form of a circle having the same projected area as the projected area of the opening portion.

The shape of the micropores 22a is not particularly limited. In Fig. 1, the micropores 22a have a substantially straight tubular shape (substantially cylindrical shape). However, the micropores 22a may have a conical shape that tapers along the depth direction (thickness direction). In addition, the shape of the bottom portion of the micropores 22a is not particularly limited, and may be a curved (convex) or flat surface shape.

In the support, the micropores may be each composed of a large diameter portion that extends to a position at a certain depth from the surface of the anodic oxide film and a small diameter portion that is in communication with a bottom portion of the large diameter portion and extends to a position at a certain depth from the communicate position.

For example, as shown in Fig. 2, an aspect may be adopted in which an aluminum support 12b includes an aluminum plate 18 and an anodic oxide film 20b having micropores 22b each composed of a large diameter portion 24 and a small diameter portion 26.

For example, the micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communicate position to a position at a depth of 20 nm to 2,000 nm. Specifically, for example, it is possible to use the aspect described in paragraphs "0107" to "0114" of JP2019-162855A.

-Manufacturing method of support-

As a manufacturing method of the support used in the present disclosure, for example, a manufacturing method is preferable in which the following steps are sequentially performed.

- Roughening treatment step: step of performing roughening treatment on aluminum plate
- Anodization treatment step: step of subjecting aluminum plate having undergone roughening treatment to anodic oxidation
- Pore widening treatment step: step of bringing aluminum plate having anodic oxide film obtained by anodization treatment step into contact with aqueous acid solution or aqueous alkali solution such that diameter of micropores in anodic oxide film increases

Hereinafter, the procedure of each step will be specifically described.

<<Roughening treatment step>>

The roughening treatment step is a step of performing a roughening treatment including an electrochemical roughening treatment on the surface of the aluminum plate. This step is preferably performed before the anodization treatment step which will be described later. However, in a case where the surface of the aluminum plate already has a preferable shape, the roughening treatment step may not be performed. This step can be carried out by the method described in paragraphs "0086" to "0101" of JP2019-162855A.

<<Anodization treatment step>>

The procedure of the anodization treatment step is not particularly limited as long as the aforementioned micropores can be obtained. Examples thereof include known methods.
In the anodization treatment step, an aqueous solution of sulfuric acid, phosphoric acid, oxalic acid, or the like can be used as an electrolytic cell. For example, the concentration of sulfuric acid is 100 g/L to 300 g/L.
The conditions of the anodization treatment are appropriately set depending on the electrolytic solution used. For example, the liquid temperature is 5°C to 70°C (preferably 10°C to 60°C), the current density is 0.5 A/dm$^2$ to 60 A/dm$^2$ (preferably 1 A/dm$^2$ to 60 A/dm$^2$), the voltage is 1 V to 100 V (preferably 5 V to 50 V), the electrolysis time is 1 second to 100 seconds (preferably 5 seconds to 60 seconds), and the film amount is 0.1 g/m$^2$ to 5 g/m$^2$ (preferably 0.2 g/m$^2$ to 3 g/m$^2$).

<<Pore widening treatment>>

The pore widening treatment is a treatment of enlarging the diameter of micropores (pore diameter) present in the anodic oxide film formed by the aforementioned anodization treatment step (pore diameter enlarging treatment).
The pore widening treatment can be carried out by bringing the aluminum plate obtained by the aforementioned anodization treatment step into contact with an aqueous acid solution or an aqueous alkali solution. The contact method is not particularly limited, and examples thereof include a dipping method and a spraying method.
As necessary, the support may have a backcoat layer on the side opposite to the image-recording layer, the backcoat layer containing the organic polymer compound described in JP1993-045885A (JP-H5-45885A) or the alkoxy compound of silicon described in JP1994-035174A (JP-H6-35174A).

<Undercoat layer>

The lithographic printing plate precursor according to the present disclosure preferably has an undercoat layer (also called interlayer in some cases) between the image-recording layer and the support. The undercoat layer enhances the adhesiveness between the support and the image-recording layer in an exposed portion, and enables the image-recording layer to be easily peeled from the support in a non-exposed portion. Therefore, the undercoat layer inhibits the deterioration of printing durability and contributes to the improvement of developability. In addition, in the case of exposure to infrared laser, the undercoat layer functions as a heat insulating layer and thus brings about an effect of preventing sensitivity reduction resulting from the diffusion of heat generated by exposure to the support.
Examples of compounds that are used in the undercoat layer include polymers having adsorbent groups that can be adsorbed onto the surface of the support and hydrophilic groups. In order to improve adhesiveness to the image-recording layer, it is preferable that polymers having adsorbent groups and hydrophilic groups further have crosslinkable groups. The compounds that are used in the undercoat layer may be low-molecular-weight compounds or polymers. As

necessary, as the compounds that are used in the undercoat layer, two or more compounds may be used by being mixed together.

In a case where the compound used in the undercoat layer is a polymer, a copolymer of a monomer having an adsorbent group, a monomer having a hydrophilic group, and a monomer having a crosslinkable group is preferable.

As the adsorbent group that can be adsorbed onto the surface of the support, a phenolic hydroxy group, a carboxy group, $-PO_3H_2$, $-OPO_3H_2$, $-CONHSO_2-$, $-SO_2NHSO_2-$, and - $COCH_2COCH_3$ are preferable. As the hydrophilic groups, a sulfo group or salts thereof and salts of a carboxy group are preferable. As the crosslinking groups, an acryl group, a methacryl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or high-molecular-weight compounds having crosslinking groups (preferably ethylenically unsaturated groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinkable groups described in JP2005-125749A and JP2006-188038A are more preferable.

The content of ethylenically unsaturated group in the polymer used in the undercoat layer is preferably 0.1 mmol to 10.0 mmol per gram of the polymer and more preferably 0.2 mmol to 5.5 mmol per gram of the polymer.

The weight-average molecular weight (Mw) of the polymer used in the undercoat layer is preferably 5,000 or more and more preferably 10,000 to 300,000.

In order to prevent contamination with the passage of time, the undercoat layer may contain, in addition to the compounds for the undercoat layer described above, a chelating agent, a secondary or tertiary amine, a polymerization inhibitor, a compound having an amino group or a functional group capable of inhibiting polymerization and a group that interacts with the surface of the support (for example, 1,4-diazabicyclo [2.2.2] octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.

The undercoat layer is formed by known coating methods. The coating amount (solid content) of the undercoat layer is preferably 0.1 mg/$m^2$ to 100 mg/$m^2$ and more preferably 1 mg/$m^2$ to 30 mg/$m^2$.

<Outermost layer>

The lithographic printing plate precursor according to the present disclosure may have an outermost layer (also called "protective layer" or "overcoat layer" in some cases) on a surface of the image-recording layer that is opposite to the support side.

It is preferable that the lithographic printing plate precursor according to the present disclosure have a support, an image-recording layer, and an outermost layer in this order.

The film thickness of the outermost layer is preferably larger than the film thickness of the image-recording layer.

The outermost layer may have a function of suppressing the reaction inhibiting image formation by blocking oxygen, a function of preventing the damage of the image-recording layer, and a function of preventing ablation during exposure to high-illuminance lasers.

The outermost layer having such characteristics is described, for example, in US3458311A and JP1980-49729B (JP-S55-49729B). As polymers with low oxygen permeability that are used in the outermost layer, any of water-soluble polymers and water-insoluble polymers can be appropriately selected. As necessary, two or more kinds of such polymers can be used by being mixed together. From the viewpoint of on-press developability, the polymers with low oxygen permeability preferably include a water-soluble polymer.

In the present disclosure, a water-soluble polymer refers to a polymer that is dissolved in 1 g or more per 100 g of pure water at 70°C and is not precipitated even though a solution in which 1 g of the polymer is dissolved in 100 g of pure water at 70°C is cooled to 25°C.

Examples of the water-soluble polymer used in the outermost layer include polyvinyl alcohol, modified polyvinyl alcohol, polyvinylpyrrolidone, a water-soluble cellulose derivative, polyethylene glycol, poly(meth)acrylonitrile, and the like.

As the modified polyvinyl alcohol, acid-modified polyvinyl alcohol having a carboxy group or a sulfo group is preferably used. Specific examples thereof include the modified polyvinyl alcohols described in JP2005-250216A and

JP2006-259137A.

Among the above water-soluble polymers, a polymer containing polyvinyl alcohol is preferable, and a polymer containing polyvinyl alcohol having a saponification degree of 50% or more is more preferable.

The saponification degree is preferably 60% or more, more preferably 70% or more, and even more preferably 85% or more. The upper limit of the saponification degree is not particularly limited, and may be 100% or less.

The saponification degree is measured according to the method described in JIS K 6726: 1994.

As an aspect of the outermost layer, for example, an aspect in which the outermost layer contains polyvinyl alcohol and polyethylene glycol is also preferable.

In a case where the outermost layer in the present disclosure contains a water-soluble polymer, the content of the water-soluble polymer with respect to the total mass of the outermost layer is preferably 1% by mass to 99% by mass, more preferably 3% by mass to 97% by mass, and even more preferably 5% by mass to 95% by mass.

The outermost layer preferably contains a hydrophobic polymer.

The hydrophobic polymer refers to a polymer that dissolves less than 5 g or does not dissolve in 100 g of pure water at 125°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these resins, and the like.

The hydrophobic polymer preferably includes a polyvinylidene chloride resin.

Furthermore, the hydrophobic polymer preferably includes a styrene-acrylic copolymer (also called styrene acrylic resin).

Moreover, from the viewpoint of on-press developability, the hydrophobic polymer is preferably hydrophobic polymer particles.

Only one hydrophobic polymer may be used, or two or more hydrophobic polymers may be used in combination.

In a case where the outermost layer contains a hydrophobic polymer, the content of the hydrophobic polymer with respect to the total mass of the outermost layer is preferably 1% by mass to 70% by mass, more preferably 5% by mass to 50% by mass, and even more preferably 10% by mass to 40% by mass.

In the present disclosure, the proportion of the area of the hydrophobic polymer occupying the surface of the outermost layer is preferably 30 area% or higher, more preferably 40 area% or higher, and even more preferably 50 area% or higher.

The upper limit of the proportion of the area of the hydrophobic polymer occupying the surface of the outermost layer is, for example, 90 area%.

The proportion of the area of the hydrophobic polymer occupying the surface of the outermost layer can be measured as follows.

By using PHI nano TOFII time-of-flight secondary ion mass spectrometer (TOF-SIMS) manufactured by ULVAC-PHI, INCORPORATED., the surface of the outermost layer is irradiated with Bi ion beams (primary ions) at an acceleration voltage of 30 kV, and the peak of ions (secondary ions) corresponding to a hydrophobic portion (that is, a region formed of the hydrophobic polymer) that are emitted from the surface is measured so that the hydrophobic portion is mapped. By measuring the area of the hydrophobic portion in an area of 100 $\mu m^2$, the proportion of the area occupied by the hydrophobic portion is determined and adopted as "proportion of the area of the hydrophobic polymer occupying the surface of the outermost layer".

For example, in a case where the hydrophobic polymer is an acrylic resin, the proportion is measured using the peak of $C_6H_{13}O^-$. In addition, in a case where the hydrophobic polymer is polyvinylidene chloride, the proportion is measured using the peak of $C_2H_2Cl^+$.

The proportion of occupied area can be adjusted by the additive amount of the hydrophobic polymer or the like.

From the viewpoint of visibility and storage stability, the outermost layer preferably contains an infrared absorber, and more preferably contains a decomposition-type infrared absorber.

As the infrared absorber, for example, those mentioned above regarding the image-recording layer are suitable.

In the outermost layer, one kind of infrared absorber may be used alone, or two or more kinds of infrared absorbers may be used in combination.

From the viewpoint of temporal visibility and storage stability, the content of the infrared absorber in the outermost layer with respect to the total mass of the outermost layer is preferably 0.10% by mass to 50% by mass, more preferably 0.50% by mass to 30% by mass, and even more preferably 1.0% by mass to 20% by mass.

From the viewpoint of improving the visibility of exposed portions, the outermost layer preferably contains a color forming agent.

Suitable examples of the color forming agent include the color forming substance precursor mentioned regarding the image-recording layer.

In the outermost layer, one kind of color forming agent may be used alone, or two or more kinds of color forming agents may be used in combination.

From the viewpoint of color formability, the content of the color forming agent in the outermost layer with respect to the total mass of the outermost layer is preferably 0.10% by mass to 50% by mass, more preferably 0.50% by mass to 30% by mass, and even more preferably 1.0% by mass to 20% by mass.

In order to improve oxygen barrier properties, the outermost layer may contain an inorganic lamellar compound. The inorganic lamellar compound refers to particles in the form of a thin flat plate, and examples thereof include mica groups such as natural mica and synthetic mica, talc represented by Formula $3MgO\cdot 4SiO\cdot H_2O$, taeniolite, montmorillonite, saponite, hectorite, zirconium phosphate, and the like.

As the inorganic lamellar compound, a mica compound is preferably used. Examples of the mica compound include mica groups such as natural mica and synthetic mica, which are represented by Formula: $A(B, C)_{2-5}D_4O_{10}(OH, F, O)_2$ [here, A represents any of K, Na, and Ca, B and C represent any of Fe (II), Fe (III), Mn, Al, Mg, and V, and D represents Si or Al.].

In the mica group, examples of the natural mica include muscovite, soda mica, phlogopite, biotite, and lepidolite. Examples of synthetic mica include non-swelling mica such as fluorine phlogopite $KMg_3(AlSi_3O_{10})F_2$, potassium tetrasilic mica $KMg_{2.5}(Si_4O_{10})F_2$, and, Na tetrasilylic mica $NaMg_{2.5}(Si_4O_{10})F_2$, swelling mica such as Na or Li taeniolite $(Na, Li)Mg_2Li(Si_4O_{10})F_2$, montmorillonite-based Na or Li hectorite $(Na, Li)_{1/8}Mg_{2/5}Li_{1/8}(Si_4O_{10})F_2$. Furthermore, synthetic smectite is also useful.

Among the mica compounds, fluorine-based swelling mica is particularly useful. That is, swelling synthetic mica has a laminated structure consisting of unit crystal lattice layers having a thickness in a range of about 10Å to 15Å (1Å is equal to 0.1 nm), and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are adsorbed between the layers in order to compensate for the deficiency. Positive ions interposed between the layers are referred to as exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where shear is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired. As a result, the aspect ratio is preferably 20 or more, more preferably 100 or more, and particularly preferably 200 or more. The aspect ratio is the ratio of the major diameter to the thickness of a particle, and it can be measured, for example, from a projection view obtained from the microphotograph of the particle. As the aspect ratio increases, the obtained effect is stronger.

Regarding the particle diameter of the mica compound, the average major diameter thereof is preferably 0.3 μm to 20 μm, more preferably 0.5 μm to 10 μm, and particularly preferably 1 μm to 5 μm. The average thickness of the particles is preferably 0.1 μm or less, more preferably 0.05 μm or less, and particularly preferably 0.01 μm or less. Specifically, for example, as a preferable aspect of swelling synthetic mica which is a representative compound, the thickness thereof is in a range of about 1 nm to 50 nm and the surface size (major diameter) is in a range of about 1 μm to 20 μm.

The content of the inorganic lamellar compound with respect to the total mass of the outermost layer is preferably 1% by mass to 60% by mass, and more preferably 3% by mass to 50% by mass. Even in a case where two or more inorganic lamellar compounds are used in combination, the total amount of the inorganic lamellar compounds preferable equals the content described above. In a case where the content is within the above range, the oxygen barrier property is improved, and excellent sensitivity is obtained. In addition, the deterioration of receptivity can be prevented.

The outermost layer may contain known additives such as a plasticizer for imparting flexibility, a surfactant for improving coating properties, and inorganic particles for controlling surface sliding properties. In addition, the oil sensitizing agent described above regarding the image-recording layer may be incorporated into the outermost layer.

The outermost layer is formed by known coating methods. The coating amount of the outermost layer (solid content) is preferably 0.01 g/$m^2$ to 10 g/$m^2$, more preferably 0.02 g/$m^2$ to 3 g/$m^2$, and particularly preferably 0.02 g/$m^2$ to 1 g/$m^2$.

The film thickness of the outermost layer in the lithographic printing plate precursor according to the present disclosure is preferably 0.1 μm to 5.0 μm, and more preferably 0.3 μm to 4.0 μm.

The film thickness of the outermost layer in the lithographic printing plate precursor according to the present disclosure/film thickness of the image-recording layer is preferably 1.1/1 to 5.0/1, and more preferably 1.5/1 to 3.0/1.

The lithographic printing plate precursor according to the present disclosure may have other layers in addition to those mentioned above.

Known layers can be adopted as those other layers without particular limitations. For example, as necessary, a backcoat layer may be provided on a surface of the support that is opposite to the image-recording layer side.

(Method of preparing lithographic printing plate and lithographic printing method)

It is possible to prepare a lithographic printing plate by performing image exposure and a development treatment on the lithographic printing plate precursor according to the present disclosure.
The method of preparing a lithographic printing plate according to the present disclosure preferably includes a step of exposing the on-press development type lithographic printing plate precursor according to the present disclosure in the shape of an image (hereinafter, this step will be also called "exposure step") and a step of removing the image-recording layer in a non-image area by supplying at least one material selected from the group consisting of a printing ink and dampening water on a printer (hereinafter, this step will be also called "on-press development step").
The lithographic printing method according to the present disclosure preferably includes a step of exposing the on-press development type lithographic printing plate precursor according to the present disclosure in the shape of an image (exposure step), a step of removing the image-recording layer in a non-image area on a printer by supplying at least one material selected from the group consisting of a printing ink and dampening water such that a lithographic printing plate is prepared (on-press development step), and a step of performing printing by using the obtained lithographic printing plate (printing step).
In addition, the method of preparing a lithographic printing plate according to the present disclosure or the lithographic printing method according to the present disclosure preferably further includes a step (identification step) of identifying the exposed lithographic printing plate precursor by a sensor.
Hereinafter, regarding the method of preparing a lithographic printing plate according to the present disclosure and the lithographic printing method according to the present disclosure, preferred aspects of each step will be described in order. Note that the lithographic printing plate precursor according to the present disclosure can also be developed using a developer.
Hereinafter, the exposure step, the on-press development step, and the identification step in the method of preparing a lithographic printing plate will be described. The exposure step in the method of preparing a lithographic printing plate according to the present disclosure is the same step as the exposure step in the lithographic printing method according to the present disclosure. In addition, the on-press development step in the method of preparing a lithographic printing plate according to the present disclosure is the same step as the on-press development step in the lithographic printing method according to the present disclosure. Furthermore, the identification step in the method of preparing a lithographic printing plate according to the present disclosure is the same step as the identification step in the lithographic printing method according to the present disclosure.

<Exposure step>

The method of preparing a lithographic printing plate according to the present disclosure preferably includes an exposure step of exposing the lithographic printing plate precursor according to the present disclosure in the shape of an image such that an exposed portion and a non-exposed portion are formed. The lithographic printing plate precursor according to the present disclosure is preferably exposed to a laser through a transparent original picture having a linear image, a halftone dot image, or the like or exposed in the shape of an image by laser light scanning according to digital data, or the like.
The wavelength of a light source to be used is preferably 750 nm to 1,400 nm. As the light source having a wavelength of 750 nm to 1,400 nm, a solid-state laser or a semiconductor laser that radiates infrared rays is suitable. In a case where an infrared laser is used, the output is preferably 100 mW or higher, the exposure time per pixel is preferably 20 microseconds or less, and the amount of irradiation energy is preferably 10 mJ/cm$^2$ to 300 mJ/cm$^2$. In addition, in order to shorten the exposure time, a multibeam laser device is preferably used. The exposure mechanism may be any of an inner surface drum method, an external surface drum method, a flat head method, or the like.
The image exposure can be carried out by a common method using a platesetter or the like. In the case of on-press development, image exposure may be carried out on a printer after the lithographic printing plate precursor is mounted on the printer.
In addition, the setting of each parameter such as SD (focal depth), Slop (the linear slope of a laser), and Curve (the arrangement curvature of a laser) at the time of exposure may be performed separately. In the parameter setting, development may be performed using an ink and dampening water described later, exposure in an image form may be performed for parameter setting, or development may be performed using a liquid other than the ink and the dampening water.
The liquid other than the ink and the dampening water may be a liquid that enables on-press development, but an aqueous liquid is preferably used, and examples thereof include an aqueous developer, an aqueous finisher liquid, an aqueous finisher gum liquid, and the like.
In addition, in a case where development is performed using a liquid other than the ink and the dampening water, after the development, the plate surface may be washed with water or the like, or in order to further improve the

visibility of the image area, an acidic aqueous solution may be brought into contact with the plate surface.

The acid included in the acidic aqueous solution is not particularly limited, but examples thereof suitably include a carboxylic acid such as acetic acid, a hydroxycarboxylic acid such as citric acid, and a salt thereof.

In addition, a method of performing the development, washing, and bringing the acidic aqueous solution into contact with a plate surface is not particularly limited, and a known method can be used. Examples thereof suitably include a method of coating a plate surface with a sponge, a waste cloth, or the like.

<On-press development step>

The method of preparing a lithographic printing plate according to the present disclosure preferably includes an on-press development step of removing the image-recording layer in a non-image area by supplying at least one selected from the group consisting of printing ink and dampening water on a printer.

Hereinafter, the on-press development method will be described.

[On-press development method]

In the on-press development method, the lithographic printing plate precursor having undergone image exposure is preferably supplied with an oil-based ink and an aqueous component on a printer such that the image-recording layer in a non-image area is removed and a lithographic printing plate is prepared.

That is, in a case where the lithographic printing plate precursor is subjected to image exposure and then mounted as it is on a printer without being subjected to any development treatment, or the lithographic printing plate precursor is mounted on a printer and then subjected to image exposure on the printer, and then an oil-based ink and an aqueous component are supplied to perform printing, at the initial stage in the middle of printing, in a non-image area, by either or both of the supplied oil-based ink and the aqueous component, a non-cured image-recording layer is dissolved or dispersed to remove, and the hydrophilic surface is exposed in the non-image area. Meanwhile, the image-recording layer cured by exposure forms an oil-based ink-receiving areas having a lipophilic surface in the exposed portion. What is supplied first to the precursor surface may be any of the oil-based ink or the aqueous component. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.

identification step>

The method of preparing a lithographic printing plate according to the present disclosure preferably further includes a step (identification step) of identifying the exposed lithographic printing plate precursor by a sensor.

The sensor preferably includes a unit that performs detection by irradiating the lithographic printing plate precursor with at least light in a wavelength range of 580 nm or more and 750 nm or less, and more preferably includes a unit that reads the bar code in the lithographic printing plate precursor exposed by irradiation with at least light in a wavelength range of 580 nm or more and 750 nm or less.

In addition, the sensor is not particularly limited, and a known sensor can be used. Among these, a known barcode reader can be suitably used.

In addition, in the exposure step, it is preferable that at least a part of the lithographic printing plate precursor is exposed in a bar code shape.

In addition, the method of preparing a lithographic printing plate according to the present disclosure or the lithographic printing method according to the present disclosure preferably further includes a step (bender step) of bending the exposed lithographic printing plate precursor.

In the bender step, a known bender device can be used.

Furthermore, it is preferable that the identification step is performed immediately before or immediately after the bender step, or during the bender step.

<Printing step>

The lithographic printing method according to the present disclosure includes a printing step of printing a recording medium by supplying a printing ink to the lithographic printing plate.

The printing ink is not particularly limited, and various known inks can be used as desired. In addition, preferred examples of the printing ink include oil-based ink or ultraviolet-curable ink (UV ink).

In the printing step, as necessary, dampening water may be supplied.

Furthermore, the printing step may be successively carried out after the on-press development step without stopping the printer.

The recording medium is not particularly limited, and a known recording medium can be used as desired.

In the method of preparing a lithographic printing plate from the lithographic printing plate precursor according to the present disclosure and in the lithographic printing method according to the present disclosure, as necessary, the entire surface of the lithographic printing plate precursor may be heated before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

Examples

Hereinafter, the present disclosure will be described in detail with reference to examples, but the present disclosure is not limited thereto. In the present examples, unless otherwise specified, "%" and "part" mean "% by mass" and "part by mass" respectively. Unless otherwise described, the molecular weight of a high-molecular-weight compound is a weight-average molecular weight (Mw), and the ratio of repeating constitutional units of a polymer compound is expressed as molar percentage. In addition, the weight-average molecular weight (Mw) is a polystyrene-equivalent molecular weight measured by gel permeation chromatography (GPC).

(Examples 1 to 15 and Comparative Examples 1 to 16)

<Preparation of support>

<<Surface treatment A>>

(A-a) Mechanical roughening treatment (brush graining method)

By using the device shown in Fig. 5, a pumice suspension (specific gravity: 1.1 g/cm$^3$) as an abrasive slurry was supplied to the surface of an aluminum plate, and in this state, a mechanical roughening treatment was performed using a rotating bundled brush. In Fig. 5, 1 represents an aluminum plate, 2 and 4 represent roller-shaped brushes (bundled brushes in the present example), 3 represents an abrasive slurry, and 5, 6, 7, and 8 represent support rollers.

In the mechanical roughening treatment, an abrasive having a median diameter (μm) of 30 μm and 4 brushes were used, and the rotation speed (rpm) of the brushes was set to 250 rpm. The bundled brush was made of 6·10 nylon and consisted of bristles having a diameter of 0.3 mm and a length of 50 mm. The brush was prepared by making holes in a φ 300 mm stainless steel cylinder and densely implanting bristles therein. The distance between two support rollers (φ 200 mm) under the bundled brush was 300 mm. The bundled brush was pressed until the load of the drive motor for rotating the brush was 10 kW higher than the load applied before the bundled brush was pressed on the aluminum plate. The rotation direction of the brush was the same as the moving direction of the aluminum plate.

(A-b) Alkali etching treatment

An aqueous solution of caustic soda having a caustic soda concentration of 26% by mass and an aluminum ion concentration of 6.5% by mass was sprayed from a spray tube onto the aluminum plate obtained above at a temperature of 70°C, thereby performing an etching treatment. Then, water washing was performed by means of spraying. The amount of dissolved aluminum was 10 g/m$^2$.

(A-c) Desmutting treatment in acidic aqueous solution

Next, a desmutting treatment was performed in an aqueous nitric acid solution. As the aqueous nitric acid solution used in the desmutting treatment, the waste liquid of nitric acid used in the next step, electrochemical roughening, was used. The liquid temperature was 35°C. The desmutting treatment was performed for 3 seconds by spraying the desmutting liquid.

(A-d) Electrochemical roughening treatment

An electrochemical roughening treatment was continuously performed using nitric acid as an electrolyte at an alternating current voltage of 60 Hz. In this treatment, an electrolytic solution was used which was prepared by adding aluminum nitrate to 10.4 g/L aqueous nitric acid solution at a temperature of 35°C such that the aluminum ion concentration was adjusted to 4.5 g/L. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used. The current density was 30 $A/dm^2$ in terms of the peak value of current, and 5% of the current coming from the power source was allowed to flow into the auxiliary anode. The electricity quantity ($C/dm^2$) was 185 $C/dm^2$, which is the total quantity of electricity used during the anodic reaction of the aluminum plate. Then, water washing was performed by means of spraying.

(A-e) Alkali etching treatment

An aqueous solution of caustic soda having a caustic soda concentration of 5% by mass and an aluminum ion concentration of 0.5% by mass was sprayed from a spray tube onto the aluminum plate obtained above at a temperature of 50°C, thereby performing an etching treatment. Then, water washing was performed by means of spraying. The amount of dissolved aluminum was 0.5 $g/m^2$.

(A-f) Desmutting treatment in acidic aqueous solution

Next, a desmutting treatment was performed in an aqueous sulfuric acid solution. In the desmutting treatment, a sulfuric acid aqueous solution having a sulfuric acid concentration of 170 g/L and an aluminum ion concentration of 5 g/L was used. The liquid temperature was 30°C. The desmutting treatment was performed for 3 seconds by spraying the desmutting liquid.

(A-g) Electrochemical roughening treatment

An electrochemical roughening treatment was continuously performed using using an AC voltage of 60 Hz in hydrochloric acid electrolysis. An electrolytic solution was used which was prepared by adding aluminum chloride to 6.2 g/L aqueous hydrochloric acid solution at a liquid temperature of 35°C such that the aluminum ion concentration was adjusted to 4.5 g/L. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used.

The current density was 25 $A/dm^2$ in terms of the peak value of current, and the quantity of electricity ($C/dm^2$) during the hydrochloric acid electrolysis was 63 $C/dm^2$ which is the total quantity of electricity used during the anodic reaction of the aluminum plate. Then, water washing was performed by means of spraying.

(A-h) Alkali etching treatment

An aqueous solution of caustic soda having a caustic soda concentration of 5% by mass and an aluminum ion concentration of 0.5% by mass was sprayed from a spray tube onto the aluminum plate obtained above at a temperature of 50°C, thereby performing an etching treatment. Then, water washing was performed by means of spraying. The amount of dissolved aluminum was 0.1 $g/m^2$.

(A-i) Desmutting treatment in acidic aqueous solution

Next, a desmutting treatment was performed in an aqueous sulfuric acid solution. Specifically, by using a waste liquid generated in the anodization treatment step (170 g/L aqueous sulfuric acid solution containing dissolved aluminum ions at 5 g/L), the desmutting treatment was performed for 4 seconds at a liquid temperature of 35°C. The desmutting treatment was performed for 3 seconds by spraying the desmutting liquid.

(A-j) First-stage anodization treatment

By using the anodization treatment device for direct current electrolysis having the structure shown in Fig. 6, a first-stage anodization treatment was performed. The anodization treatment was performed under the conditions shown in Table 1, thereby forming an anodic oxide film having a predetermined film thickness. In the anodization treatment device 610, an aluminum plate 616 is transported as indicated by the arrow in Fig. 6. In a power supply tank 612 storing an electrolytic solution 618, the aluminum plate 616 is positively (+) charged by a power supply electrode 620. Further, the aluminum plate 616 is transported upward by a roller 622 in the power supply tank 612, redirected downward by a nip roller 624, transported toward an electrolytic treatment tank 614 in which an electrolytic solution 626 is stored, and redirected to the horizontal direction by a roller 628. Subsequently, the aluminum plate 616 is negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodization treatment device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the rollers 622, 624, and 628. The power supply electrode 620 and the electrolysis electrode 630 are connected to a direct current power source 634.

(A-k) Pore widening treatment

Under the conditions shown in Table 1, the aluminum plate having undergone the above anodization treatment was immersed in an aqueous solution of caustic soda at a temperature of 35°C and having a caustic soda concentration of 5% by mass and an aluminum ion concentration of 0.5% by mass, thereby performing a pore widening treatment. Then, water washing was performed by means of spraying.

(A-1) Second-stage anodization treatment

By using the anodization treatment device for direct current electrolysis having the structure shown in Fig. 6, a second-stage anodization treatment was performed. The anodization treatment was performed under the conditions shown in Table 1, thereby forming an anodic oxide film having a predetermined film thickness.

(A-m) Third-stage anodization treatment

By using the anodization treatment device for direct current electrolysis having the structure shown in Fig. 6, a third-stage anodization treatment was performed. The anodization treatment was performed under the conditions shown in Table 1, thereby forming an anodic oxide film having a predetermined film thickness.

By the above surface treatment A, the supports A shown in Tables 1 and 2 were obtained.

Table 2 shows the average diameter (nm) of the large diameter portion in the anodic oxide film within the surface of the anodic oxide film having micropores obtained after the second anodization treatment step, the average diameter (nm) of the small diameter portion at a communicate position, the depth (nm) of the large diameter portion and the small diameter portion, the pit density (micropore density, unit; number of micropores/$\mu m^2$), and the thickness (nm) of the anodic oxide film from the bottom portion of the small diameter portion to the surface of the aluminum plate.

The average diameter of the micropores (average diameter of the large diameter portion and the small diameter portion) is a value obtained by observing the surface of the large diameter portion and the surface of the small diameter portion with FE-SEM at 150,000X magnification (N= 4), and measuring the diameters of micropores (large diameter portion and small diameter portion) in a range of 400 nm $\times$ 600 nm in the obtained 4 images, and averaging the diameters. In a case where the large diameter portion was deep and it was difficult to measure the diameter of the small diameter portion, and in a case where an enlarged diameter portion in the small diameter portion was measured, the upper portion of the anodic oxide film was cut, and then various diameters were calculated.

The depth of the micropores (depth of the large diameter portion and the small diameter portion) is a value obtained by observing the cross section of the support (anodic oxide film) with FE-SEM (observation of the depth of the large diameter portion: 150,000X magnification, observation of depth of small diameter portion: 50,000$\times$ magnification), measuring the depths of 25 random micropores in the obtained image, and averaging the diameters.

In Table 1, film amount (AD) in the column of the first anodization treatment and film amount (AD) in the column of second anodization treatment represent the amount of film obtained by each treatment. As electrolytic solutions, the aqueous solutions containing the components in Table 1 were used.

[Table 1]

| Support | Surface treatment | First anodization treatment | | | | | | | Pore widening treatment | | | Second anodization treatment | | | | | | |
|---|---|---|---|---|---|---|---|---|---|---|---|---|---|---|---|---|---|---|
| | | Liquid type | Liquid component | Component concentration | Temperate | Current density | Time | Film amount | Liquid component | Temperature | Time | Liquid type | Liquid component | Component concentration | Temperature | Current density | Time | Film amount |
| Support A | A | Sulfuric acid | $H_2SO_4$/Al | 170/5 | 40 | 30 | 1.6 | 0.25 | NaOH 5%/Al 0.5% | 35 | 5 | Sulfuric acid | $H_2SO_4$/Al | 170/5 | 50 | 13 | 17 | 2.25 |

[Table 2]

| Support | Large diameter portion | | | | Small diameter portion | | | Thickness of anodic oxide film (nm) |
|---|---|---|---|---|---|---|---|---|
| | Average diameter (nm) | Shape | Micropore density (number of micropores/μm²) | Depth (nm) | Diameter of pore at comunicate position (nm) | Shape | Depth (nm) | |
| Support A | 35 | Straight tubular | 500 | 100 | 10 | Straight tubular | 900 | 1,000 |

By using the support A, an undercoat layer, an image-recording layer, and, as necessary, a protective layer were formed according to any one of Formulations 1 to 3 shown in Table 3.

Formulations 1 to 3 are as below.

-Formulation 1~

<Formation of undercoat Layer>

The obtained support A was coated with the undercoat layer coating liquid having the following composition such that the dry coating amount was 0.1 g/m², to form an undercoat layer.

-Undercoat layer coating liquid-

- Compound for undercoat layer (the following U-1, 11% aqueous solution): 0.10502 parts
- Sodium gluconate: 0.0700 parts
- Surfactant (EMALEX (registered trademark) 710, manufactured by NIHON EMULSION Co., Ltd.): 0.00159 parts
- Preservative (BIOHOPE L, manufactured by K·I Chemical Industry Co., LTD.): 0.00149 parts
- Water: 2.8719 parts

(U - 1)

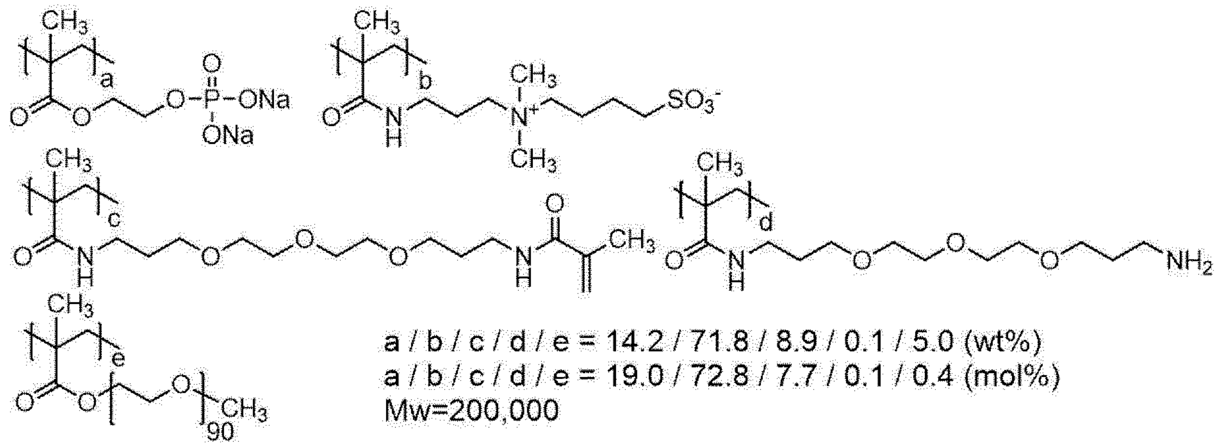

a / b / c / d / e = 14.2 / 71.8 / 8.9 / 0.1 / 5.0 (wt%)
a / b / c / d / e = 19.0 / 72.8 / 7.7 / 0.1 / 0.4 (mol%)
Mw=200,000

<Formation of image-recording layer>

The undercoat layer was bar-coated with the following image-recording layer coating liquid 1 and dried in the oven at 50°C for 60 seconds, thereby forming an image-recording layer having a dried coating amount of 0.9 g/m² and thus preparing a lithographic printing plate precursor.

-Image-recording layer coating liquid 1-

Polymer dispersion: 0.675 parts
Hydroxypropyl methylcellulose: 0.400 parts
Monomer 1: 0.036 parts
Monomer 2: 0.115 parts
Monomer 3: 0.087 parts
Infrared absorber 1: 0.028 parts
Surfactant 1: 0.045 parts
Iodonium salt 1: 0.073 parts
Iodonium salt 2: 0.053 parts
Color forming substance precursor 1: addition of compound at amount shown in Table 3
Color forming substance precursor 2: addition of compound at amount shown in Table 3
Phenothiazine: 0.005 parts
1-Propanol: 2.6 parts
2-Butanone: 3.5 parts
1-Methoxy-2-propanol: 0.92 parts
δ-butyrolactone; 0.10 parts
Water: 1.16 parts

Polymer dispersion: a polymer dispersion was prepared according to Example 10 of EP1,765,593A, and used as a 23.5% by mass dispersion containing n-propanol/water at a mass ratio of 80:20.

Hydroxypropyl methylcellulose: 5% aqueous solution with 30% of methoxylated part and 10% of hydroxypropoxylated part. The viscosity of the 2% by mass aqueous solution is 5 mPa·s at 20°C.

Monomer 1: the following compound

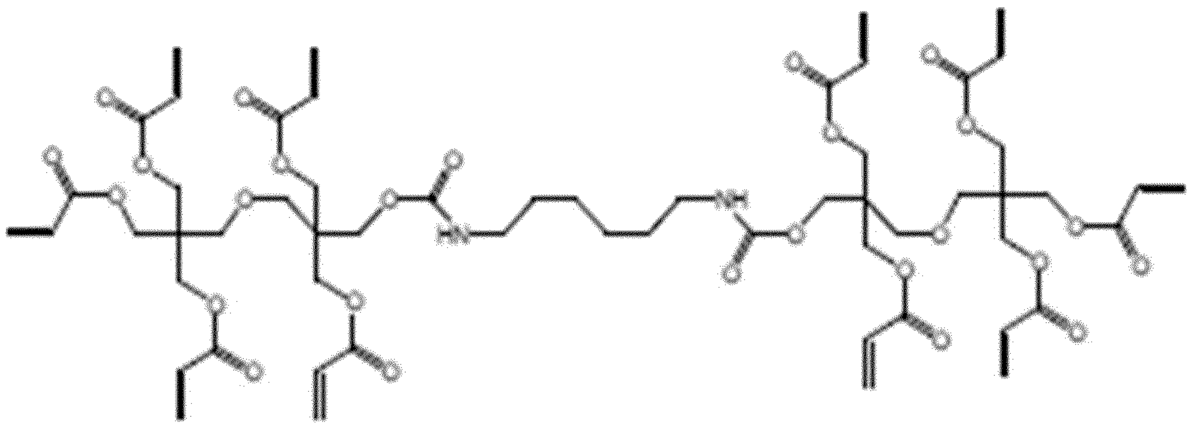

Monomer 2: the following compound

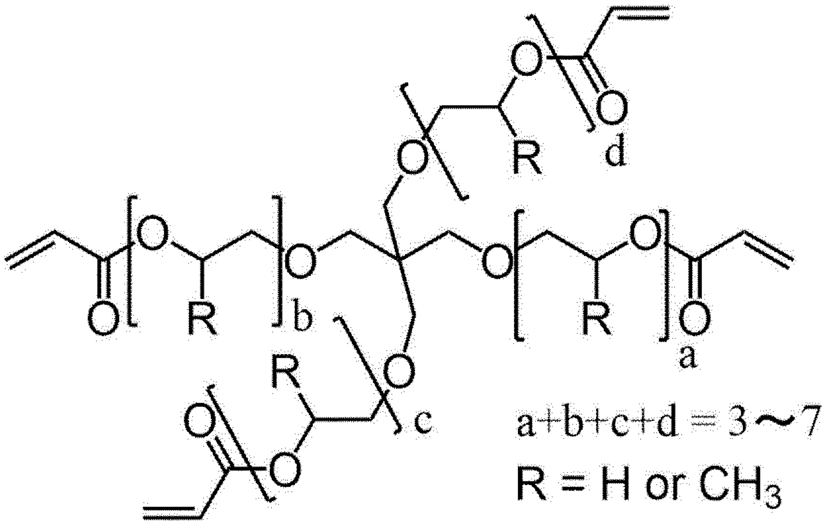

Monomer 3: the following compound

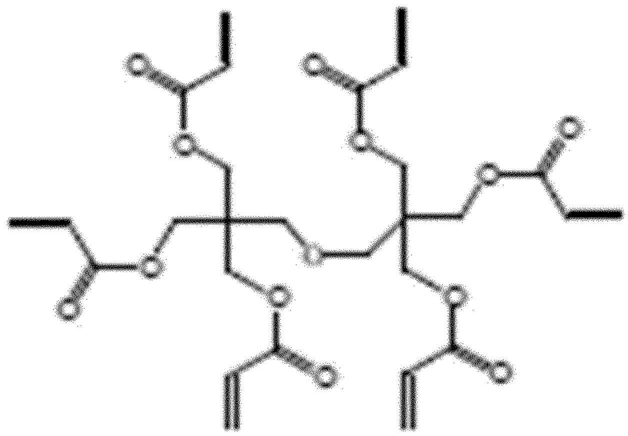

Infrared absorber 1: the following compound

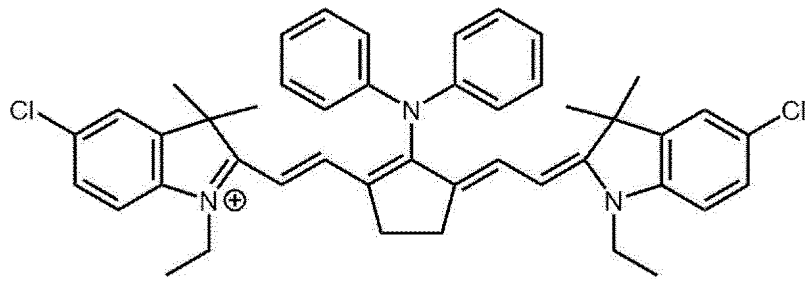

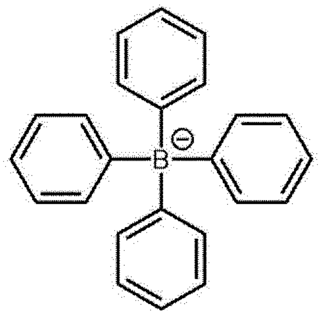

Surfactant 1: BYK302 manufactured by BYK-Chemie GmbH was used as a 25% by mass solution of 1-methoxy-2-propanol.

Iodonium salt 1: the following compound

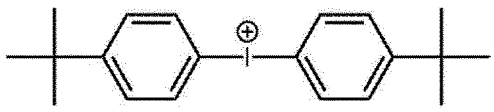

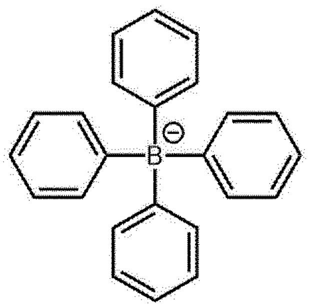

Iodonium salt 2: the following compound

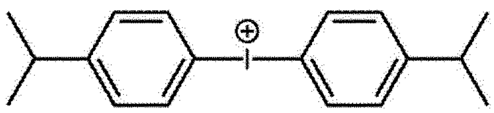

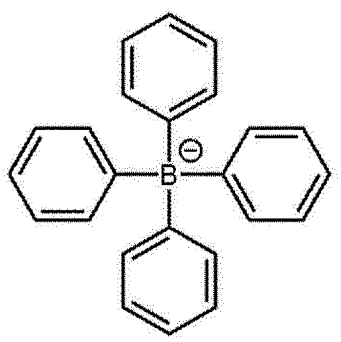

Phenothiazine: the following compound

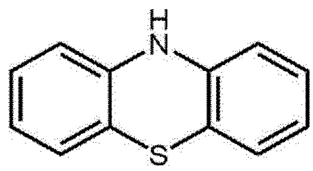

-Formulation 2~

<Formation of undercoat Layer>

The obtained support A was coated with the undercoat layer coating liquid such that the dry coating amount was 0.1 g/m$^2$, to form an undercoat layer.

<Formation of image-recording layer>

The undercoat layer was bar-coated with the following image-recording layer coating liquid 2 and dried in the oven at 120°C for 40 seconds, thereby forming an image-recording layer having a dried coating amount of 1.0 g/m$^2$ and thus preparing a lithographic printing plate precursor.

-Image-recording layer coating liquid 2-

Infrared absorber (IR-2): 0.0400 parts
Color forming substance precursor 1: addition of compound at amount shown in Table 3
Color forming substance precursor 2: addition of compound at amount shown in Table 3
Electron-accepting polymerization initiator (Int-1): 0.1090 parts
Electron-donating polymerization initiator (TPB): 0.0250 parts
Polymerizable compound (the following M-4): 0.4714 parts
Anionic surfactant (A-1): 0.0400 parts
Fluorine-based surfactant (W-1): 0.0042 parts
2-Butanone: 4.3551 parts
1-Methoxy-2-propanol: 3.9260 parts
Methanol: 2.6947 parts
Polymer particles R: 2.3256 parts

IR-2: the following compound

IR-2

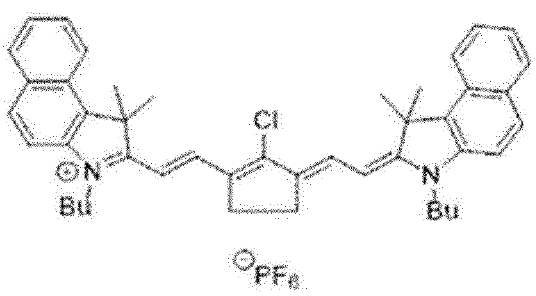

Int-1: the following compound, HOMO energy level of -6.70 eV, LUMO energy level of -3.08 eV

Int-1

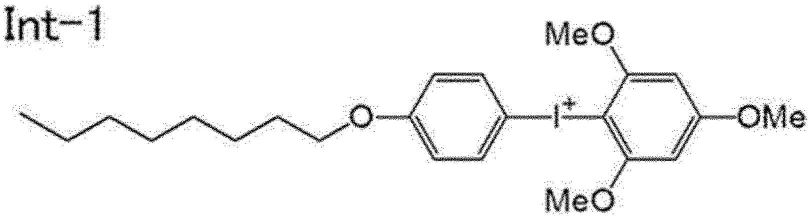

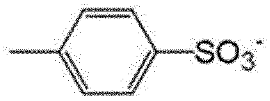

TPB: the following compound

TPB

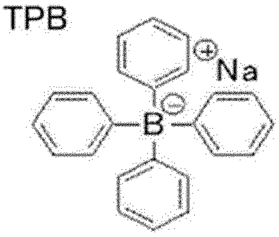

A-1: the following compound

A-1

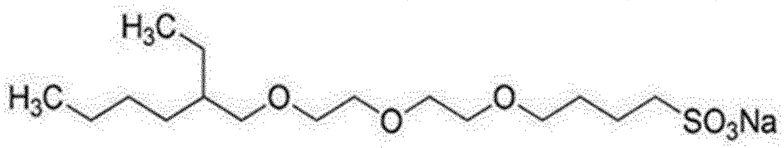

W-1: the following compound

W-1

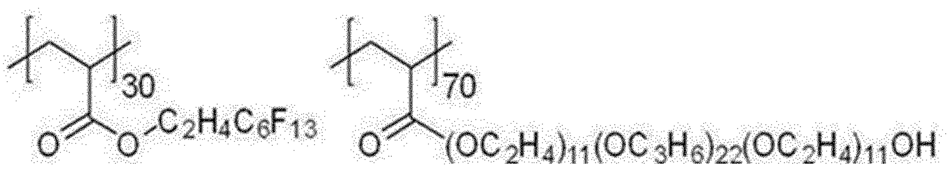

W - 1
Mw = 13,000

<Synthesis method of polymerizable compound (M-4)>

A mixed solution of TAKENATE D-160N (polyisocyanate trimethylolpropane adduct, manufactured by Mitsui Chemicals, Inc., 4.7 parts), ARONIX M-403 (manufactured by TOAGOSEI CO., LTD., amount yielding the ratio of NCO value of TAKENATE D-160N:hydroxyl number of ARONIX M-403 = 1:1), t-butylbenzoquinone (0.02 parts), and methyl ethyl ketone (11.5 parts) was heated at 65°C. NEOSTAN U-600 (bismuth-based polycondensation catalyst, manufactured

by NITTO KASEI CO., LTD., 0.11 parts) was added to the reaction solution, and the reaction solution was heated at 65°C for 4 hours. The reaction solution was cooled to room temperature (25°C), and methyl ethyl ketone was added thereto, thereby synthesizing a urethane acrylate (M-4) solution having a solid content of 50% by mass.

<Preparation of polymer particles R>

-Preparation of oil-phase component-

WANNATE (registered trademark) PM-200 (polyfunctional isocyanate compound: manufactured by Wanhua Chemical Group Co., Ltd.): 6.66 g, a 50% by mass ethyl acetate solution of TAKENATE (registered trademark) D-116N (adduct of trimethylolpropane (TMP), m-xylylene diisocyanate (XDI), and polyethylene glycol monomethyl ether (EO90) (following structure)" manufactured by Mitsui Chemicals, Inc.: 5.46 g, a 65% by mass ethyl acetate solution of SR399 (dipentaerythritol pentaacrylate, manufactured by Sartomer Company Inc.): 11.24 g, ethyl acetate: 14.47 g, and PIONIN (registered trademark) A-41-C (manufactured by TAKEMOTO OIL & FAT Co., Ltd.): 0.45 g mixed together and stirred at room temperature (25°C) for 15 minutes, thereby obtaining an oil-phase component.

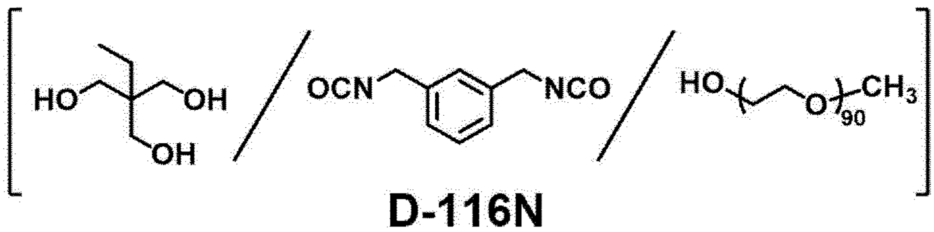

D-116N

-Preparation of water-phase component-

As a water-phase component, 47.2 g of distilled water was prepared.

-Microcapsule forming step-

The oil-phase component and the water-phase component were mixed together, and the obtained mixture was emulsified at 12,000 rpm for 16 minutes by using a homogenizer, thereby obtaining an emulsion.

Distilled water (16.8 g) was added to the obtained emulsion, and the obtained liquid was stirred at room temperature for 180 minutes.

After stirring, the liquid was heated at 45°C, and stirred for 5 hours in a state of being kept at 45°C such that ethyl acetate was distilled off from the liquid. Distilled water was added thereto such that the concentration of solid contents was adjusted to 20% by mass, thereby obtaining an aqueous dispersion liquid of polymer particles R. R had a volume average particle diameter of 165 nm that was measured using a laser diffraction/scattering-type particle diameter distribution analyzer LA-920 (manufactured by HORIBA, Ltd.).

<Formation of protective layer>

The image-recording layer was bar-coated with the following protective layer coating liquid 1 and dried in an oven at 120°C for 60 seconds, thereby forming a protective layer having a dry coating amount of 0.05 g/$m^2$. In this way, a lithographic printing plate precursor was prepared.

-Protective layer coating liquid 1-

- Inorganic lamellar compound dispersion (1) (described below): 0.5625 parts
- Hydrophilic polymer (1) (20% aqueous solution of the following compound): 0.0825 parts
- METOLOSE SM04 (methyl cellulose, manufactured by Shin-Etsu Chemical Co., Ltd., methoxy substitution degree = 1.8): 0.0125 parts
- RAPISOL A-80 (anionic surfactant, manufactured by NOF CORPORATION, 80% aqueous solution): 0.007 parts
- Deionized water: 4.3355 parts

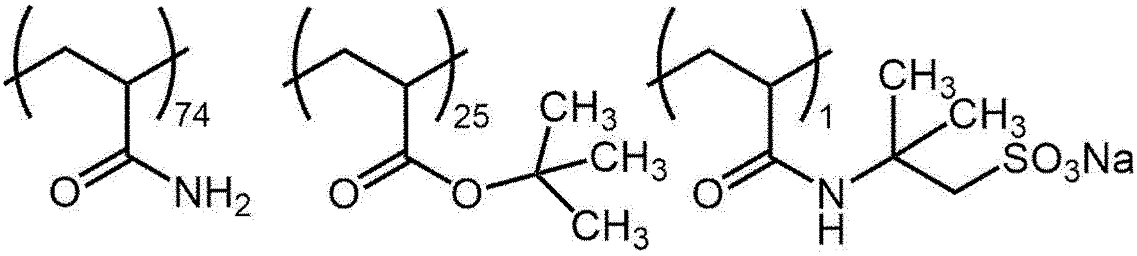

Hydrophilic polymer (1)

The method for preparing an inorganic lamellar compound dispersion (1) used in the protective layer coating liquid will be described below.

-Preparation of inorganic lamellar compound dispersion (1)-

Synthetic mica (SOMASIF ME-100 manufactured by Co-op Chemical Co., Ltd., 6.4 parts) was added to deionized water (193.6 parts) and was dispersed using a homogenizer until the average particle diameter (the laser scattering method) reached 3 μm. The aspect ratio of the obtained dispersed particles was 100 or more.

-Formulation 3~

<Formation of undercoat Layer>

The obtained support A was coated with the undercoat layer coating liquid such that the dry coating amount was 0.1 g/$m^2$, to form an undercoat layer.

<Formation of image-recording layer>

The undercoat layer was bar-coated with the following image-recording layer coating liquid 3, followed by drying in an oven at 120°C for 40 seconds, thereby forming an image-recording layer having a dry coating amount of 1.0 g/$m^2$.

-Image-recording layer coating liquid 3-

Infrared absorber (IR-1): 0.0120 parts
Infrared absorber (IR-2 described above): 0.0250 parts
Color forming substance precursor 1: addition of compound at amount shown in Table 3
Color forming substance precursor 2: addition of compound at amount shown in Table 3
Electron-accepting polymerization initiator (Int-1 described above): 0.1090 parts Electron-donating polymerization initiator (TPB described above): 0.0250 parts Polymerizable compound (M-4 described above): 0.4714 parts
Anionic surfactant (A-1 described above): 0.0400 parts
Fluorine-based surfactant (W-1 described above): 0.0042 parts
2-Butanone: 4.3551 parts
1-Methoxy-2-propanol: 3.6383 parts
Methanol: 2.6947 parts
Polymer particles R described above: 2.6163 parts

IR-1: the following compound

IR-1

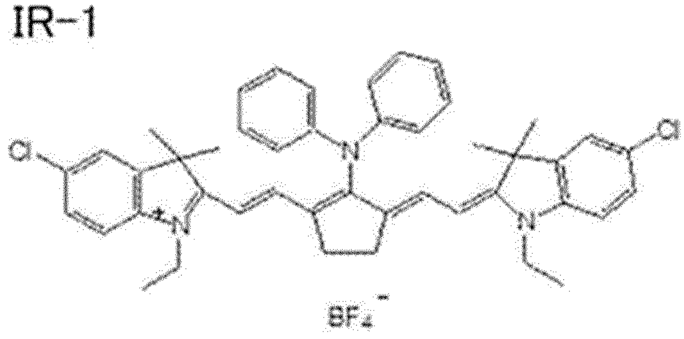

<Formation of protective layer>

The image-recording layer was bar-coated with the following protective layer coating liquid 2 and dried in an oven at 120°C for 60 seconds, thereby forming a protective layer having a dry coating amount of 0.05 g/m$^2$. In this way, a lithographic printing plate precursor was prepared.

-Protective layer coating liquid 2-

- Inorganic lamellar compound dispersion (1): 0.5625 parts
- Hydrophilic polymer (1) (20% aqueous solution of the compound described above): 0.0825 parts
- METOLOSE SM04 (methyl cellulose, manufactured by Shin-Etsu Chemical Co., Ltd., methoxy substitution degree = 1.8): 0.0250 parts
- RAPISOL A-80 (anionic surfactant, manufactured by NOF CORPORATION, 80% aqueous solution): 0.0007 parts
- Deionized water: 4.3300 parts

<Evaluation of lithographic printing plate precursor>

[Evaluation of ink turbidity suppressiveness]

By using Magnus 800 Quantum manufactured by Eastman Kodak Company that was equipped with an infrared semiconductor laser, the obtained lithographic printing plate precursor was exposed under the conditions of output of 27 W, an outer drum rotation speed of 450 rpm, and a resolution of 2,400 dpi (dots per inch, 1 inch is equal to 2.54 cm) (irradiation energy equivalent to 110 mJ/cm$^2$). The exposed image includes a solid image.

The obtained exposed precursor was mounted on a Kikuban-sized (636 mm × 939 mm) cylinder of a printer SX-74 manufactured by Heidelberger Druckmaschinen AG without being developed. This printer was connected to a 100 L-capacity dampening water circulation tank having a non-woven fabric filter and a temperature control device. A circulation device was filled with 80 L of dampening water containing 2.0% by mass of dampening water S-Z1 (manufactured by FUJIFILM Corporation), and an ultraviolet-curable ink (UV ink) T&K medium ink was used as printing ink. The dampening water and ink were supplied by a standard automatic printing start method, and then printing was performed 300 sheets of TOKUBISHI art paper (ream weight: 76.5 kg, manufactured by MITSUBISHI PAPER MILLS LIMITED.) at a printing rate of 10,000 sheets/hour. The ink turbidity suppressiveness was evaluated from the color difference ΔE between the ink color of the solid portion of the paper surface before the start of the printing and the ink color of the solid portion after the printing was repeated on 10 plates. The smaller the value of ΔE is, the less the turbidity is and the better the ink turbidity suppressiveness is.

[Evaluation of visibility]

Image exposure was performed on the obtained lithographic printing plate precursor under the same conditions as in the evaluation of the ink turbidity suppressiveness, such that the characters "Fuji" having a size of 3 to 14 points form exposed portions. Under a white light of 800 lux, the exposed lithographic printing plate precursor was placed perpendicular to the floor. An experimenter stood at a distance of 1 m from the just exposed precursor and evaluated the points of the smallest characters that could be read accurately by both eyes. The evaluation was performed within 30 minutes after the exposure of the lithographic printing plate precursor. The average values given by 10 experimenters were calculated, and the visibility was evaluated based on the following standard. A or B is preferable.

A: 3 points or more and less than 5 points
B: 5 points or more and less than 6 points
C: 6 points or more and less than 7 points
D: 7 points or more and less than 9 points
E: 9 points or more and less than 11 points
F: 11 points or more

<Sensor readability>

By using Trendsetter Q800 manufactured by Eastman Kodak Company that was equipped with an infrared semiconductor laser, the obtained lithographic printing plate precursor was exposed under the conditions of output of 14 W, an outer drum rotation speed of 360 rpm, and a resolution of 2,400 dpi (dots per inch, 1 inch is equal to 2.54 cm) (irradiation energy equivalent to 110 $mJ/cm^2$). A data matrix code was included in the exposed image. The data matrix code was read using an SR-1000W sensor manufactured by KEYENCE CORPORATION and evaluation was performed in which 100% of reading ratio is defined as OK, and the other is NG.

[Table 3]

| | Formulation | Color forming substance precursor 1 | | Color forming substance precursor 2 | | λmax1 (nm) | Change in absorbance at λmax1 | λmax2 (nm) | Change in absorbance at λmax2 | Visibility | Sensor readability | Ink turbidity suppressiveness |
|---|---|---|---|---|---|---|---|---|---|---|---|---|
| | | Type | Additive amount (part bv mass) | Type | Additive amount (part bv mass) | | | | | | | |
| Example 1 | 1 | CS-1 | 0.020 | CL-1 | 0.065 | 570 | 0.20 | 590 | 0.15 | A | OK | 7 |
| Example 2 | 1 | CS-1 | 0.010 | CL-1 | 0.065 | 570 | 0.10 | 590 | 0.15 | A | OK | 9 |
| Example 3 | 1 | CS-1 | 0.020 | CL-1 | 0.033 | 570 | 0.20 | 590 | 0.08 | A | OK | 8 |
| Example 4 | 1 | CS-1 | 0.010 | CL-1 | 0.033 | 570 | 0.10 | 590 | 0.08 | A | OK | 9 |
| Example 5 | 1 | CS-2 | 0.033 | CL-1 | 0.065 | 575 | 0.20 | 590 | 0.15 | A | OK | 6 |
| Example 6 | 1 | CS-3 | 0.021 | CL-1 | 0.065 | 570 | 0.20 | 590 | 0.15 | A | OK | 7 |
| Example 7 | 1 | CS-1 | 0.020 | CL-3 | 0.040 | 570 | 0.20 | 620 | 0.15 | A | OK | 7 |
| Example 8 | 1 | CS-1 | 0.020 | CL-4 | 0.040 | 570 | 0.20 | 590 | 0.12 | A | OK | 7 |
| Example 9 | 1 | CS-2 | 0.033 | CL-4 | 0.040 | 575 | 0.20 | 590 | 0.12 | A | OK | 6 |
| Example 10 | 1 | CS-3 | 0.021 | CL-4 | 0.040 | 570 | 0.20 | 590 | 0.12 | A | OK | 7 |
| Example 11 | 1 | CS-1 | 0.020 | CL-7 | 0.052 | 570 | 0.20 | 670 | 0.10 | A | OK | 7 |
| Example 12 | 2 | CS-1 | 0.020 | CL-1 | 0.065 | 570 | 0.15 | 590 | 0.12 | A | OK | 7 |
| Example 13 | 2 | CS-1 | 0.020 | CL-4 | 0.040 | 570 | 0.15 | 590 | 0.10 | A | OK | 7 |
| Example 14 | 3 | CS-1 | 0.020 | CL-1 | 0.065 | 570 | 0.15 | 590 | 0.12 | A | OK | 7 |
| Example 15 | 3 | CS-1 | 0.020 | CL-4 | 0.040 | 570 | 0.15 | 590 | 0.10 | A | OK | 7 |
| Comparative Example 1 | 1 | CS-1 | 0.020 | - | - | 570 | 0.20 | - | - | A | NG | 7 |
| Comparative Example 2 | 1 | CL-2 | 0.043 | - | - | 450 | 0.08 | 590 | 0.05 | D | NG | 10 |
| Comparative Example 3 | 1 | CS-1 | 0.020 | CL-2 | 0.043 | 570 | 0.20 | 590 | 0.05 | A | NG | 7 |

(continued)

| | Formulation | Color forming substance precursor 1 | | Color forming substance precursor 2 | | λmax1 (nm) | Change in absorbance at λmax1 | λmax2 (nm) | Change in absorbance at λmax2 | Visibility | Sensor readability | Ink turbidity suppressiveness |
|---|---|---|---|---|---|---|---|---|---|---|---|---|
| | | Type | Additive amount (part bv mass) | Type | Additive amount (part bv mass) | | | | | | | |
| Comparative Example 4 | 1 | CS-2 | 0.033 | CL-2 | 0.043 | 575 | 0.20 | 590 | 0.05 | A | NG | 6 |
| Comparative Example 5 | 1 | CS-4 | 0.042 | CL-1 | 0.065 | 530 | 0.05 | 590 | 0.15 | C | OK | 9 |
| Comparative Example 6 | 1 | CL-5 | 0.021 | CL-6 | 0.020 | 450 | 0.08 | 590 | 0.05 | D | NG | 10 |
| Comparative Example 7 | 1 | CL-4 | 0.020 | - | - | - | - | 590 | 0.06 | D | OK | 9 |
| Comparative Example 8 | 1 | CL-4 | 0.040 | - | - | - | - | 590 | 0.12 | C | OK | 8 |
| Comparative Example 9 | 1 | CL-4 | 0.060 | - | - | - | - | 590 | 0.18 | C | OK | 7 |
| Comparative Example 10 | 1 | CS-1 | 0.020 | CL-4 | 0.020 | 570 | 0.10 | 590 | 0.06 | A | NG | 7 |
| Comparative Example 11 | 1 | CS-2 | 0.033 | CL-4 | 0.020 | 575 | 0.10 | 590 | 0.06 | A | NG | 6 |
| Comparative Example 12 | 1 | CS-3 | 0.021 | CL-4 | 0.020 | 570 | 0.10 | 590 | 0.06 | A | NG | 7 |
| Comparative Example 13 | 1 | CS-4 | 0.042 | CL-4 | 0.040 | 530 | 0.05 | 590 | 0.12 | C | OK | 8 |
| Comparative Example 14 | 1 | CL-5 | 0.042 | CL-4 | 0.040 | 450 | 0.08 | 590 | 0.12 | C | OK | 8 |
| Comparative Example 15 | 1 | CL-6 | 0.042 | CL-4 | 0.040 | 450 | 0.08 | 590 | 0.12 | C | OK | 8 |

(continued)

| | Formulation | Color forming substance precursor 1 | | Color forming substance precursor 2 | | $\lambda$max1 (nm) | Change in absorbance at $\lambda$max1 | $\lambda$max2 (nm) | Change in absorbance at $\lambda$max2 | Visibility | Sensor readability | Ink turbidity suppressiveness |
|---|---|---|---|---|---|---|---|---|---|---|---|---|
| | | Type | Additive amount (part bv mass) | Type | Additive amount (part bv mass) | | | | | | | |
| Comparative Example 16 | 1 | CL-7 | 0.052 | - | - | - | - | 670 | 0.10 | C | OK | 8 |

λmax1 in Table 3 represents a maximal absorption wavelength in a wavelength range of 380 nm or more and less than 580 nm in the color forming substance generated from the color forming substance precursor 1, and λmax2 represents a maximal absorption wavelength in a wavelength range of 580 nm or more and 750 nm or less in the color forming substance generated from the color forming substance precursor 1 or the color forming substance precursor 2.

In addition, the absorbance of the color forming substance precursor and the color forming substance generated from the color forming substance precursor was measured by the aforementioned method.

Details of abbreviations described in Table 3 are shown below.

<Color forming substance precursor>

CS-1 to CS-4: the following compounds
CL-1 to CL-7: the following compounds

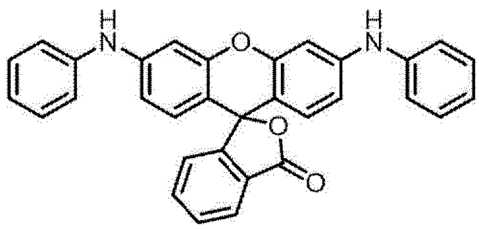

CS - 1

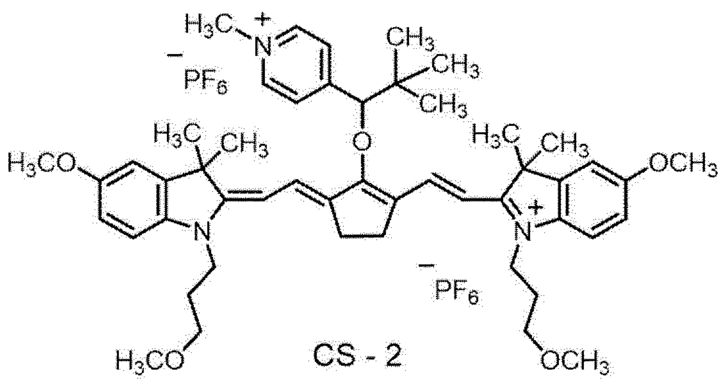

CS - 2

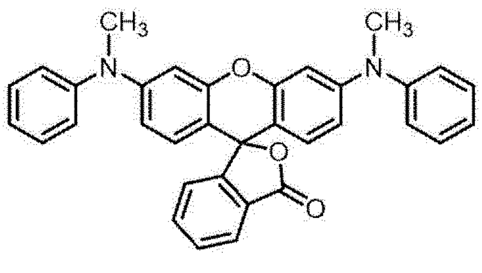

CS - 3

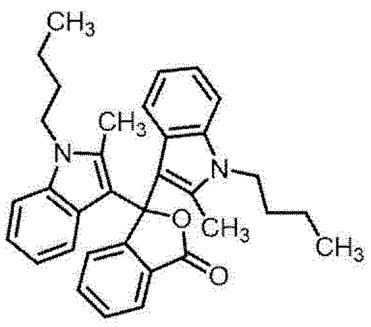

CS - 4

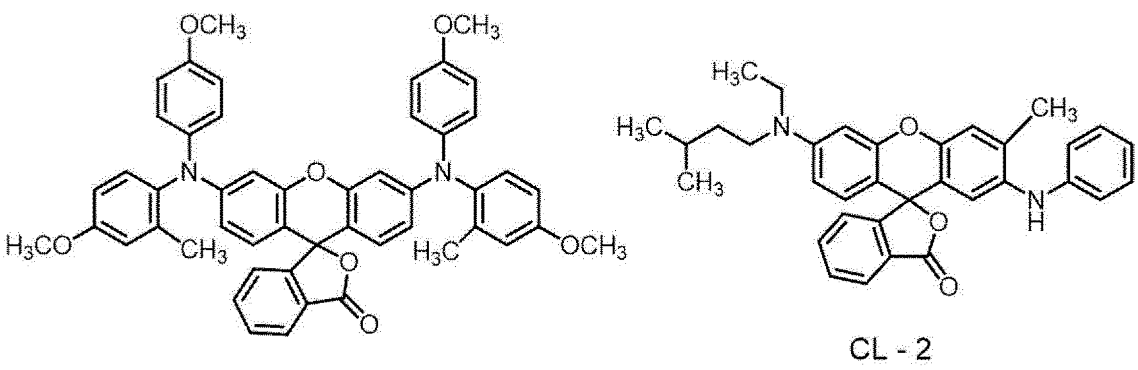

CL - 2

CL - 1

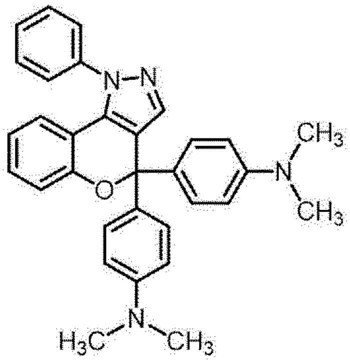

CL - 3

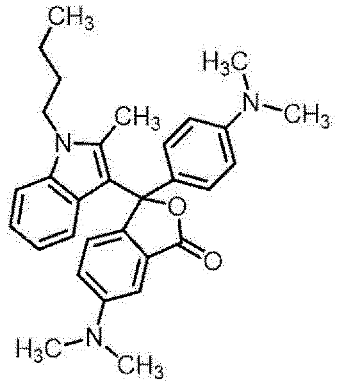

CL - 4

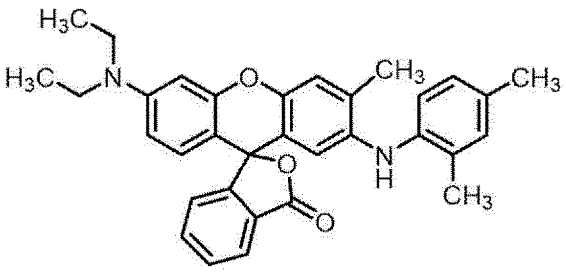

CL - 5

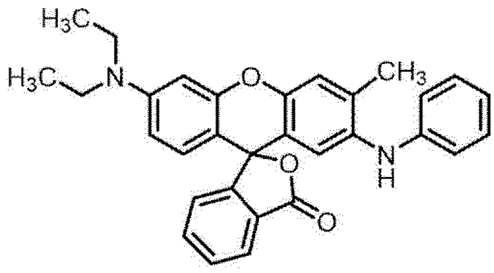

CL - 6

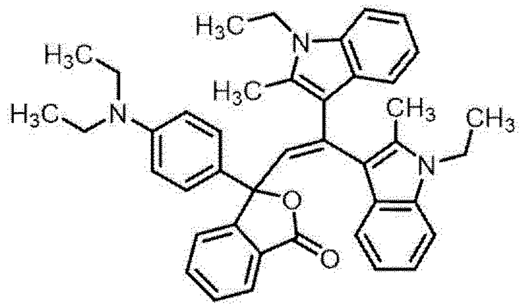

CL - 7

In addition, the maximal absorption wavelengths (λmax) and ε's of the used color forming substance precursors CS-1 to CS-4 and CL-1 to CL-7 were measured by the aforementioned method. The measurement results are shown in Table 4 below.

[Table 4]

| Color forming substance precursor | λmax (nm) | ε | Ring-opening rate |
|---|---|---|---|
| CS-1 | 570 | 64,000 | 94% |
| CS-2 | 575 | 100,000 | 0% |
| CS-3 | 570 | 94,000 | 85% |
| CS-4 | 530 | 30,000 | 68% |
| CL-1 | 590 | 68,000 | 75% |
| CL-2 | 450/590 | 32,000/20,000 | 76% |
| CL-3 | 620 | 43,000 | 70% |

(continued)

| Color forming substance precursor | λmax (nm) | ε | Ring-opening rate |
|---|---|---|---|
| CL-4 | 590 | 74,000 | 58% |
| CL-5 | 450/590 | 32,000/20,000 | 76% |
| CL-6 | 450/590 | 32,000/20,000 | 76% |
| CL-7 | 670 | 22,000 | 80% |

From the results shown in Table 3, it is found that compared to the lithographic printing plate precursors according to comparative examples, the lithographic printing plate precursors according to examples are better in visibility and sensor readability.

In addition, it is found that the lithographic printing plate precursor according to Examples has excellent ink turbidity suppressiveness.

(Examples 16 to 30)

A lithographic printing plate precursor was prepared and evaluated in the same manner as in Examples 1 to 15 except that in the evaluation of ink turbidity suppressiveness, the evaluation of visibility, and the evaluation of sensor readability, exposure development in a case of setting each of parameters such as SD value, Slope value, and Curve value were performed under the following conditions.

The lithographic printing plate precursor was exposed in a predetermined image form and lightly rubbed with a sponge (manufactured by 3M Company) impregnated with PS finishing gum FN-6 (manufactured by FUJIFILM Corporation) for development, next, a surface of the plate was washed with a waste cloth containing water, then a 10% aqueous solution of citric acid was impregnated into a sponge (manufactured by 3M Company) and uniformly spread over the plate surface, and the color of the image area was formed.

The evaluation results of ink turbidity suppressiveness, visibility, and sensor readability in Examples 16 to 30 are the same as the evaluation results of ink turbidity suppressiveness, visibility, and sensor readability in corresponding Examples 1 to 15.

The disclosure of JP2021-141516A filed on August 31, 2021 and the disclosure of JP2022-031973A filed on March 2, 2022 are incorporated in the present specification by reference.

All documents, patent applications, and technical standards described in the present specification are herein incorporated by reference to the same extent that individual documents, patent applications, and technical standards have been specifically and individually indicated to be incorporated by reference, respectively.

Explanation of References

1: aluminum plate
2 and 4: roller-shaped brush
3: abrasive slurry
5, 6, 7, and 8: support roller
12a, 12b: aluminum support
14: undercoat layer
16: image-recording layer
18: aluminum plate
20a, 20b: anodic oxide film
22a, 22b: micropore
24: large diameter portion
26: small diameter portion
D: depth of large diameter portion
50: main electrolytic cell
52: radial drum roller
51: alternating current power source
53a and 53b: main pole
55: electrolytic solution

54: electrolytic solution supply port
56: slit
57: electrolytic solution channel
60: auxiliary anode cell
58: auxiliary anode
Ex: electrolytic solution outlet
S: liquid supply
W: aluminum plate
610: anodization treatment device
612: power supply tank
614: electrolytic treatment tank
616: aluminum plate
618, 626: electrolytic solution
620: power supply electrode
622, 628: roller
624: nip roller
630: electrolysis electrode
632: tank wall
634: direct current power source
ta: anodic reaction time
tc: cathodic reaction time
tp: time taken for current to reach peak from 0
Ia: peak current on anodic cycle side
Ic: peak current on cathodic cycle side
AA: current of anodic reaction of aluminum plate
CA: current of cathodic reaction of aluminum plate

## Claims

**1.** An on-press development type lithographic printing plate precursor, comprising:

a support; and
an image-recording layer on the support,
wherein the image-recording layer contains a polymerizable compound, a polymerization initiator, an infrared absorber, and a color forming substance precursor, and
a color forming substance generated from the color forming substance precursor has

a maximal absorption wavelength in a wavelength range of 380 nm or more and less than 580 nm, at which an absorbance difference with respect to the color forming substance precursor is 0.1 or more, and
a maximal absorption wavelength in a wavelength range of 580 nm or more and 750 nm or less, at which an absorbance difference with respect to the color forming substance precursor is 0.07 or more.

**2.** The on-press development type lithographic printing plate precursor according to claim 1, wherein a molar absorption coefficient $\varepsilon$ at any one of the maximal absorption wavelengths in the color forming substance is 35,000 or more.

**3.** The on-press development type lithographic printing plate precursor according to claim 1 or 2, wherein the color forming substance precursor is a leuco colorant.

**4.** The on-press development type lithographic printing plate precursor according to any one of claims 1 to 3, wherein the color forming substance precursor is an acid color forming agent.

**5.** The on-press development type lithographic printing plate precursor according to any one of claims 1 to 4, wherein the color forming substance precursor includes two or more kinds of color forming substance precursors.

**6.** The on-press development type lithographic printing plate precursor according to claim 5, wherein the color forming substance precursor includes two kinds of color forming substance precursors.

7. The on-press development type lithographic printing plate precursor according to any one of claims 1 to 6, wherein in the color forming substance, the maximal absorption wavelength in the wavelength range of 380 nm or more and less than 580 nm, at which the absorbance difference with respect to the color forming substance precursor is 0.1 or more is a maximal absorption wavelength in a wavelength range of 500 nm or more and less than 580 nm, at which an absorbance difference with respect to the color forming substance precursor is 0.1 or more.

8. The on-press development type lithographic printing plate precursor according to any one of claims 1 to 7, wherein in the color forming substance, the maximal absorption wavelength in the wavelength range of 580 nm or more and 750 nm or less, at which the absorbance difference with respect to the color forming substance precursor is 0.07 or more is a maximal absorption wavelength in a wavelength range of 580 nm or more and 660 nm or less, at which an absorbance difference with respect to the color forming substance precursor is 0.07 or more.

9. The on-press development type lithographic printing plate precursor according to any one of claims 1 to 8,

wherein a ring-opening rate of the color forming substance precursor, which is determined by the following expression, is 40 mol% to 99 mol%,
the ring-opening rate = a molar absorption coefficient of the color forming substance precursor to which 1 molar equivalent of acid is added/a molar absorption coefficient $\varepsilon$ of the color forming substance generated from the color forming substance precursor $\times$ 100.

10. A method of preparing a lithographic printing plate, comprising:

a step of exposing the on-press development type lithographic printing plate precursor according to any one of claims 1 to 9 in a shape of an image; and
a step of supplying at least one selected from the group consisting of a printing ink and dampening water on a printer to remove an image-recording layer in a non-image area.

11. The method of preparing a lithographic printing plate according to claim 10, further comprising:
a step of identifying the exposed lithographic printing plate precursor by a sensor.

12. A lithographic printing method comprising:

a step of exposing the on-press development type lithographic printing plate precursor according to any one of claims 1 to 9 in a shape of an image;
a step of supplying at least one selected from the group consisting of a printing ink and dampening water on a printer to remove an image-recording layer in a non-image area and to prepare a lithographic printing plate; and
a step of performing printing by using the obtained lithographic printing plate.

13. The lithographic printing method according to claim 12, further comprising:
a step of identifying the exposed lithographic printing plate precursor by a sensor.

FIG. 1

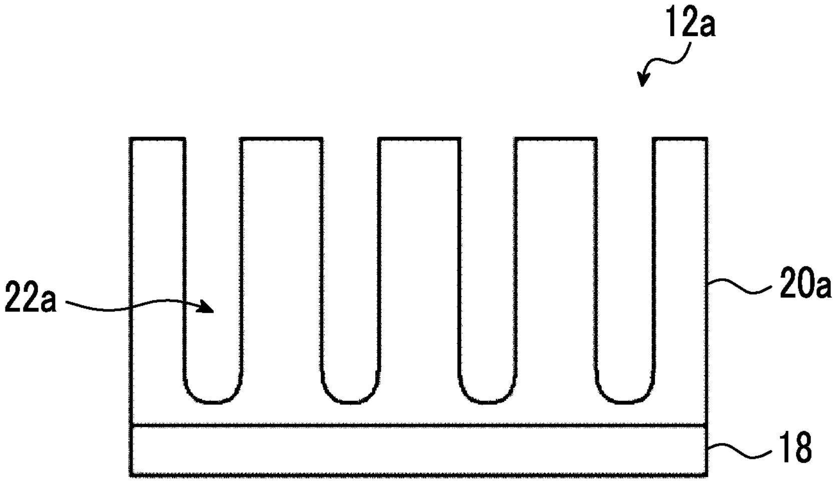


FIG. 2

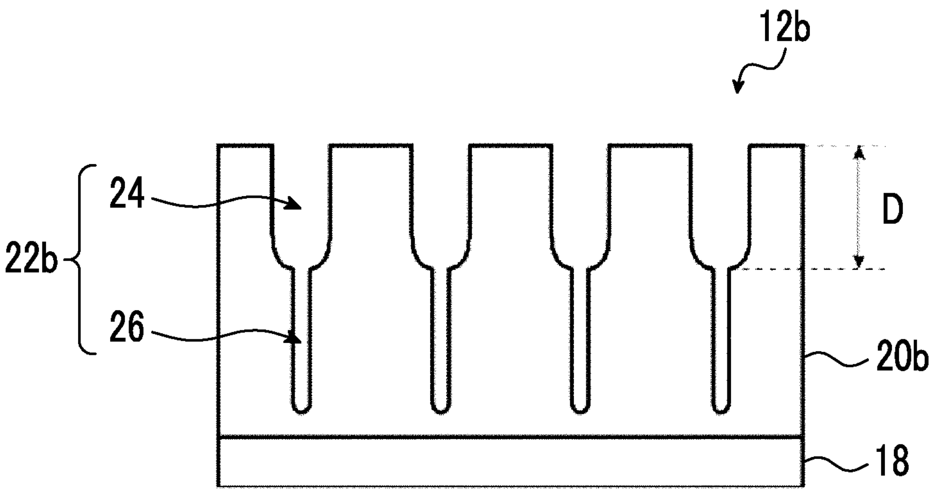

FIG. 3

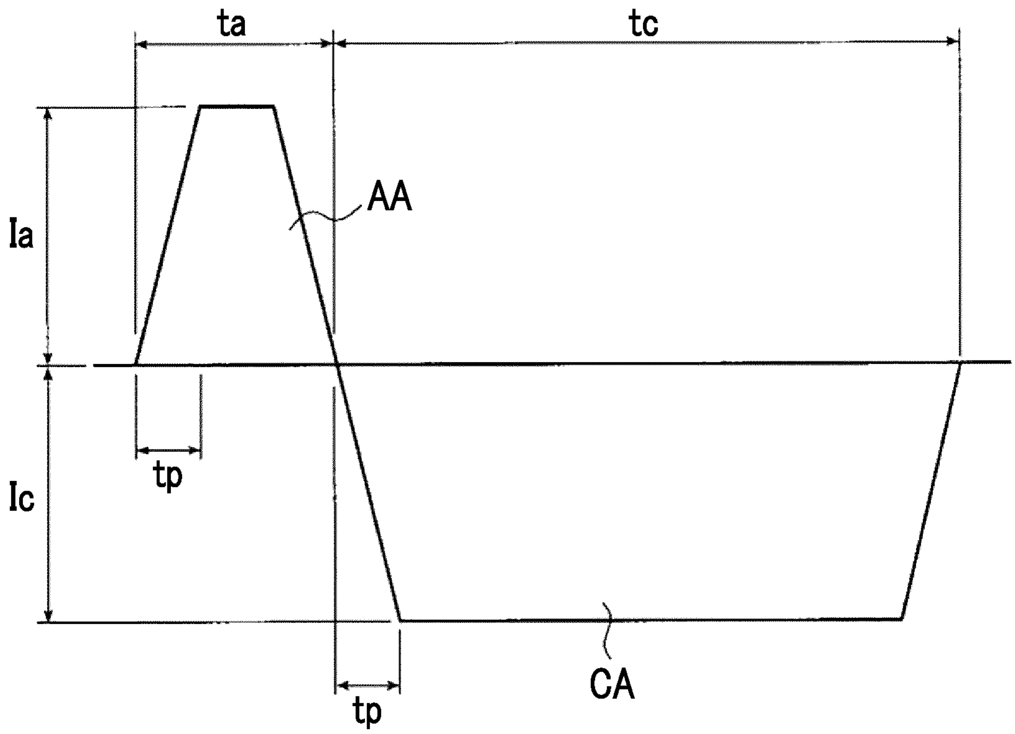


FIG. 4

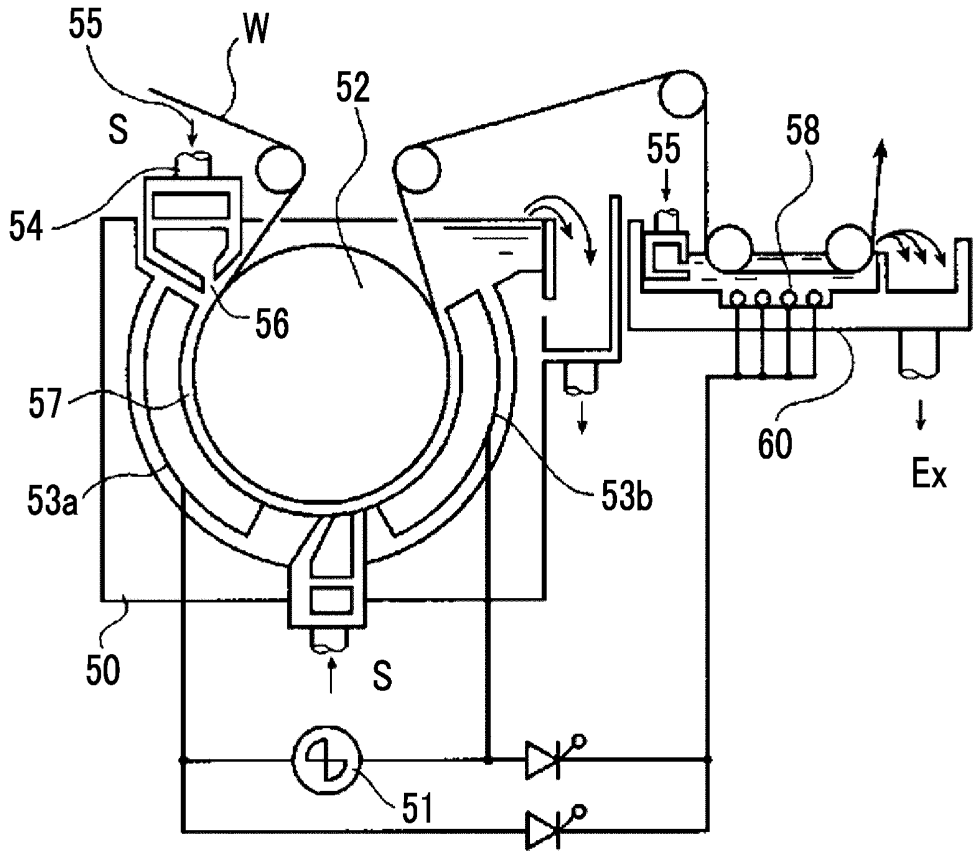

FIG. 5

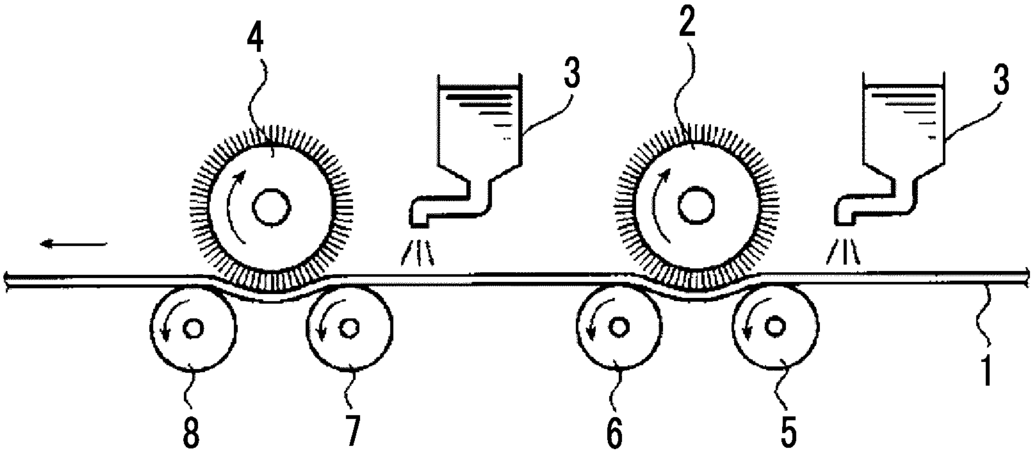


FIG. 6

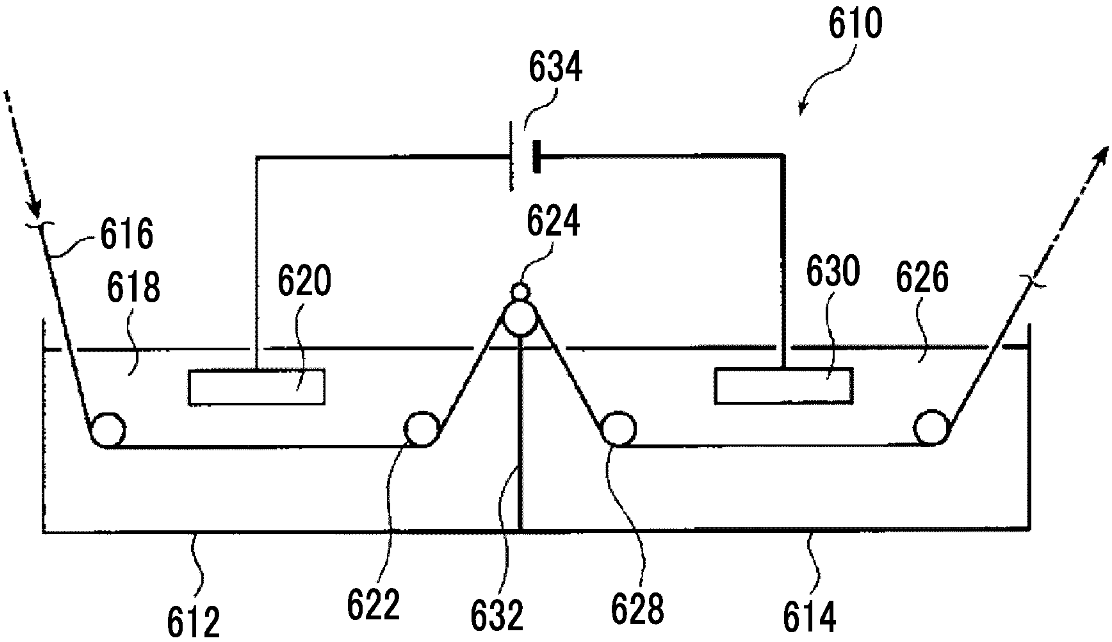

**INTERNATIONAL SEARCH REPORT**

International application No. **PCT/JP2022/031121**

**A. CLASSIFICATION OF SUBJECT MATTER**

***B41N 1/14***(2006.01)i; ***B41C 1/10***(2006.01)i; ***B41M 1/06***(2006.01)i; ***G03F 7/00***(2006.01)i; ***G03F 7/004***(2006.01)i; ***G03F 7/027***(2006.01)i

FI: B41N1/14; B41C1/10; B41M1/06; G03F7/004 505; G03F7/00 503; G03F7/004 507; G03F7/027

According to International Patent Classification (IPC) or to both national classification and IPC

**B. FIELDS SEARCHED**

Minimum documentation searched (classification system followed by classification symbols)

B41N1/00-3/08; B41C1/00-3/08; B41M1/00-3/18; G03F7/00; G03F7/004; G03F7/027

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2020/262692 A1 (FUJIFILM CORPORATION) 30 December 2020 (2020-12-30)<br>paragraphs [0012], [0041]-[0050], [0533], [0544]-[0551], [0638]-[0649] | 1-7, 9-10, 12<br>8, 11, 13 |
| A | WO 2021/132665 A1 (FUJIFILM CORPORATION) 01 July 2021 (2021-07-01)<br>entire text, all drawings | 1-13 |
| A | WO 2019/004471 A1 (FUJIFILM CORPORATION) 03 January 2019 (2019-01-03)<br>entire text, all drawings | 1-13 |
| A | WO 2019/243036 A1 (AGFA NV) 26 December 2019 (2019-12-26)<br>entire text, all drawings | 1-13 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **25 October 2022** | **08 November 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/031121**

| Patent document cited in search report | Publication date (day/month/year) | Patent family member(s) | Publication date (day/month/year) |
|---|---|---|---|
| WO 2020/262692 A1 | 30 December 2020 | US 2022/0111629 A1<br>paragraphs [0013]-[0024], [0125]-[0142], [1139], [1155]-[1181], [1376]-[1398]<br>EP 3991986 A1<br>CN 114051598 A | |
| WO 2021/132665 A1 | 01 July 2021 | (Family: none) | |
| WO 2019/004471 A1 | 03 January 2019 | US 2020/0117086 A1<br>entire text, all drawings<br>EP 3647069 A1<br>CN 110809521 A | |
| WO 2019/243036 A1 | 26 December 2019 | US 2021/0362485 A1<br>entire text, all drawings<br>EP 3587113 A1<br>CN 112334312 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2016027886 A
- WO 2020262692 A
- JP 2008544322 A
- WO 2019219560 A
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- WO 2019013268 A
- JP 8108621 A
- JP H8108621 A
- JP 61166544 A
- JP 2002328465 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2008503365 A
- JP 2012148555 A
- JP 2006297907 A
- JP 2007050660 A
- JP 2008284858 A
- JP 2009090645 A
- JP 2009208458 A
- JP 2008284817 A
- JP 2019162855 A
- JP 5045885 A
- JP H545885 A
- JP 6035174 A
- JP H635174 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- US 3458311 A
- JP 55049729 B
- JP S5549729 B
- JP 2005250216 A
- JP 2006259137 A
- JP 2021141516 A
- JP 2022031973 A


### Non-patent literature cited in the description


- Dye Handbooks. 1970
- *Research Disclosure No. 33303,* January 1992
- Polymer Handbook. VII-698-711
- Polymer Handbook